(19)

Europäisches
Patentamt
European
Patent Office
Office européen
des brevets

(11) **EP 1 976 344 B1**

(12) **EUROPEAN PATENT SPECIFICATION**

(45) Date of publication and mention
of the grant of the patent:
**20.04.2011 Bulletin 2011/16**

(51) Int Cl.:
**H05G 2/00** (2006.01)

(21) Application number: **08005656.7**

(22) Date of filing: **26.03.2008**

(54) **Extreme ultraviolet light source device and extreme ultraviolet radiation generating method**

Lichtquellenvorrichtung für extremes Ultraviolettlicht und Verfahren zur Erzeugung einer extremen Ultraviolettstrahlung

Source lumineuse d'ultraviolets extrêmes et procédé pour générer un rayonnement UV extrême

(84) Designated Contracting States:
**DE NL**

(30) Priority: **28.03.2007 JP 2007084595**
**01.10.2007 JP 2007257439**

(43) Date of publication of application:
**01.10.2008 Bulletin 2008/40**

(73) Proprietors:
- **TOKYO INSTITUTE OF TECHNOLOGY**
  **Tokyo (JP)**
- **Ushio Denki Kabushiki Kaisha**
  **Chiyoda-ku**
  **Tokyo 100-0004 (JP)**

(72) Inventors:
- **Hosokai, Tomonao**
  **Tokyo-to (JP)**
- **Horioka, Kazuhiko**
  **Yokohama-hi**
  **Kanagawa-ken (JP)**

- **Mizokoshi, Hiroshi**
  **Gotenba-shi**
  **Shizuoka-ken (JP)**
- **Yokoyama, Takuma**
  **Gotenba-shi**
  **Shizuoka-ken (JP)**
- **Seki, Kyohei**
  **Himeji-shi**
  **Hyogo-ken (JP)**

(74) Representative: **Tomerius, Isabel et al**
**Lang & Tomerius**
**Patentanwälte**
**Landsberger Strasse 300**
**80687 München (DE)**

(56) References cited:
**WO-A-03/087867      WO-A-2005/004555**
**US-A1- 2004 108 473**

## Description

Background of the Invention

Field of Invention

This invention is directed to an extreme ultraviolet light source device and extreme ultraviolet radiation generating method that generate extreme ultraviolet radiation using plasma generated by discharge, and particularly, to an extreme ultraviolet light source device and extreme ultraviolet radiation generating method that generate extreme ultraviolet radiation using plasma generated by discharge following gasification of a high temperature plasma raw material by energy beam irradiation of a high temperature plasma raw material for generation of extreme ultraviolet radiation that is supplied to the vicinity of the discharge electrodes.

Description of Related Art

With the micro-miniaturization and higher integration of semiconductor integrated circuits, there are demands for improved resolution in projection lithography devices used in manufacturing integrated circuits. Lithography light-source wavelengths have gotten shorter, and extreme ultraviolet light source devices (hereafter, EUV light source devices) that radiate extreme ultraviolet (hereafter EUV) radiation with wavelengths from 13 nm to 14 nm, and particularly, the wavelength of 13.5 nm, have been developed as a next generation semiconductor lithography light source to follow excimer laser devices to meet these demands.

A number of methods of generating EUV radiation are known in EUV light source devices; one of these is a method in which high temperature plasma is generated by heating and excitation of an extreme ultraviolet radiating species (hereafter EUV radiating species) and extracting the EUV radiation radiated by the plasma.

EUV light source devices using this method can be roughly divided, by the type of high temperature plasma generation, into LPP (laser-produced plasma) type EUV light source devices and DPP (discharge-produced plasma) type EUV light source devices (see, "Status and Prospects of Research on EUV (Extreme Ultraviolet) Light Sources for Lithography," J. Plasma Fusion Res. Vol. 79, No.3, p. 219-260, March 2003, for example).

LPP-type EUV light source devices use EUV radiation from a high temperature plasma produced by irradiating a solid, liquid, or gaseous target with a pulsed laser. DPP-type EUV light source devices, on the other hand, use EUV radiation from a high temperature plasma produced by electrical current drive.

A radiating species that radiates 13.5 nm EUV radiation-that is, Xe (xenon) with a valence of about 10 as a high temperature plasma raw material for generation of EUV-is known in both these types of EUV light source devices, but Li (lithium) and Sn (tin) ions have been noted as high temperature plasma raw materials that yield a greater radiation intensity. For example, Sn has a conversion efficiency, which is the ratio of 13.5 nm wavelength EUV radiation intensity to the input energy for generating high temperature plasma, several times greater than that of Xe.

As a method for generation of high temperature plasma, methods that combine laser beam irradiation of a high temperature plasma raw material and heating with a large discharge-based current (also called "hybrid method" hereafter) have been proposed in recent years. EUV light source devices using a hybrid method include, for example, that described in WO 2005/004555 A1, in JP-A-2005-522839 and corresponding US 6,972,421 B2. It is explained in outline below.

The hybrid method in the EUV light source device described in JP-A-2005-522839 and corresponding US 6,972,421 B2 uses the following process. Figure 4C of JP-A-2005-522839 (US 6,972,421 B2) explains the EUV light source device using the hybrid method. In that figure, a grounded outer electrode forms the discharge vessel. An insulator is placed inside the outer electrode, and a high voltage side inner electrode is placed inside the insulator. A gas, such as xenon (Xe) gas or a mixture of xenon (Xe) and helium (He), for example, is used as the high temperature plasma raw material.

This high temperature plasma raw material gas is supplied to the discharge vessel by a gas path fitted to the inner electrode. Such things as an RF pre-ionization coil for pre-ionization of the high temperature plasma raw material gas and a focusing lens to focus the laser beam are installed in the discharge vessel.

The generation of EUV radiation is performed as follows.

First, raw material gas, which is a high temperature plasma raw material introduced into the discharge vessel, undergoes pre-ionization when pulsed power is supplied to the RF pre-ionization coil. Then, a laser beam that has passed through the focusing lens is focused on a specified region within the discharge vessel. Because the high temperature plasma raw material gas has undergone pre-ionization, it is broken down near the laser focal point.

Next, pulsed power is applied between the outer electrode and the inner electrode, and a discharge is generated. By means of the pinch effect from the discharge, the high temperature plasma raw material is heated and excited and a high temperature plasma is generated; EUV radiation is produced from this high temperature plasma.

Here, electric conductivity is increased by the emission of electrons in the vicinity of the laser focal point.

Accordingly, the position of the discharge channel in the discharge region (the space where discharge occurs between the electrodes) is demarcated at the position where the laser focal point is set. That is, the plasma pinch position is demarcated by the laser beam. For that reason, the positional stability of the point of generation of EUV radiation is improved.

In the event that the EUV light source device is used as a light source for lithography, precision of the pointing stability of the point of emission is demanded. The hybrid method EUV light source device described in JP-A-2005-522839 and corresponding US 6,972,421 B2 may be said to be a response to that demand.

There have also been, in recent years, proposals to generate EUV radiation from high temperature plasma generated by a combination of gasification of a high temperature plasma raw material for EUV generation (also called a high temperature plasma raw material hereafter) by irradiation of a laser beam and heating with a large, discharge-based current (see, JP-A-2007-515741 and corresponding WO 2005/004555 A1, JP-A-2007-505460 and corresponding US 2007/0090304 A1, and WO 2005/101924 A1). This method is called the LAGDPP (laser assisted gas discharge produced plasma) method hereafter.

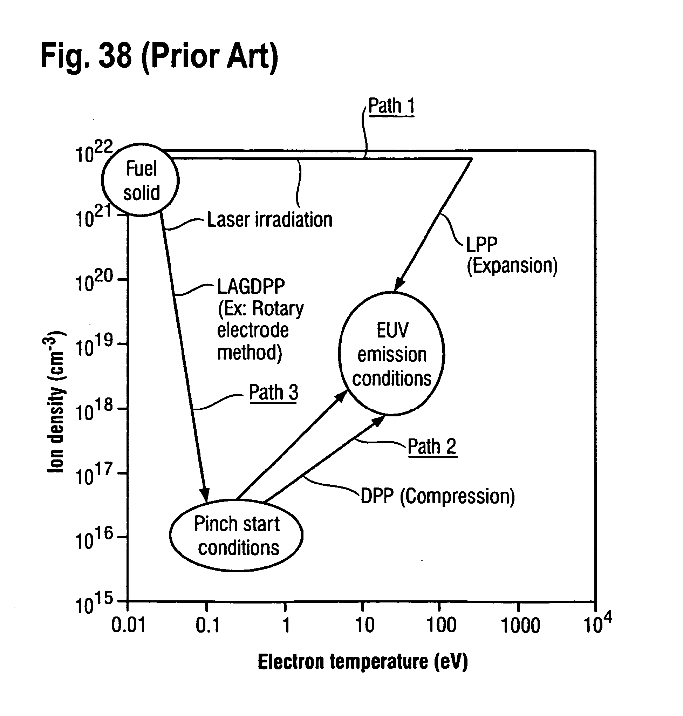

Next, the mechanisms for arriving at EUV radiation on the basis of the methods mentioned above are explained in brief, using Figure 38.

Figure 38 is a graph showing how high temperature plasma raw material (solid fuel is depicted as an example in Figure 38) takes a route of change of state and arrives at conditions that fulfill the conditions for EUV emission. In the figure, the vertical axis represents ion density ($cm^{-3}$) and the horizontal axis represents electron temperature (eV). In this figure, as one moves downward on the vertical axis the high temperature plasma raw material expands and ion density is reduced; a move upward indicates compression and increased ion density. As one moves to the right on the horizontal axis, the high temperature plasma raw material is heated and the electron temperature increases.

In the LPP method, an intense laser beam irradiates a target, for example, a solid or liquid high temperature plasma raw material such as Sn or Li (represented as the "fuel solid" in the upper left portion of Figure 38; in the solid state, the ion density of metallic Sn or Li is about $10^{22}$ $cm^{-3}$, and the electron temperature is 1 eV or less). The high temperature plasma raw material irradiated by the laser beam is suddenly heated to an electron temperature in excess of 300 eV and gasified, and a high temperature plasma is generated. The generated high temperature plasma expands, and the ion density in the high temperature plasma becomes from $10^{17}$ to $10^{20}$ $cm^{-3}$, with an electron temperature of about 20 eV to 30 eV. EUV radiation is emitted from high temperature plasma that has reached such a state (Figure 38, path 1).

That is, in the LPP method, the plasma that is generated by laser beam heating expands, by which means the plasma fulfills the conditions for EUV emission stated above (ion density from $10^{17}$ to $10^{20}$ $cm^{-3}$ and electron temperature from 20 to 30 eV).

In the DPP method, on the other hand, there is a gaseous high temperature plasma raw material atmosphere within the discharge vessel in which the electrodes are located, and the initial plasma is generated by starting a discharge between the electrodes in that atmosphere.

For example, the high temperature raw material Sn is supplied to the discharge vessel in the gaseous form called stannane ($SnH_4$), and the initial plasma is formed by discharge. The ion density in the initial plasma is, for example, about $10^{16}$ $cm^{-3}$ with an electron temperature of 1 eV or less, for example, which does not fulfill the conditions for EUV emission stated above (ion density from $10^{17}$ to $10^{20}$ $cm^{-3}$ and electron temperature from 20 eV to 30 eV) (Initial state of pinch in Figure 38).

Because of the action of the self-magnetic field inherent to the DC current flowing between the electrodes during discharge, the initial plasma is constricted in the direction of the current path. This increases the density of the initial plasma, and the plasma temperature also rises sharply. This action is called the pinch effect hereafter. Because of heating due to the pinch effect, the now-high temperature plasma reaches an ion density from $10^{17}$ $cm^{-3}$ to $10^{20}$ $cm^{-3}$ and electron temperature from 20 eV to 30 eV, and EUV radiation is emitted from the plasma (Figure 38, path 2).

In other words, in the DPP method, because of compression of the plasma generated, that plasma fulfills the conditions for EUV emission stated above (both ion density from $10^{17}$ to $10^{20}$ $cm^{-3}$ and electron temperature from 20 to 30 eV).

In the LAGDPP method, moreover, a laser beam irradiates a solid or liquid target (the high temperature plasma raw material) and produces a gaseous high temperature plasma raw material atmosphere (initial plasma) by gasifying the raw material. As in the DPP method, the ion density in the initial plasma is, for example, about $10^{16}$ $cm^{-3}$ with an electron temperature of 1 eV or less, for example, which does not fulfill the conditions for EUV emission stated above (ion density from $10^{17}$ $cm^{-3}$ to $10^{20}$ $cm^{-3}$ and electron temperature from 20 eV to 30 eV) (Initial state of pinch in Figure 38). Then, because of compression and heating driven by the discharge current, the now-high temperature plasma reaches an ion density from $10^{17}$ $cm^{-3}$ to $10^{20}$ $cm^{-3}$ and electron temperature from 20 eV to 30 eV, and EUV radiation is emitted from the plasma.

Examples of LAGDPP are described in the above mentioned JP-A-2007-515741 and corresponding WO 2005/004555 A1, JP-A-2007-505460 and corresponding US 2007/0090304 A1, and WO 2005/101924 A1. In all of these documents, it is stated that the high temperature plasma raw material is gasified to produce a "cold plasma," and the pinch effect from the discharge current is used to generate high temperature plasma, with EUV radiation being emitted from this high temperature plasma. That is, according to conventional examples, in the discharge-current-driven heating of the LAGDPP method, as in the DPP method, the pinch effect is used. In other words, a high temperature plasma that fulfills the conditions for EUV emission follows path 3 → path 2 in Figure 38.

In the case of the LPP method, the high temperature plasma generated by laser beam irradiation of the high temperature plasma raw material expands and cools within a short period. Consequently, the high temperature plasma that has achieved the conditions for EUV emission cools within a short period (10 ns, for example) and no longer fulfills the conditions for EUV emission, and so EUV emission from the plasma stops.

In the DPP method and the LAGDPP method, on the other hand, a pulsed discharge current flows between the discharge electrodes, as described above, and the initial plasma of high temperature plasma raw material is compressed and heated by the pinch effect and so reaches the conditions for EUV emission.

Within a short period, however, the high temperature plasma that is constricted in the direction of the discharge current path expands rapidly in the direction of the discharge current path as the discharge current rapidly diminishes, and the pinch effect disappears; density declines and cooling occurs. As a result, the plasma in the discharge region no longer fulfills the EUV emission conditions, and so EUV emission from the plasma stops.

Now, the discharge between the electrodes starts with a laser-triggered vacuum arc discharge in a relatively broad region and shifts to a gas discharge (including the pinch discharge) along with the supply of high temperature plasma raw material. Then a discharge column (plasma column) is formed, but what is called the "discharge region" in this specification is defined as a space that includes all these discharge phenomena.

Further, within the discharge region, when the internal current density of the discharge increases and the discharge shifts to a gas discharge as the discharge column (plasma column) grows, there is a spatial region with high current density in the discharge column in which discharge-driven current is dominant; this spatial region is defined as a "discharge channel." Here, the discharge channel is the region where discharge-driven current is the dominant flow, and so this discharge channel is also called a discharge path or discharge current path.

Pulse lengthening of the EUV emission is explained next.

As noted above, an EUV emission is produced in a pulse shape within a short period of time. Therefore, the energy conversion efficiency is markedly low. When an EUV light source device is used as a light source for semiconductor lithography, both high output and efficiency that is as high as possible is operationally demanded of the EUV light source device. High-efficiency, high-output EUV radiation sources are possible if high-efficiency EUV generation conditions can be maintained for a long period. As a result, pulse lengthening of the light-emission pulse width is desired.

A method of lengthening pulses of EUV emission in DPP-type EUV generation devices is disclosed WO 2006/120942 A1 and JP-A-2007-123138. Based on WO 2006/120942 A1 and JP-A-2007-123138, this conventional pulse-lengthening method is explained below with reference to Figures 39 & 40.

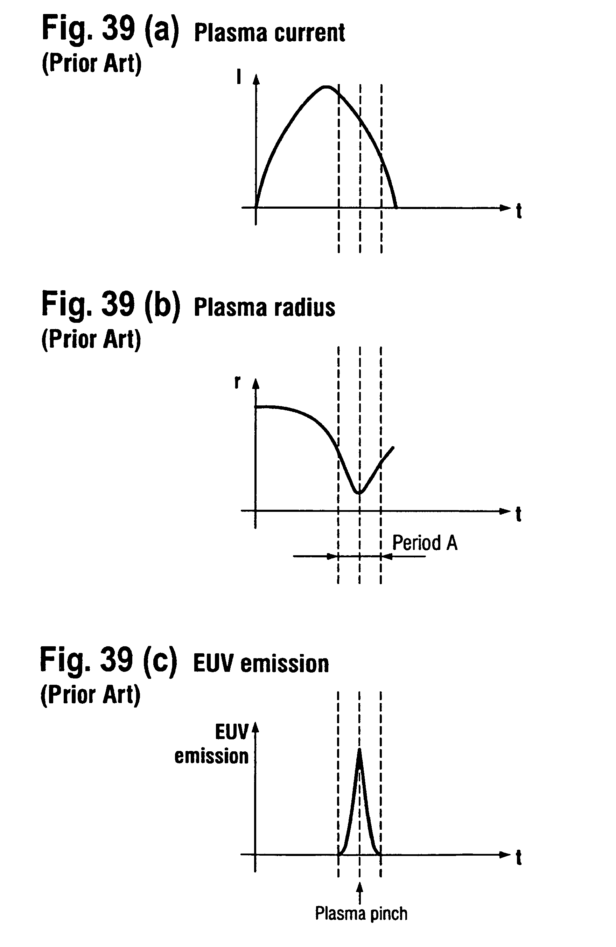

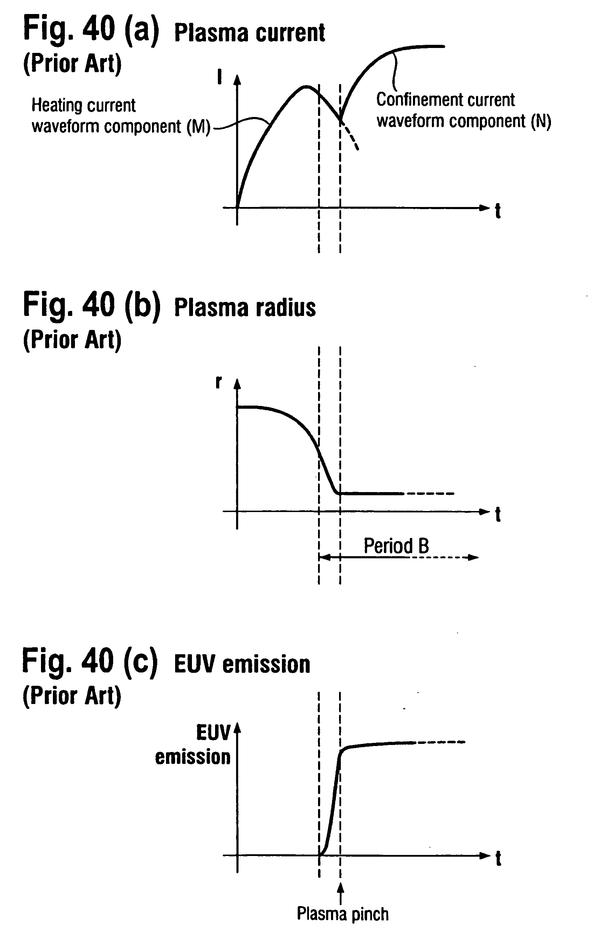

Both of Figures 39 & 40 are graphs in which (a) the plasma current I, (b) the plasma radius r, and (c) the EUV radiation output are plotted in relation to the passage of time beginning with the start of discharge. The horizontal axis represents the time and the vertical axis represents the plasma current I, the plasma radius r, and the EUV radiation output.

The pulse lengthening of EUV radiation in WO 2006/120942 A1 and JP-A-2007-123138 is realized in DPP-type EUV producing devices by separating and controlling the plasma heating and compression process and the process of maintaining a state of high temperature and high pressure.

In the conventional DPP method, as shown in Figure 39, the waveform of the plasma current I that flows within uniform plasma columns formed between a pair of electrodes is a waveform that increases with the passage of time after the start of discharge, and then decreases after the peak is passed. For ease of understanding, the waveform of the current I is taken as a sine wave below.

Heating and compression of the plasma occur as the plasma current I increases. That is, the radius r of the generated plasma column grows smaller and smaller, due to the pinch effect, as the plasma current I flows; it is smallest when the value of the plasma current I has passed its peak and begun to fall.

EUV emission occurs during time period A, in the vicinity of the peak of the plasma current I waveform, when the plasma temperature and ion density are within the specified range (as shown in Figure 38, for example, the electron temperature is from 5 eV to 200 eV and the ion density is about $10^{17}$ cm$^{-3}$ to $10^{20}$ cm$^{-3}$).

When the peak of the plasma current I waveform is passed, however, the current value diminishes with the passage of time, and so the pinch effect also weakens; the plasma expands and the plasma temperature drops. The expanding plasma has great kinetic energy and quickly breaks away from the discharge region. The EUV emission stops as a result. The duration of the EUV emission is, for example, a mere 10 ns.

On the other hand, the method described in WO 2006/120942 A1 and JP-A-2007-123138 is constituted so that the waveform of the plasma current I flowing between a pair of electrodes becomes the waveform shown in Figure 40. That is, the waveform of the plasma current I increases with the passage of time after the start of discharge, and in the vicinity after the peak is passed (for example, in the vicinity when the plasma is pinched, causing EUV emission to start), it increases further with the passage of time.

As shown in Figure 40, the waveform of the plasma current I comprises a heating current waveform component (M) and a subsequent confinement current waveform component (N). The heating current waveform component (M) is the same, up to a certain point in time, as the waveform of the plasma current I shown in Figure 39. In Figure 40, the heating current waveform component (M) is shown as a sine wave for ease of understanding.

Plasma heating and compression occur along with the increase of the plasma current I during the period of the heating current waveform component (M). That is, the radius r of the generated plasma column grows smaller and smaller, due to the pinch effect, as the plasma current I flows; it is smallest when the value of the plasma current I has passed its peak and begun to fall. EUV emission occurs in the vicinity of the peak of the plasma current I waveform, when the plasma temperature and ion density are within the specified range (as shown in Figure 38, for example, the electron temperature is from 5 eV to 200 eV and the ion density is about $10^{17}$ cm$^{-3}$ to $10^{20}$ cm$^{-3}$).

After EUV emission occurs, the waveform of the plasma current I shifts to the confinement current waveform component N.

As stated above, the plasma compressed by the pinch effect attempts to expand with great kinetic energy. Here, when the strength of the plasma current I increases and the action of the self-magnetic field becomes powerful, it becomes possible to maintain in a compressed state the plasma that is trying to expand.

Taking the pressure of the plasma in this pinched state as $P_{pp}$, the plasma density as $n_{pp}$, the Boltzmann coefficient as k, and the plasma temperature as $T_{pp}$, then the pressure of the plasma in the pinched state $P_{pp}$ is proportional to $n_{pp}kT_{pp}$.

$$P_{pp} \propto n_{pp}kT_{pp} \qquad (101)$$

On the other hand, the compression pressure $P_B$ that results from the self-magnetic field B inherent to the plasma current I, when magnetic permeability in a vacuum is $\mu_0$ and the plasma radius is r, is represented by

$$P_B = \mu_0 / 2\pi r \qquad (102)$$

Here, if the condition

$$P_B \geqq P_{pp} \qquad (103)$$

is met, the plasma can be maintained in a pinched state. The plasma in a pinched state here has become high temperature plasma with a great plasma density $n_{pp}$ and plasma temperature $T_{pp}$, and so because of formula (103) it is necessary to increase the plasma current 1.

In other words, by increasing the plasma current I after the plasma is pinched, the subsequent current value can be held steady, by which means the pinch effect is maintained, and so the plasma temperature and ion density are maintained within the specified range (a state in which the plasma radius is small).

Theoretically, while the plasma temperature and ion density are maintained in a state within the specified range (period B in Figure 40), an EUV emission can continue. In other words, pulse lengthening of the EUV emission becomes possible.

The example shown in Figure 40 is one in which the point in time at which the plasma is pinched and the plasma radius is at its smallest is the point of transition from the heating current waveform component (M) to the confinement current waveform component (N).

Now, in reality, even with a plasma current I that has a confinement current waveform component (N) that maintains a peak current value exceeding the peak of the heating current waveform component (M), it is difficult to maintain the high temperature plasma in a compressed state for a long period, due to such reasons as plasma column collapse due to the growth of fluid instability. For this reason, the confinement current waveform component (N) eventually diminishes with the passage of time; the pinch effect weakens, the plasma expands, and the plasma temperature declines. The EUV emission ends as a result. In the example in WO 2006/120942 A1, it is stated that the duration of EUV power (duration of high temperature plasma) can be pulse-lengthened to about 30 ns.

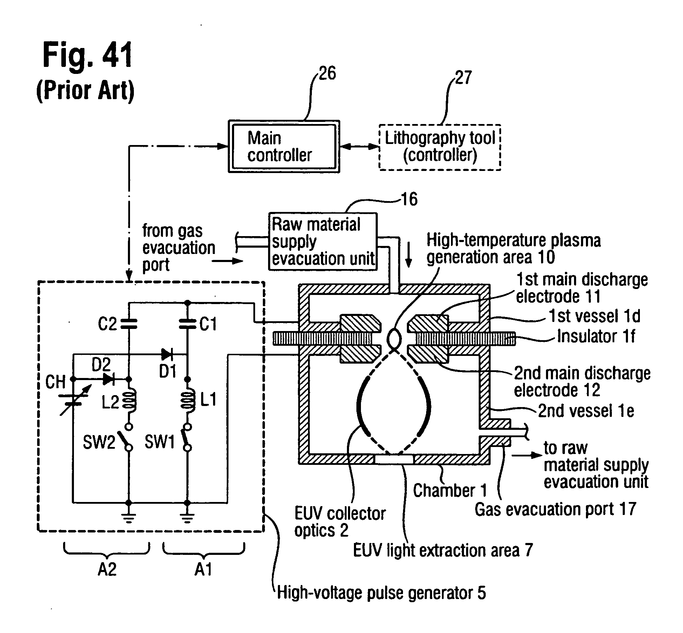

Figure 41 is an example of the constitution of a DPP-type EUV light source device to realize the EUV emission pulse-lengthening method described in WO 2006/120942 A1 and JP-A-2007-123138.

High temperature plasma raw material is introduced into the chamber 1, which is the discharge vessel, by a raw material supply/evacuation unit 16. The high temperature plasma raw material is a raw material for formation of a radiating species that emits EUV radiation with a wavelength of 13.5 nm in the high temperature plasma generation area 10 in the chamber 1; it is, for example, xenon (Xe) or Sn vapor. The high temperature plasma raw material introduced flows within the chamber 1 and reaches the gas evacuation port 17.

A raw material supply/evacuation unit 16 has a vacuum pump or other evacuation means (not illustrated); the evacuation means is connected to the gas evacuation port 17 of the chamber.

That is, the high temperature plasma raw material that reaches the gas evacuation port 17 is evacuated by the evacuation means of the raw material supply/evacuation unit 16.

A ring-shaped first main discharge electrode (cathode) 11 and a second main discharge electrode (anode) 12, separated by an insulator 1f, are located in the chamber 1. The chamber 1 comprises a first vessel 1d, formed of conductive material, on the first main discharge electrode 11 side and a second vessel 1e, similarly formed of conductive material, on the second main discharge electrode side. The first vessel 1d and the second vessel 1e are separated and insulated by the insulator 1f.

The second vessel 1e and the second main discharge electrode 12 are grounded, and a pulsed power generator 5 applies a voltage of about -5 kV to -20 kV on the first vessel 1d and the first main discharge electrode 11. As a result, a discharge is generated in the high temperature plasma generation area 10 between the ring-shaped first and second main discharge electrodes 11, 12, and an EUV radiation with a wavelength of 13.5 nm is generated by this high temperature plasma. The EUV radiation thus generated is reflected by EUV collector optics 2 and is output to an unillustrated irradiation area by an EUV radiation extraction area 7.

Incidentally, the waveform of the plasma current (discharge current) shown in Figure 40(a) is obtained as follows, for example. A current having a sinusoidal waveform is overlapped by another current with a waveform that is not sinusoidal. In other words, a current that has a heating current waveform component (M) is overlapped with a current of a pattern that differs from the heating current waveform component (M) to form a confinement current waveform component (N).

In order to obtain this sort of current waveform, the high-voltage pulse generator 5 is constituted with a parallel discharge circuit having independent switching elements SW1, SW2 as shown in Figure 41.

The pulsed power generator 5 shown in Figure 41 comprises a discharge circuitAl made up of a capacitor C1 and a switch SW1 in series and a discharge circuit A2 made up of a capacitor C2 and a switch SW2 in series, the two being connected in parallel to the load (the first main discharge electrode 11 and the second main discharge electrode 12. Here, the high-voltage power source CH has the purpose of charging the capacitors C1, C2. Further, a coil L1 represents the inductance component compounding the parasitic inductance of the capacitor C1 and the inductances of the circuit loop formed by the capacitor C1, the switch SW1, and the load. Similarly, a coil L2 represents the inductance component compounding the parasitic inductance of the capacitor C2 and the inductances of the circuit loop formed by the capacitor C2, the switch SW2, and the load. Further, diodes D1, D2 have the purpose of limiting the current direction so that the electrical energy stored in the capacitors C1, C2 is transferred only to the load.

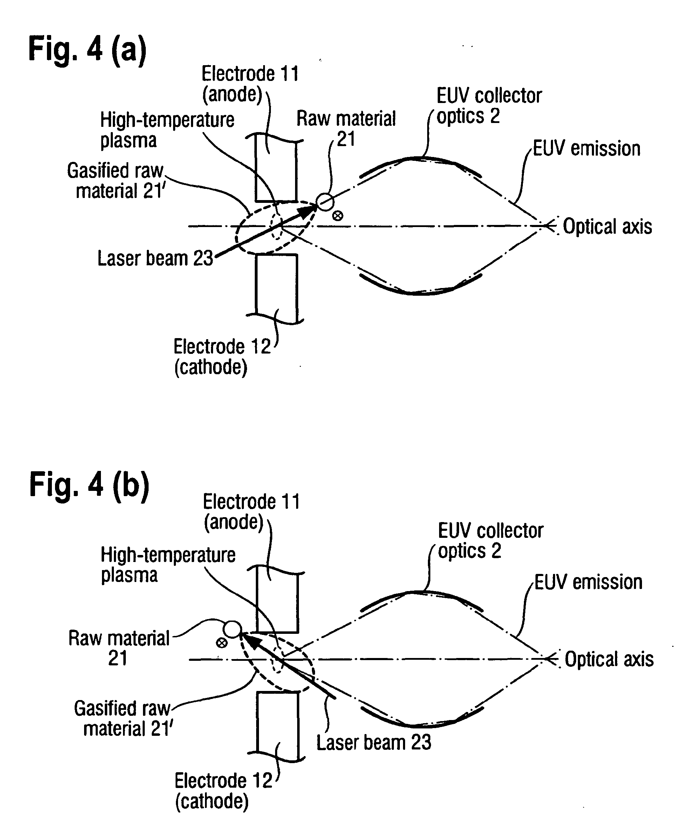

The high-voltage pulse generator shown in Figure 41 operates as follows. First the high-voltage power source CH charges the capacitors C1, C2 of the discharge circuits through the diodes D1, D2. Then by turning the first switch SW1 of the discharge circuit A1 ON, the electrical energy stored in the first capacitor C1 is applied between the first main discharge electrode 11 and the second main discharge electrode 12 and discharge begins. At that time, the current flowing between the first main discharge electrode 11 and the second main discharge electrode 12 is used to pinch the plasma. That is, due to Joule heating by the pinch effect, a high temperature plasma is generated. This current corresponds to the heating current waveform component (M) in the waveform of Figure 4(a).

Next, at the point when EUV radiation emission with a wavelength of 13.5 nm has begun because of the plasma pinch effect, the second switch SW2 of the discharge circuit A2 is turned ON and the electric energy stored in the second capacitor C2 is applied between the first main discharge electrode 11 and the second main discharge electrode 12; the current from the second capacitor C2 is added to the current flowing between the first main discharge electrode 11 and the second discharge electrode 12. This current is used as the current to maintain the pinched state of the high temperature, high-density plasma. It corresponds to the confinement current waveform component (N) in the waveform of Figure 40(a).

Now, control of the first switch SW1 and the second switch SW2 and control of the raw material supply/evacuation unit 16 is handled by a main controller 26. The main controller 26 controls these control elements on the basis of operational command signals from the controller 27 of the lithography tool.

However, the following problems arise in the constitution of a device such as shown in JP-A-2005-522839 and corresponding US 6,972,421 B2.

In the EUV light source device described above, the position of the discharge channel is demarcated by laser beam irradiation. To realize EUV emission with good efficiency, however, it is necessary to set the high temperature plasma raw material (gas) distribution in the discharge channel to the desired spatial density distribution.

In other words, even if the position of the discharge channel is demarcated, EUV radiation with a wavelength of 13. 5 nm will not be produced by the plasma generated by the discharge unless the high temperature plasma raw material (gas) distribution in the discharge channel is the desired spatial density distribution.

In the EUV light source device of JP-A-2005-522839 and corresponding US 6,972,421 B2, the raw material gas is supplied to the discharge vessel by a gas path installed in the inner electrode. It is not possible, however, to actively control the spatial density distribution of the high temperature plasma raw material (gas) distribution in the discharge channel, and so the high temperature plasma raw material (gas) spatial density distribution that is optimal for EUV emission will not necessarily be available in the discharge channel.

In the EUV emission pulse-lengthening method of the prior art described above, on the other hand, the EUV emission pulse lengthening shown in WO 2006/120942 A1 and JP-A-2007-123138 can be realized in DPP-type EUV light source devices by separating and controlling the plasma heating and compression process and process of maintaining a state of high temperature and high-pressure. In other words, in order to maintain the pinched state of the plasma, it is necessary to supply energy to the discharge space so that the value of the plasma current I after the plasma arrives at the pinched state will be greater than the value of the plasma current I before the plasma arrives at the pinched state, as shown in Figure 40(a), in contrast to the conventional DPP method.

At the completion of the EUV emission, the energy supplied to the discharge space is converted to heat. In order to maintain the pinched state of plasma in DPP-type EUV light source devices employing traditional pulse-lengthening methods, a greater discharge current flows than in the ordinary DPP method without pulse-lengthening technology. For that reason, the heat input to the electrodes in this sort of EUV light source device is greater than in conventional DPP-type EUV light source devices. Therefore, the heat load causes partial melting or vaporization or spattering of the electrodes, and so debris is formed, and this debris is liable to bring about the problem of damage to the EUV collector optics.

Moreover, in order to maintain the pinched state of the plasma, it is necessary to change the waveform of the plasma current I as shown in Figure 40(a). Here, the period for which the plasma is pinched in a high temperature state because of the heating current waveform component (M) of the plasma current I waveform shown in Figure 40(a) is about 10 ns, and so in order to maintain the pinched state, it is necessary for the plasma current I to flow within this period so as to generate a confinement current waveform component (N) of the plasma current I waveform.

In other words, the time tolerance for the flow of current to generate the confinement current waveform component (N) of the current waveform must be about 10 ns or less; highly precise control is required for synchronization of the timing of the switches SW1, SW2.

Summary of the Invention

This invention was made in consideration of the situation described above; a first object of this invention being to provide an EUV light source device and an EUV generating method that is capable of demarcation of the discharge channel position, and at the same time, is capable of appropriately setting the density of the high temperature plasma raw material (gas) in the discharge channel.

Further, a second object of this invention is to provide an extreme ultraviolet radiation generating method and extreme ultraviolet light source device capable of achieving the first object noted above and of realizing EUV emission pulse lengthening without imposing a great heat load on the electrodes, and without requiring highly precise control, as in the prior art.

Brief Description of the Drawings

Figure 1 is a timing chart (1) to explain EUV generation in this invention where the rise time of the discharge current is rapid and the laser beam for raw material irradiates before the laser beam for initiation.

Figure 2 is a timing chart (2) to explain EUV generation in this invention where the rise time of the discharge current is slow and the laser beam for raw material irradiates after the laser beam for initiation.

Figures 3(a) & 3(b) are plan and front schematic diagrams, respectively, for explaining the relationship of electrodes, raw material supply position, and laser beam for raw material irradiation position.

Figures 4(a) & 4(b) are plan and front schematic diagrams, respectively, for explaining the relationship of electrodes, raw material supply position, and laser beam for raw material irradiation position.

Figures 5(a) & 5(b) are plan and front schematic diagrams, respectively, to explain the relationship of electrodes, raw material supply position, and laser beam for raw material irradiation position.

Figure 6 is a graph for explaining the path of the high temperature plasma raw material to reach conditions that fulfill the conditions for EUV radiation emission in this invention.

Figures 7(a)-7(c) are graphs for explaining the pulse lengthening method (multi-pinch type) of this invention.

Figures 8(a)-8(c) are graphs for explaining the pulse lengthening method (non-pinch type) of this invention.

Figure 9 is a schematic cross-sectional front view of an embodiment of the EUV light source device of this invention.

Figure 10 is a schematic cross-sectional top view of an embodiment of the EUV light source device of this invention.

Figures 11(a) & 11(b) are examples of collection of the second laser beam (laser beam for initiation).

Figure 12 is a representation for explaining monitoring of the position of raw material dropped from the raw material supply unit.

Figure 13 is a first part of a flow chart showing the operation of the embodiment shown in Figures 9 & 10.

Figure 14 is a second part of the flow chart of Fig. 13 showing the operation of the embodiment shown in Figures 9 & 10.

Figure 15 is a time chart (1) showing the operation of the embodiment shown in Figures 9 & 10.

Figure 16 is a front view showing a first variation of the embodiment of the EUV light source device of this invention shown in Figures 9 & 10.

Figure 17 is a plan view showing the first variation of the embodiment of the EUV light source device of this invention shown in Figures 9 & 10.

Figure 18 is a front view showing a second variation of the embodiment of the EUV light source device of this invention shown in Figures 9 & 10.

Figure 19 is a plan view showing the second variation of the embodiment of the EUV light source device of this invention shown in Figures 9 & 10.

Figure 20 is a side view showing the second variation of the embodiment of the EUV light source device of this invention shown in Figures 9 & 10.

Figure 21 is a plan view showing a third variation of the embodiment of the EUV light source device of this invention shown in Figures 9 & 10.

Figure 22 is a side view showing the third variation of the embodiment of the EUV light source device of this invention shown in Figures 9 & 10.

Figures 23(a) & 23(b) are concept drawings of the fitting of a tubular nozzle for spraying raw material in the first energy beam irradiation position.

Figure 24(a)-24(c) show the fitting of a high-speed spray nozzle for spraying raw material in the first energy beam irradiation position and the constriction of a portion of the nozzle.

Figure 25 shows a raw material accommodation area for accommodating the high temperature plasma raw material, integrated with a high-speed spray nozzle.

Figures 26(a) & 26(b) show the formation of a concavity in the position of the high temperature plasma raw material to which the beam is irradiated.

Figure 27 is a first part of a flow chart of the operation of the first variation of the embodiment of the EUV light source device shown in Figures 9 & 10.

Figure 28 is a second part of the Figure 27 flow chart of the operation of the first variation of the embodiment of the EUV light source device shown in Figures 9 &10.

Figure 29 is a time chart of the operation of the first variation of the embodiment of the EUV light source device shown in Figures 9 &10.

Figure 30 is a representation for explaining adjustment irradiation.

Figure 31 shows an example of the basic constitution of an EUV light source device with the pulse lengthened on the basis of this invention.

Figure 32 is a time chart for explaining operation of the EUV light source device shown in Figure 31.

Figure 33 is a representation for explaining a pulse-lengthened EUV light source device embodiment of this invention.

Figure 34 is a schematic representation of the constitution of a pulse-lengthened EUV light source device embodiment of this invention.

Figure 35 is a schematic diagram of an example of an equivalent circuit of the power supply means.

Figure 36 is a flow chart of the operation of the embodiment shown in Figure 34.

Figure 37 is a time chart of the operation of the embodiment shown in Figure 34.

Figure 38 is a graph for explaining the path of the high temperature plasma raw material to reach conditions that fulfill the conditions for EUV radiation emission.

Figures 39(a)-39(c) are graphs showing the relationship between plasma current I, plasma column radius r, and EUV emission power in conventional DPP-type EUV radiation generation devices.

Figures 40(a)-40(c) are graphs showing the relationship between plasma current I, plasma column radius r, and EUV emission power in pulse-lengthened conventional DPP-type EUV radiation generation devices.

Figure 41 is a schematic representation of an example of a conventional DPP-type EUV radiation generation device with EUV emission pulse-lengthening method.

Detailed Description of the Invention

The EUV light source device of this invention irradiates and gasifies, with a first energy beam, a radiating species that emits EUV radiation with a wavelength of 13.5 nm, such as solid or liquid Sn or Li that is a high temperature plasma raw material. The gasified high temperature plasma raw material spreads at a specified speed, centered on the normal direction of the high temperature plasma raw material surface to which the energy beam is incident.

Accordingly, the high temperature plasma raw material that is gasified by irradiation by the first energy beam and spreads at a specified speed is supplied to the discharge region by setting appropriately such things as the position of the discharge region and the raw material, the direction of the first energy beam's irradiation of the raw material, and the irradiation energy of the first energy beam.

Such things as laser beams, ion beams, or electron beams can be adopted as the energy beam.

By appropriately setting the energy intensity and the irradiation direction of the first energy beam, it is possible to set the spatial density distribution of gasified high temperature plasma raw material in the discharge region to the specified spatial density distribution.

By irradiating a specified position in the discharge region with a second energy beam, on the other hand, it is possible to start the discharge and to demarcate the discharge channel position to the position of the second energy beam irradiation. When the second energy beam is a laser beam, for example, by focusing the laser beam (laser beam for initiation) on a specified position in the discharge region, it is possible to demarcate the discharge channel position relative to the position where the laser focus is set. In that way, the positional stability of the point of luminescence of EUV radiation is improved.

Further, because the discharge begins at the time when the second energy beam irradiates a specified position in the discharge region, as stated above, it is possible to control the timing of the beginning of discharge by controlling the second energy beam irradiation timing.

By appropriately setting the timing of first energy beam irradiation and the timing of second energy beam irradiation, it is possible to generate a discharge in the position-demarcated discharge channel such that, in a state where at least a portion of gasified raw material of which the spatial density distribution is the specified distribution has reached the discharge channel, the magnitude of the discharge current is at or above the lower limit of the discharge current value needed to obtain an EUV emission of the specified intensity.

It is possible, as a result, to realize an efficient EUV emission.

(1) The irradiation timing of the first energy beam (energy beam for raw material) and the second energy beam (energy beam for initiation), (2) the interrelationship of the electrode position, the raw material supply position, and the irradiation position of the energy beam for raw material, and (3) the energy of the energy beam for raw material are explained below. Laser beams are used as an example of the energy beams below.

(1) Timing

The EUV generating method of this invention is explained below using timing charts.

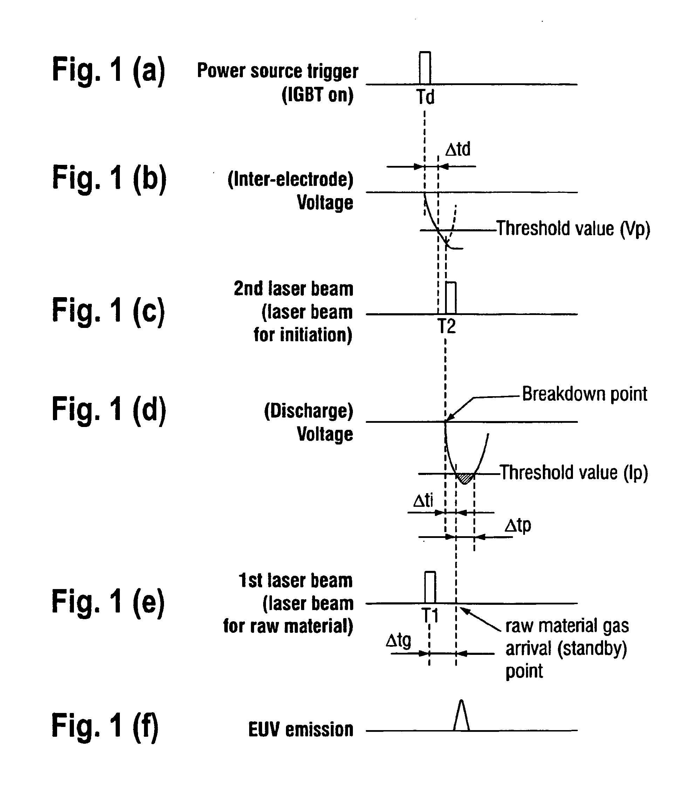

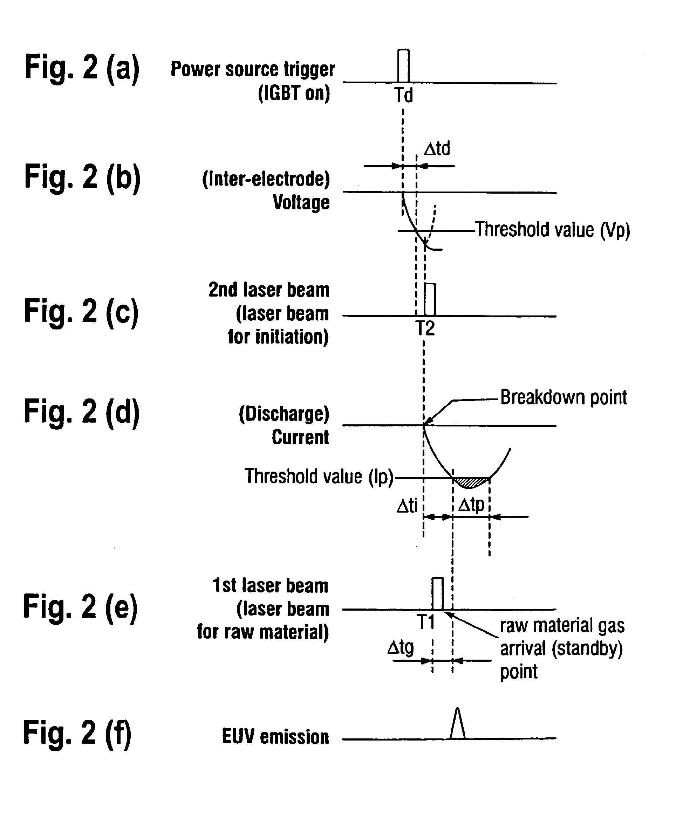

Figures 1 & 2 are timing charts to explain the EUV generating method in this invention. Figure 1 shows the case of the first laser beam being irradiated earlier than the second laser beam, and Figure 2 shows the case of the first laser beam being irradiated later than the second laser beam.

First, as shown in Figures 1 & 2, a trigger signal is input (at time Td) to the switching means (an IGBT, for example) of the pulsed power supply means that applies pulsed power between the paired electrodes, and the switching means is turned ON (see, (a) of Figures 1 & 2).

After a time interval $\Delta$td, the interelectrode voltage reaches the threshold value Vp (see, (b) of Figures 1 & 2). This threshold value Vp is the voltage value in the event that the value of the discharge current flowing when discharge occurs is at or above the threshold value Ip (the threshold value Ip is explained hereafter). That is, if discharge were to occur at less than the threshold value Vp, the peak discharge current would not reach the threshold value Ip.

Now, even in the event that discharge does not occur in this state, the inter-electrode voltage can reach and be maintained at the maximum voltage (broken curve in (b) of Figures 1 & 2).

At time T2 (T2 = Td + $\Delta$td) at or after the inter-electrode voltage has reached the threshold value Vp, the second laser beam (laser beam for initiation) irradiates the discharge region (see, (c) of Figures 1 & 2). Now, the second laser beam can irradiate either electrode of the paired electrodes. The discharge region is taken to include the electrode surface hereafter.

By means of irradiation by the second laser beam (laser beam for initiation), the discharge is started, and after $\Delta$ti, the magnitude of the discharge current reaches the threshold value Ip mentioned above (see, (d) of Figures 1 & 2). This threshold value Ip is the lower limit for the discharge current value necessary to obtain an EUV emission of the specified intensity. Now, the period when the discharge current value is at or above the threshold value Ip is called $\Delta$tp.

The first laser beam (laser beam for raw material) irradiates the raw material so that, of the high temperature plasma raw material that is gasified by the first laser beam and spreads at a specified speed, at least a portion having the specified spatial density distribution will have reached the discharge region during the period $\Delta tp$ following this time $(T2 + \Delta ti)$.

The period from the time that the first laser beam irradiates the raw material until at least a portion of the gasified raw material having the specified spatial density distribution reaches the discharge region is called $\Delta tg$; the laser beam for raw material irradiates at the time T1 during the period from $(T2 + \Delta ti - \Delta tg)$ to $(T2 + \Delta ti + \Delta tp - \Delta tg)$ (see (e) of Figures 1 and 2). By this means, EUV radiation is emitted (see (f) of Figures 1 and 2).

Here, Figure 1 shows an example where the rise time of the discharge current is rapid and the second laser beam (laser beam for initiation) irradiates after the first laser beam (laser beam for raw material) irradiates.

Figure 2, on the other hand, shows an example where the rise time of the discharge current is slow and the first laser beam (laser beam for raw material) irradiates after the second laser beam (laser beam for initiation) irradiates.

(2) Relationship of electrode position, raw material supply position, and laser beam for raw material irradiation position

In the EUV light source device of this invention, as noted above, high temperature plasma raw material gasified by the first laser beam (laser beam for raw material) arrives at the discharge region. An example of the positional relationship is shown below.

As an example, this shows the case in which the supply of high temperature plasma raw material that is the target of the first laser beam is by dropping in the form of droplets. Now, the method of supplying high temperature plasma raw material is not limited to this. It is also possible, for example, to supply the high temperature plasma raw material in wire form, as indicated below.

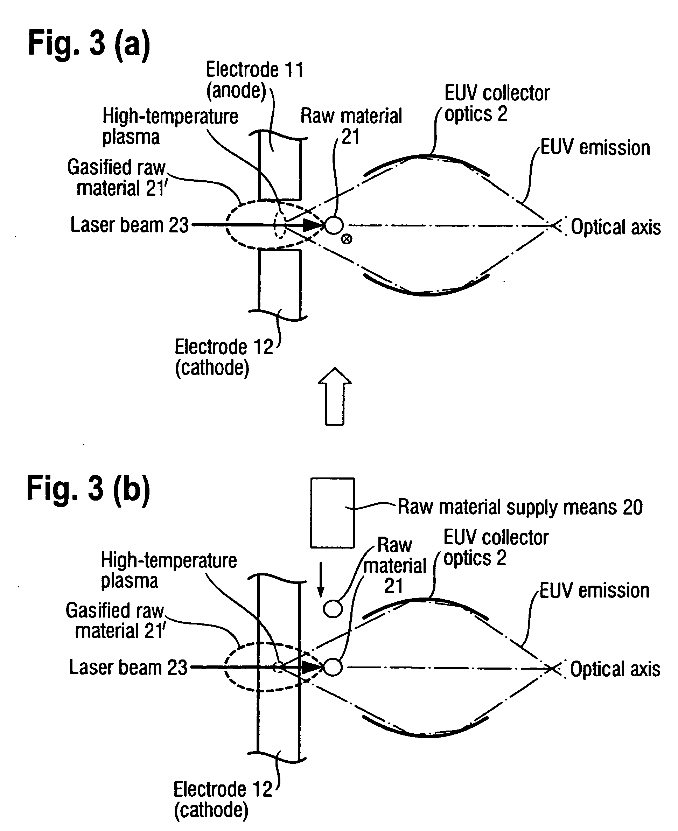

Figure 3 is a schematic to explain this positional relationship; Figure 3(a) is a plane view, and Figure 3(b) is a front view. In other words, Figure 3(b) is a view as seen from the direction of the arrow in Figure 3(a). In the drawing, 11 is an electrode (anode), 12 is an electrode (cathode), 2 is the extreme ultraviolet radiation collector optics (also called "EUV collector optics" hereafter), 20 is a raw material supply means, 21 is raw material, and 23 is the first laser beam (laser beam for raw material).

The first laser beam 23 irradiates the high temperature plasma raw material 21 that is dropped. The irradiation position is a position where the dropped high temperature plasma raw material 21 has approached the vicinity of the discharge region.

In the example shown in Figure 3, the plate-shaped paired electrodes 11, 12 are placed separated by a specified gap. The discharge region is positioned in the space separating the paired electrodes 11, 12. The high temperature plasma raw material 21 is supplied by the raw material supply means 20, in the gravitational direction, to the vicinity of the discharge region which is the space between the paired electrodes 11, 12 and the extreme ultraviolet radiation collector optics 2.

When the high temperature plasma raw material 21 arrives in the vicinity of the discharge region, the first laser beam 23 irradiates the high temperature plasma raw material 21. The high temperature plasma raw material, gasified by irradiation by the first laser beam 23, spreads centered on the normal direction of the surface of the high temperature plasma raw material to which the first laser beam is incident.

For this reason, when the first laser beam 23 irradiates the high temperature plasma raw material 21 supplied by the raw material supply means 20 on the surface that faces the discharge region, the gasified high temperature plasma raw material 21' spreads in the direction of the discharge region.

Here, the EUV collector optics 2 often comprises a grazing incidence optical system that sets the optical axis as the collection direction. To constitute this sort of grazing incidence optical system, generally, there are multiple thin, concave mirrors nested with high precision. EUV collector optics with such a constitution have the multiple thin, concave mirrors supported by a support column that roughly matches the optical axis and supports that extend radially from the support column.

In Figure 3, the first laser beam 23 enters from the optical axis direction specified by the collector optics 2 and irradiates the high temperature plasma raw material 21. For that reason, if there is slippage in the synchronization irradiation position of the first laser beam 23 and the position of the high temperature plasma raw material 21, the first laser beam 23 may irradiate the EUV collector optics 2 and, depending on the circumstances, damage the EUV collector optics 2.

In the event that it is necessary to prevent the first laser beam 23 from reaching the EUV collector optics 2, in this way, when the first laser beam 23 irradiates, it is possible to adjust the direction of travel of the first laser beam 23 as shown in Figure 4(a) & 4(b), so that it does not reach the EUV collector optics 2.

Incidentally, the high temperature plasma raw material that is gasified by irradiation by the first laser beam 23 as described above spreads centered on the normal direction of the surface of the high temperature plasma raw material to which the first laser beam is incident. Therefore, when the first laser beam 23 irradiates the high temperature plasma raw material 21 on the surface that faces the discharge region, the gasified high temperature plasma raw material 21' spreads in the direction of the discharge region.

Here, of the gasified high temperature raw material 21' supplied to the discharge region by first laser beam irradiation, a portion that does not contribute to the formation of high temperature plasma by the discharge or a portion of the clusters of gas in atomic form dissociated as an effect of plasma formation will contact the lower temperature portions within the EUV light source device and accumulate as debris.

In the event that the high temperature plasma raw material is Sn, for example, a portion that does not contribute to the formation of high temperature plasma by the discharge or a portion of the metallic clusters of Sn, Snx gas in atomic form dissociated as an effect of plasma formation will contact the lower temperature portions within the EUV light source device as debris and produce a tin mirror.

Here, in the event that the high temperature plasma raw material 21 is supplied by the raw material supply means to the side of the paired electrodes 11, 12 that does not look toward the EUV collector optics 2, the first laser beam 23 will irradiate the high temperature plasma raw material from the EUV collector optics 2 side so that the gasified high temperature plasma raw material 21' is supplied to the discharge region as shown in Figure 4(b).

In this case, the high temperature plasma raw material gasified by the first laser beam 23 spreads in the direction of the discharge region and the EUV collector optics. In other words, debris will be released in the direction of the EUV collector optics 2 by the first laser beam 23 irradiating toward the high temperature plasma raw material 21 and the discharge generated between the electrodes 11, 12. If the debris deposits on the EUV collector optics 2, reflectivity of 13.5 nm by the EUV collector optics 2 will decline and performance of the EUV light source device will deteriorate.

It is preferable, therefore, to supply the high temperature plasma raw material to a space in the vicinity of the discharge region which is a space between the paired electrodes 11, 12 and the EUV collector optics 2, as shown in Figure 3 and figure 4(a) .

When the first laser beam 23 irradiates the high temperature plasma raw material 21, supplied in this way, on the side where the surface of the high temperature plasma raw material faces the discharge region, the gasified high temperature raw material 21' will spread in the direction of the discharge region but will not spread in the direction of the EUV collector optics 2. That is, it is possible to suppress the movement of debris toward the EUV collector optics 2 by setting the supply of high temperature plasma raw material 21 and the irradiation position of the first laser beam 23 as described above.

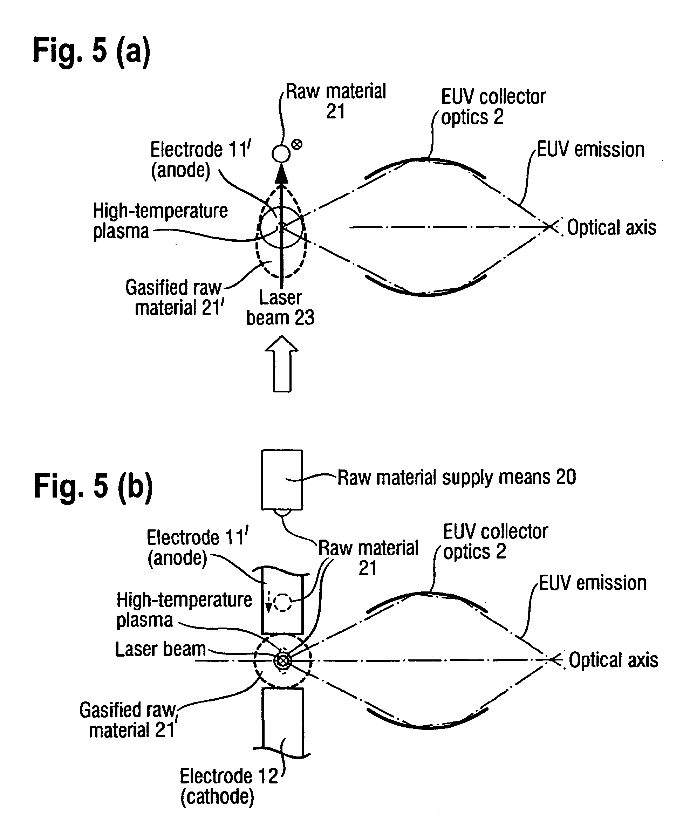

Consider the case where the paired electrodes separated by a specified gap are columnar, as shown in Figure 5. Here, Figure 5(a) is a plane view and Figure 5(b) is a front view. That is, Figure 5(b) is a view as seen from the direction of the arrow in Figure 5(a).

In this case, the high temperature plasma raw material 21 is supplied to a space that is on a plane perpendicular to the optical axis and that is in the vicinity of the discharge region; even if the first laser beam 23 irradiates the high temperature plasma raw material 2 from a direction perpendicular to the optical axis, the gasified high temperature raw material 21' will not spread in the direction of the EUV collector optics 2. Accordingly, hardly any debris produced by first laser beam 23 irradiation of the high temperature plasma raw material 21 and by discharge generated between the electrodes 11', 12' will travel toward the EUV collector optics 2.

Now, even if the paired electrodes separated by a specified gap are columnar, of course, it is acceptable to have the high temperature plasma raw material supplied by the raw material supply means to a space in the vicinity of the discharge region that is a space between the paired electrodes and the EUV collector optics, as shown in Figure 3 and Figure 4(a).


(3) Energy of the laser beam for raw material

The time period $\Delta$tg from the point when the first laser beam (laser beam for raw material) irradiates the raw material until at least a part of the gasified high temperature raw material reaches the discharge region is determined from the distance between the discharge region and the raw material irradiated by the first laser beam 23 and the speed at which the gasified raw material spreads.

Here, the distance between the discharge region and the raw material irradiated by the first laser beam depends on the position of the discharge region and the raw material 21 at the time of first laser beam 23 irradiation and the direction of irradiation of the first laser beam 23 toward the raw material 21.

As stated above, on the other hand, the high temperature plasma raw material 21' gasified by irradiation by the first laser beam 23 spreads, at a specified speed, centered on the normal direction of the surface of the high temperature plasma raw material to which the first laser beam 23 is incident. This specified speed depends on the irradiation energy of the first laser beam 23 that irradiates the raw material 21.

Ultimately, the time period $\Delta$tg from the point when the first laser beam irradiates the raw material until at least a part of the gasified high temperature raw material reaches the discharge region depends on the position of the discharge region and the raw material 21, the direction of first laser beam 23 irradiation of the raw material 21, and the irradiation energy of the first laser beam 23, and can be set to a specified period by setting these parameters appropriately.

Now, by setting these parameters appropriately, it is possible to set the spatial density distribution of the gasified high temperature raw material to a specified distribution.

When the first laser beam (laser beam for raw material) 23 described above irradiates and gasifies the raw material, it is possible to lengthen the pulse by appropriate setting of the first laser beam irradiation conditions and the discharge current.

That is, pulse lengthening of the EUV emission in order to maintain a state of plasma compression by means of the pinch effect is achieved without a large current flow through the discharge region by maintaining a high temperature plasma that fulfills the EUV emission conditions stated above (ion density from $10^{17}$ cm$^{-3}$ to $10^{20}$ cm$^{-3}$ and electron temperature from 20 eV to 30 eV).

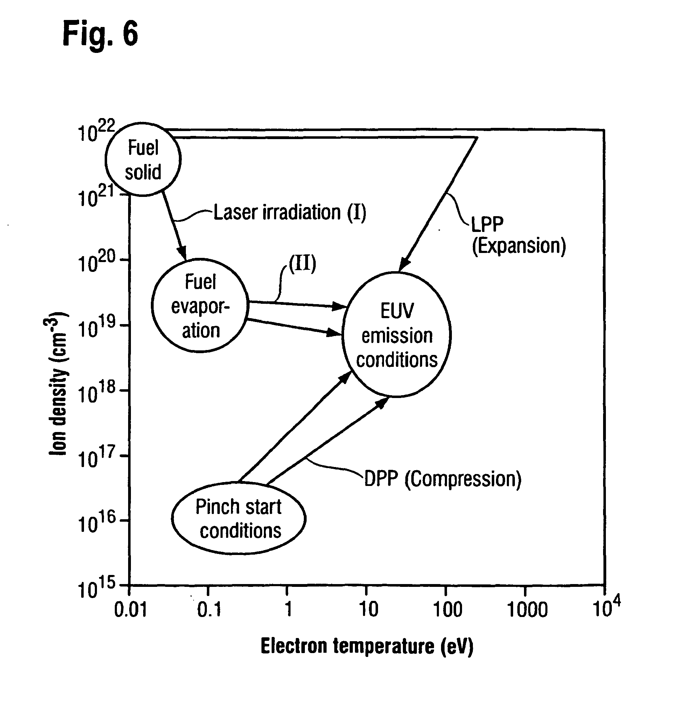

The DPP-type high temperature plasma generation of this invention is explained using figure 6. Now, the vertical and horizontal axes of figure 6 are the same as those of Figure 38.

An energy beam irradiates solid or liquid high temperature plasma raw material (a fuel solid is shown, as an example, in Figure 6) located outside the discharge region. A laser beam, for example, is used as the energy beam. The following explanation utilizes a laser beam as an example of the energy beam.

The solid or liquid high temperature plasma raw material irradiated by the laser beam is heated and gasified, and reaches the discharge channel formed in advance in the discharge region. Here, the irradiation energy of the laser beam is set appropriately so that when the gasified high temperature raw material reaches the discharge region, there will be an ion density of about $10^{17}$ cm$^{-3}$ to $10^{20}$ cm$^{-3}$ and an electron temperature not exceeding 1 eV in the plasma. In other words, laser beam irradiation of the high temperature plasma raw material will form a low temperature plasma gas such that the ion density in the plasma fulfills the condition for EUV emission but the electron temperature is a low temperature (path (I) of Figure 6).

This low temperature plasma is supplied to the discharge channel formed in advance in the discharge region between the electrodes, and the low temperature plasma is heated by the discharge current. Here, the ion density of the low temperature plasma gas has already met the condition for EUV emission, so it is acceptable if the conventional DPP-type pinch-effect compression is small. In other words, the current flowing between the electrodes primarily contributes only to heating of the low temperature plasma, heating brings the electron temperature to between 20 eV and 30 eV, and EUV is emitted by the high temperature plasma that has reached EUV emission conditions (path (II) of Figure 6).

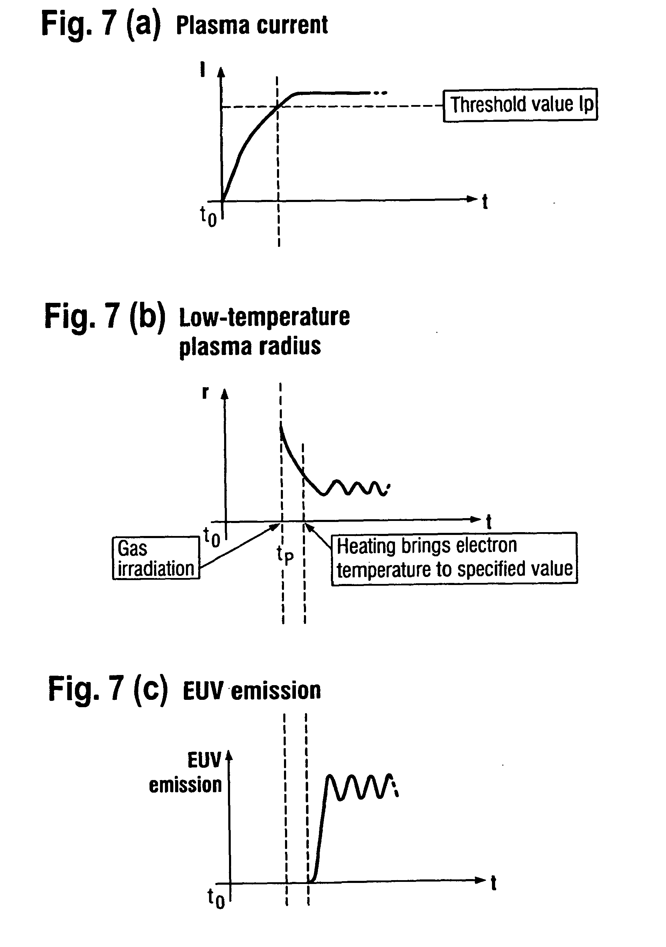

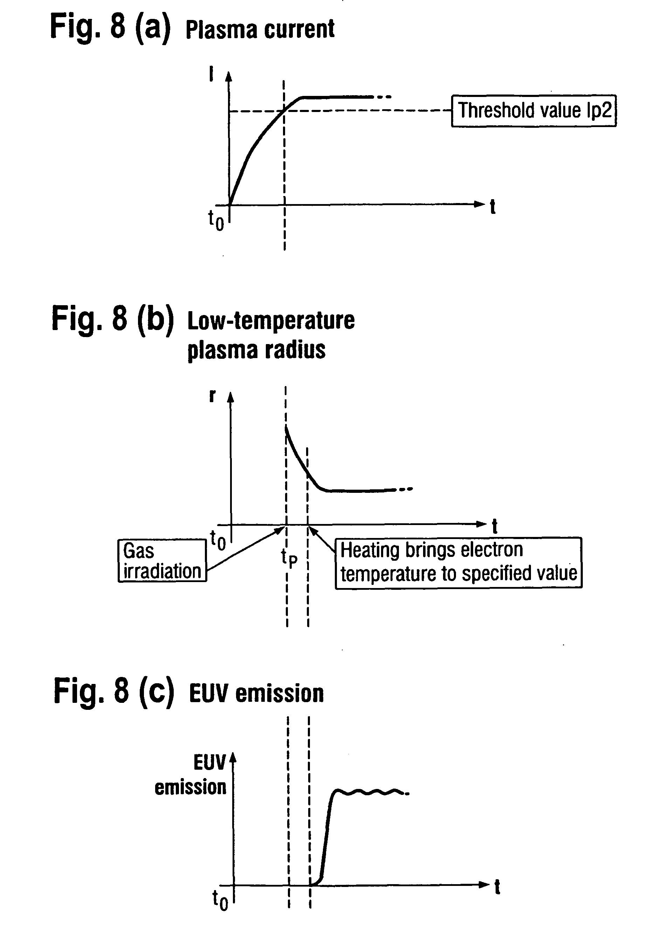

Here, the low temperature plasma gas is supplied continually to a discharge channel formed beforehand between the electrodes, by which means it becomes possible to achieve pulse lengthening of the EUV emission. The pulse-lengthening method is explained below, using Figures 7 & 8.

Now, Figure 7 shows the multi-pinch method and Figure 8 shows the non-pinch method.

Figure 7 is a graph to explain the plasma current, the low temperature plasma radius and EUV emission in the multi-pinch method.

Power is supplied between the electrodes, and at the time t = $t_0$ (by application of the trigger) vacuum discharge starts and current begins to flow, and a discharge channel (discharge current path) is formed (Figure 7(a)). At the point tp when the current I reaches the threshold value Ip, which is described hereafter, the cross-sectional size of the discharge channel narrows under the effect of the magnetic field inherent in the current.

On the other hand, at the point tp noted above, the high temperature plasma raw material gasified by laser beam irradiation (that is, the low temperature plasma gas with an ion density corresponding to EUV emission conditions but a lower electron temperature) is made to arrive selectively at the narrow discharge channel flowing in the discharge region.

Here, the current threshold value Ip, when $P_B$ is the compression pressure due to the self-magnetic field inherent to the current and Pp is the pressure of the plasma, is set as

$$P_B \gg Pp \qquad\qquad\qquad (104)$$

In other words, it is a current value at which adequate compression of the low temperature plasma gas by the self-magnetic field is possible.

Now, the threshold value Ip is a current value having energy capable of heating low temperature plasma (ion density from $10^{17}$ cm$^{-3}$ to $10^{20}$ cm$^{-3}$ and electron temperature not exceeding 1 eV) to an electron temperature of 20 eV to 30 eV or higher.

The low temperature plasma that is selectively supplied to the narrow discharge channel mentioned above is produced by laser beam irradiation of a solid or liquid high temperature plasma raw material, as mentioned above. The laser beam irradiation conditions are set appropriately on the basis of such things as the distance to the discharge region from the high temperature plasma raw material located outside the discharge region. The irradiation energy is at a level that can gasify the solid or liquid high temperature plasma raw material without raising the electron temperature too much (note: laser radiation raises the electron temperature slightly, as shown in Figure 6), in the range from $10^5$ W/cm$^2$ to $10^{16}$W/cm$^2$, for example.

Irradiating the solid or liquid high temperature plasma raw material with this sort of laser beam makes it possible to supply high temperature plasma raw material with an ion density that corresponds to EUV emission conditions and a low electron temperature (low temperature plasma gas) between the electrodes continuously for a period of about 10 $\mu$s.

The discharge duration in the conventional DPP method or LAGDPP method is generally about 2 $\mu$s. That is, compared to the conventional discharge duration, the supply of the low temperature plasma gas stated above can be considered to be a continuous steady supply.

The laser irradiation conditions and conditions, such as the location of the high temperature plasma raw material, are set appropriately so that the low temperature plasma gas selectively arrives at the narrow discharge channel. This type of adjustment is used to constitute a flow of gasified high temperature plasma raw material (low temperature plasma gas) with good directionality and to set that flow so that it is supplied focused on the vicinity of the narrow discharge channel. By means of such a constitution, low temperature plasma gas can be supplied continuously and selectively to the narrow discharge channel.

Now, when the solid or liquid high temperature plasma raw material is located inside the discharge region, the energy from the discharge acts directly on the high temperature plasma raw material and the conditions for gasification of the high temperature plasma raw material change from moment to moment. It is not possible, therefore, to continuously and selectively supply low temperature plasma gas with an ion density that corresponds to EUV emission conditions and a low electron temperature to a narrow discharge channel.

The low temperature plasma gas supplied to the narrow discharge channel, heated by the pinch effect of current at a value at or above the threshold value Ip or by the confinement effect of the self-magnetic field, becomes high temperature plasma and EUV is emitted by the high temperature plasma.

Here, the EUV emission is realized by the path (II) in figure 6, and so there is little compression from the pinch effect and a large proportion of the heating process is due to the confinement effect and Joule heating due to the self-magnetic field. In other words, there is not a large current as in the conventional DPP method and LAGDPP method, and EUV emission is possible even though a relatively small current is flowing through the discharge region. Further, it is possible to effectively input energy (that is, to heat) the plasma even without fast, short pulses of discharge current. Accordingly, it is possible to set the discharge current pulses longer than in the prior art.

Immediately following maximum compression, the compressed high temperature plasma is pushed out along a plasma density slope in the direction of the discharge channel axis, and largely departs from the direction of the discharge channel axis. At the same time, the discharge channel expands in the diametric direction, and as a result, the plasma density and electron temperature within the discharge channel fall sharply. In the prior art, the EUV emission is completed at this point.

However, there is a steady flow of low temperature plasma gas surrounding the discharge channel, as stated above, and so when the plasma density in the discharge channel drops, low temperature plasma gas is supplied to that space with no time lag. Accordingly, before the diameter of the discharge channel has expanded appreciably, the discharge channel is again narrowed by the pinch effect or by the confinement effect of the self-magnetic field; the low temperature plasma is heated, and the EUV emission continues by the mechanism described above (Figures 7(b) & 7(c)).

Repetition of this type of pinch effect or the confinement effect of the self magnetic field sustains the period for which the discharge current continues.

Now, rapid and short pulses are not necessary in this invention, as stated above, and so it is possible to set the discharge current pulses longer than in the prior art. That is, repetition of this sort of pinch effect or confinement effect of the self-magnetic field can be maintained for a long period, and so it is possible to bring about EUV emission pulse lengthening. This method of continuous use of the pinch effect is called the "multi-pinch" method hereafter.

In the conventional DPP method using the pinch effect, low ion-density, high temperature plasma raw material is supplied to the discharge region (pinch start conditions in Figure 6). The low density gas more or less fills the entire discharge vessel (discharge region). The discharge channel resulting from the initial plasma produced by discharge in a low-density gas atmosphere has an initial shape as broad as the diameter of the discharge vessel, and so a current pulse with great power is necessary to narrow the discharge channel by the pinch effect and turn the initial plasma into high temperature plasma. Moreover, fast and short pulses of discharge current must be applied in order to increase the efficiency of energy input into the plasma from the discharge. Accordingly, the EUV emission is completed with a single pinch effect, and the pulse width of the EUV emission is about 200 ns at the most (path 2 of Figure 38).

Further, in the conventional DPP method, when the first pinch ends and the plasma density in the discharge channel drops, low-density gas (high temperature plasma raw material) in the discharge vessel infiltrates that region, and so the discharge channel broadens and returns to the diameter of the initial state in the first pinch effect. Accordingly, if one attempts to execute multiple pinches, it requires a large current, the same as for the first pinch. In actuality, the discharge current is in fast and short pulses, as stated above, and so it is impossible to execute a second pinch in the time that remains after the first pinch.

The pinch effect is used in the LAGDPP method as well, and the EUV emission occurs by way of path 3 and then path 2 of Figure 38. That is, the low-density, high temperature plasma gas is supplied to the discharge region by means of laser irradiation of the high temperature plasma raw material.

Beyond that, as in the case of the DPP method, the initial plasma is generated by discharge in a low-density gas atmosphere, and a high-power current pulse is necessary to make the initial plasma into a high temperature plasma by means of the pinch effect, as well as realization of fast and short pulses of discharge current.. Therefore, the EUV emission ends with a single pinch effect.

As in WO 2005/101924 A1, in the LAGDPP method the discharge occurs after the high temperature plasma raw material gas is released by laser beam irradiation, and so a large proportion of high temperature plasma raw material gas escapes from the discharge region without being heated, which is inefficient.

In other words, in the conventional DPP method and the LAGDPP method, in order to achieve pulse lengthening of the EUV emission it is necessary to adopt a method to separate and control the plasma heating and compression process and the process of maintaining compression, and to supply energy to the discharge space so that the value of the plasma current after the plasma reaches a pinched state is larger than the value of the plasma current before the plasma reaches a pinched state, as in WO 2006/120942 A1 or JP-A-2007-123138.

Incidentally, the current threshold value Ip2, when $P_B$ is the compression pressure due to the self-magnetic field inherent to the current and Pp is the pressure of the plasma, is set as

$$P_B \geqq Pp \qquad\qquad\qquad (105)$$

 Even in the event of a current value such that the low temperature plasma gas is weakly compressed by the self-magnetic field (the low temperature plasma gas expands and the ion density is maintained at a level that does not diminish), pulse lengthening of the EUV emission is possible.

Now, the threshold value Ip2 is a current value having energy capable of heating low temperature plasma (ion density from $10^{17}$ to $10^{20}$ cm$^{-3}$ and electron temperature not exceeding 1 eV) to an electron temperature of 20 eV to 30 eV or higher.

Figure 8 is a graph to explain the plasma current, the low temperature plasma radius, and EUV emission in the case of the non-pinch method. The non-pinch method is explained below with reference to Figure 8.

Power is supplied between the electrodes, and at the time t = $t_0$, discharge starts and current begins to flow (Figure 8(a)). At the point tp when the current I reaches the threshold value Ip2, the cross-sectional size of the discharge channel narrows under the effect of the self-magnetic field inherent in the current. Now, to compare the current threshold value Ip when the multi-pinch effect is used and the threshold value Ip2 mentioned above, Ip > Ip2, and so and so the cross-sectional size of the discharge channel is larger than when the multi-pinch method is used.

On the other hand, at the point tp noted above, the low temperature plasma gas with an ion density corresponding to EUV emission conditions but a lower electron temperature is made to arrive selectively at the narrow discharge channel flowing in the discharge region, the same as when the multi-pinch effect is used. Now as stated above, the low temperature plasma gas is constituted to be continuously and selectively supplied to the narrow discharge channel.

The low temperature plasma gas supplied to the narrow discharge channel is hardly compressed at all by current exceeding the threshold value Ip2; this low temperature plasma gas, maintained in a state of expansion with no drop in ion density, is heated to become high temperature plasma, and EUV is emitted from the high temperature plasma. That is, because the ion density of the low temperature plasma satisfies the EUV emission conditions from the start, EUV emission can be realized by heating while maintaining the ion density (path (II) of Figure 6).

Accordingly, EUV emission is possible even with a relatively small current flowing through the discharge region, not the large current of the conventional DPP and LAGDPP methods. Further, it is possible to effectively input energy to the plasma (that is, to effectively heat the plasma) even without fast, short pulses of discharge current. Accordingly, it is possible to set the discharge current pulses longer than in the prior art.

Here, there is a steady flow of low temperature plasma gas surrounding the discharge channel, as stated above. As a result, low temperature plasma gas with the specified ion density is supplied steadily to the discharge. Accordingly, as long as the discharge current continues, the low temperature plasma is heated and the EUV emission continues (Figures 8(b) and 8(c)).

In this case as well, fast and short pulses of current are not necessary, and so it is possible to set discharge current pulses longer than in the prior art. That is, because it is possible to maintain continuous heating of low temperature plasma gas and generation of high temperature plasma over a long period, pulse lengthening of the EUV emission can be realized.

In this method, the current threshold value Ip2 is a current value such that the low temperature plasma gas is weakly compressed by the self-magnetic field (the low temperature plasma gas expands and the ion density is maintained at a level that does not diminish), and so the low temperature plasma is heated without apparent constriction and becomes high temperature plasma. Therefore, this method is called the "non-pinch method" below.

Here, whether it is the multi-pinch method described above or the non-pinch method is decided by the broadness of the discharge channel if the driving current values are the same. Such things as the discharge electrode shape and the beam diameter of the irradiating laser beam are selected; if the discharge channel is narrow it will be the multi-pinch method and if the discharge channel is broad it will be the non-pinch method.

Now, in the non-pinch method, the discharge channel diameter is larger than in the multi-pinch method, and so the size of the high temperature plasma will also be larger than in the multi-pinch method. That is, the size of the EUV radiation source will be larger than in the multi-pinch method, and so in the event that this invention is applied to an EUV light source device for lithography, adopting the multi-pinch method rather than the non-pinch method is preferable to enable reduction of the size of the EUV radiation source.

To compare the EUV radiation extraction by the multi-pinch method with extraction from a single pinch with the same energy conversion efficiency and the same EUV output, the peak power input is smaller with the single pinch. Accordingly, it is possible to suppress the peak power input to the electrodes, and to reduce the occurrence of debris resulting from electrode spattering. Further, the number of ions that contribute to EUV luminescence in a single pinch is smaller. Therefore, the size of the light source can be reduced, which is an advantage in design of the lithography optical system.

As stated above, pulse lengthening of EUV radiation can be realized in this invention in the following way.

(i) A narrow discharge channel is produced in the discharge region beforehand.

(ii) Solid or liquid high temperature plasma raw material outside the discharge region is irradiated by an energy beam and gasified, and a low temperature plasma gas is formed having an ion density corresponding to EUV emission conditions and a low electron temperature (Figure 6, fuel vapor: ion density from $10^{17}$ cm$^{-3}$ to $10^{20}$ cm$^{-3}$; electron temperature not exceeding 1 eV).

(iii) The low temperature plasma gas is selectively supplied at a steady rate to the narrow discharge channel so that the low temperature plasma gas reaches the narrow discharge channel when the discharge current reaches the specified threshold value (Ip or Ip2). As a result, the electron temperature of the low temperature plasma gas is raised by the action of the discharge and, following path II of Figure 6, a high temperature plasma that fulfills the EUV emission conditions is formed and EUV emission occurs.

(iv) Here, the low temperature plasma gas is supplied to a discharge channel formed in advance, and so there is no need for the discharge current pulses to be high current or fast and short pulses; it is acceptable for the current pulses to have slower rise times or to be longer than conventional current pulses. The EUV emission continues as long as the narrow discharge channel continues to some extent. Therefore, by forming a discharge circuit and lengthening the discharge current pulses so that they are longer than those of the conventional DPP and LAGDPP methods, it is possible to make the duration of the narrow discharge channel greater than in the prior art, and pulse lengthening of the EUV radiation can be realized as a result.

(v) Now, when the multi-pinch method is adopted and the current threshold value is set to be Ip, the diameter of the narrow discharge channel pulsates while the discharge current pulses continue but remains relatively narrow, and EUV radiation can be generated by repeated pinching of the low temperature plasma.

Further, when the non-pinch method is adopted and the current threshold value is set to be Ip2, the diameter of the narrow discharge channel will be broader than in the case of the multi-pinch method but remains relatively narrow; heating of the low temperature plasma continues, the plasma temperature and density necessary for EUV emission are maintained, and EUV radiation is generated.

Now, in the non-pinch method, as stated previously, the diameter of the discharge channel is greater than in the multi-pinch method and so the size of the high temperature plasma is also greater than in the multi-pinch method.

On the basis of the above, the problems mentioned previously are solved, as follows, in this invention.

(1) In an extreme ultraviolet light source device that has a raw material supply means that supplies liquid or solid raw materials so that extreme ultraviolet radiation will be emitted within the vessel, a first energy beam irradiation means that gasifies the raw material by irradiating the raw material with a first energy beam, a pair of electrodes separated by a specified gap to heat and excite the gasified raw material by discharge and to generate a high temperature plasma within the vessel mentioned above, a pulsed power supply means to supply pulsed power to the electrodes, a collector optical means that collects extreme ultraviolet radiation emitted from the high temperature plasma generated by discharge in the discharge region of the pair of electrodes, and an extreme ultraviolet radiation extraction area that extracts the collected extreme ultraviolet radiation, the extreme ultraviolet light source device has a second energy beam irradiation means that initiates discharge in the discharge region and demarcates the discharge path in a specified position of the discharge region by irradiating a second energy beam between the electrodes on which power is applied.

The first energy beam irradiation means irradiates the first energy beam toward raw material supplied to a space other than the discharge region from which the gasified raw material can reach the discharge region.

(2) In an extreme ultraviolet light source device that has a raw material supply means that supplies liquid or solid raw materials, a first energy beam irradiation means that gasifies the raw material by irradiating the raw material with a first energy beam, a pair of electrodes separated by a specified gap to heat and excite the gasified raw material by discharge and to generate a high temperature plasma within the vessel mentioned above, a pulsed power supply means to supply pulsed power of 1 μs or more to the electrodes, a collector optical means that collects extreme ultraviolet radiation emitted from the high temperature plasma generated by discharge in the discharge region of the pair of electrodes, and an extreme ultraviolet radiation extraction area that extracts the collected extreme ultraviolet radiation, the extreme ultraviolet light source device has a second energy beam irradiation means that initiates discharge in the discharge region and demarcates the discharge path in a specified position of the discharge region by irradiating a second energy beam between the electrodes on which power is applied.

The first energy beam irradiation means irradiates the first energy beam toward raw material supplied to a space other than the discharge region from which the gasified raw material can reach the discharge region, and after the discharge path is demarcated between the electrodes, raw material gas of which the ion density in the discharge path is nearly the same as the ion density under extreme ultraviolet radiation emission conditions is supplied to the discharge path mentioned above.

(3) In (1) and (2) above, the first energy beam irradiation means and the second energy beam irradiation means each have their operational timing set so that the discharge current of the discharge generated in the discharge region is at or above a specified threshold value when at least part of the gasified raw material having the specified spatial density distribution reaches the discharge region.

(4) In (1), (2) and (3) above, the supply of raw material from the raw material supply means is provided by dropping the raw material in droplet form in the direction of gravitation.

(5) In (1), (2) and (3) above, the supply of raw material from the raw material supply means is provided by putting the raw material in wire form and continually moving the raw material wire.

(6) In (1), (2) and (3) above, the raw material supply means has a raw material supply disk, and supply of raw material from the raw material supply means is done by putting the raw material in liquid form and supplying the liquid raw material to the raw material supply disk, and rotating the raw material supply disk to which the liquid raw material has been supplied to move the supplied portion of liquid raw material on the raw material supply disk to the irradiation position of the energy beam.

(7) In (1), (2) and (3) above, the raw material supply means has a capillary, and supply of raw material from the raw material supply means is performed by putting the raw material in liquid form and supplying the liquid raw material to the irradiation position of the energy beam by way of the above-mentioned capillary.

(8) In (1), (2) and (3) above, a tubular nozzle is fitted to the raw material energy beam irradiation position, and at least part of the raw material gasified by irradiation by the energy beam is sprayed by the tubular nozzle.

(9) In (8) above, there is a constriction of part of the interior of the nozzle.

(10) In (1), (2), (3), (4), (5), (6), (7), (8) or (9) above, there is a magnetic field impression means that applies a magnetic field on the discharge region that is roughly parallel to the direction of discharge generated between the pair of electrodes.

(11) In (1), (2), (3), (4), (5), (6), (7), (8), (9) or (10) above, the paired electrodes are disk-shaped electrodes and are driven to rotate so that the discharge generation position on the electrode surface changes.

(12) In (11) above, the paired, disk-shaped electrodes are placed so that the edge portions on the periphery of the two electrodes are separated by a specified gap.

(13) In (1), (2), (3), (4), (5), (6), (7), (8), (9), (10), (11) or (12) above, the energy beams are laser beams.

(14) In an extreme ultraviolet radiation generating method that generates extreme ultraviolet radiation by using a first energy beam to irradiate and gasify liquid or solid raw material for the emission of extreme ultraviolet radiation supplied to a vessel within which there is a pair of electrodes, and heating and exciting the gasified raw material and generating a high temperature plasma with a discharge from the pair of electrodes, the first energy beam is irradiated toward raw material supplied to a space other than the discharge region from which the gasified raw material can reach the discharge region, a second energy beam that irradiates the discharge region initiates discharge in the discharge region of discharge due to the paired electrodes, and demarcates a discharge path in a specified position in the discharge region.

(15) In an extreme ultraviolet radiation generating method that generates extreme ultraviolet radiation by using a first energy beam to irradiate and gasify liquid or solid raw material for the emission of extreme ultraviolet radiation supplied to a vessel within which there is a pair of electrodes, and heating and exciting the gasified raw material and generating a high temperature plasma with a discharge from the pair of electrodes, the first energy beam is irradiated toward raw material supplied to a space other than the discharge region from which the gasified raw material can reach the discharge region, a second energy beam that irradiates the discharge region initiates discharge in the discharge region of discharge due to the paired electrodes, demarcates a discharge path in a specified position in the discharge region, after the discharge path is demarcated between the electrodes, raw material gas of which the ion density in the discharge path is nearly the same as the ion density under extreme ultraviolet radiation emission conditions is supplied to the discharge path, the raw material gas is heated by the discharge to a temperature that fulfills the conditions for extreme ultraviolet radiation emission and extreme ultraviolet radiation is generated continuously for 200 ns or longer.

(16) In (15) above, the first energy beam and the second energy beam each have their irradiation timing set so that the discharge current of the discharge generated in the discharge region is at or above a specified threshold value when at least part of the gasified raw material having the specified spatial density distribution reaches the discharge region.

(17) In (16) above, time data on the start of discharge and time data on when the discharge current reaches the specified threshold value is acquired, and the irradiation timing of the first energy beam and the second energy beam is modified on the basis of both sets of time data.

(18) In (16) or (17) above, prior to irradiation of the first energy beam and the second energy beam with irradiation timing set as described above, the first energy beam irradiates the raw material once.

[Effect of the Invention]

The following effects can be obtained with this invention.

(1) Setting the intensity and direction of irradiation of the first energy beam appropriately makes it possible to set the spatial density distribution of the gasified high temperature raw material in the discharge region to the specified distribution.

Further, irradiating the specified position in the discharge region with the second energy beam makes it possible to demarcate the position of the discharge channel and to improve the positional stability of the point of generation of the EUV radiation. It becomes possible, moreover, to control the timing of the beginning of discharge by controlling the timing of irradiation by the second energy beam.

(2) Efficient EUV emission becomes possible by means of setting the irradiation timing of the first energy beam and the second energy beam so that in the timing, at which at least a part of the raw material gasified by irradiation by the first energy beam, having a spatial density distribution that is the specified distribution, reaches the discharge region and the discharge current of the discharge that is generated in the discharge region is at or above the specified threshold value, the second energy beam is irradiated.

(3) Setting a magnetic field impression means that applies a magnetic field on the discharge region that is roughly parallel to the direction of discharge generated between the paired electrodes makes it possible to reduce the size of the high temperature plasma that emits EUV radiation, and to prolong the period of EUV emission.

(4) Making the paired electrodes disk-shaped and driving them to rotate so that the position of discharge generation changes on the surfaces of the electrodes makes it possible to reduce the speed of electrode wear and prolong the service life of the electrodes.

(5) It is possible to reliably realize efficient EUV emission by obtaining time data on the timing of the start of discharge and the arrival of the discharge current at the specified threshold value and correcting the irradiation timing of the first energy beam and the second energy beam on the basis of that time data.

(6) Irradiating the raw material once with the first energy beam prior to irradiating the first energy beam and the second energy beam with the set irradiation timing facilitates the generation of discharge between the discharge electrodes and makes it possible to reliably generate discharge with the desired timing.

(7) A narrow discharge channel is produced in the discharge region beforehand, a low temperature plasma gas having an ion density corresponding to the EUV emission conditions and a low electron temperature is selectively supplied to the narrow discharge channel at a steady rate, the discharge acts on the low temperature plasma gas and an EUV emission is generated, and so the discharge current need not be a large current as in the conventional DPP and LAGDPP methods, and EUV emission is possible even though the current flowing in the discharge region is relatively small.

Further, it is possible to input energy into the plasma efficiently without the conventional fast and short pulse of discharge current. Therefore, it is possible to set discharge current pulses longer than in the prior art.

Further, by constituting the discharge circuit so that the discharge current pulses are longer than in the conventional DPP and LAGDPP methods and thus lengthening the discharge current pulses, it is possible to make the duration of the narrow discharge channel longer than in the prior art, and to realize pulse lengthening of the EUV emission as a result.

For example, when the duration of the discharge channel is at least 1 $\mu$s or longer, the duration of the discharge channel can be reliably lengthened to 200 ns. In other words, when the duration of the discharge channel is set to 1 $\mu$s or longer, it is possible to reliably make the duration of the EUV emission longer (to 200 ns) than the duration of the conventional EUV emission.

(8) In pulse lengthening, there is no need for the discharge current to be a large current as in the conventional DPP and LAGDPP methods, and there is no need to implement faster and shorter pulses of discharge current. Therefore, it is possible to make the thermal load on the electrodes less than in the prior art, and to suppress the generation of debris.

(9) There is no need to control the plasma current waveform in order to maintain the pinched state of high temperature plasma, as in conventional pulse-lengthening technology, and so there is no need for a large current flow between the electrodes. Further, there is no need to change the waveform of the plasma current in order to maintain the pinch effect, and so highly precise synchronization control and current control are not necessary.

(10) Irradiating the discharge path (discharge channel) with a discharge path fixation energy beam and fixing the discharge path with that energy beam makes it possible to improve the positional stability of the EUV emission point of luminescence.

1. Representative Embodiments

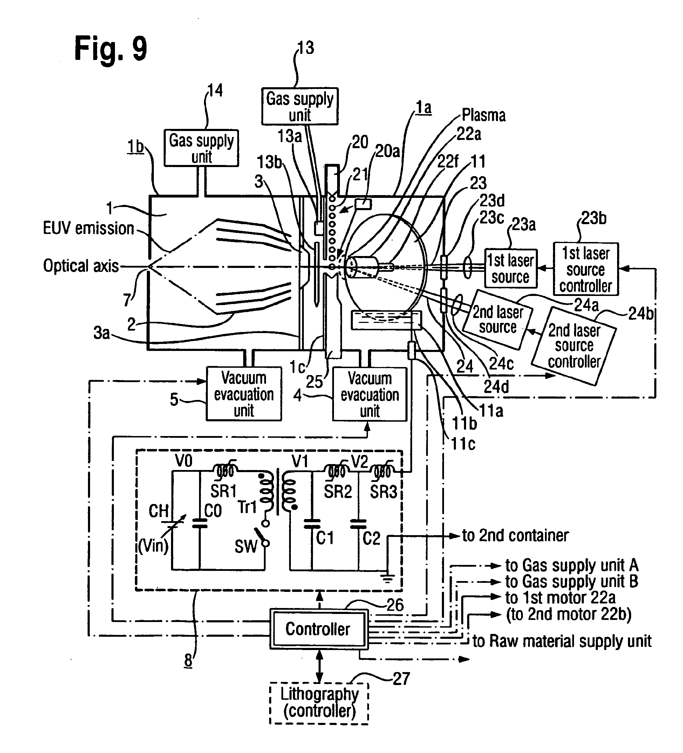

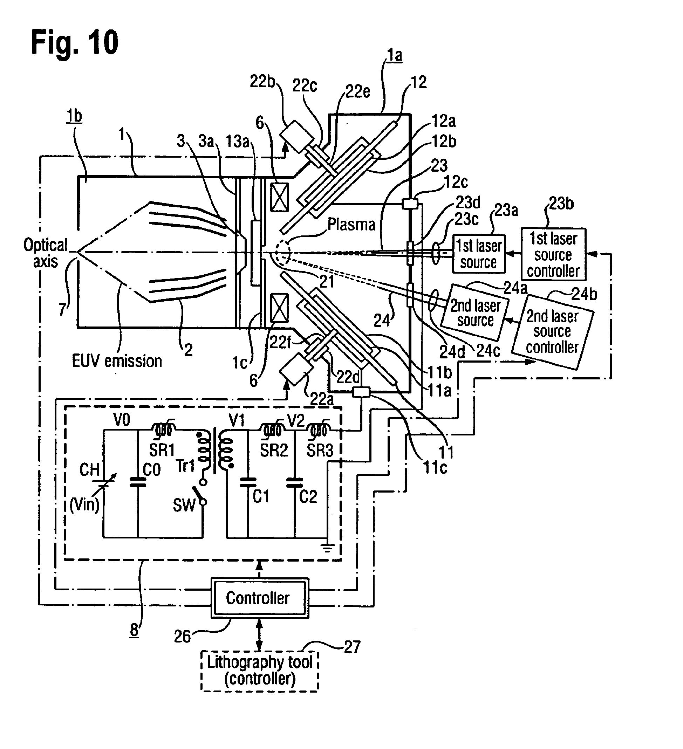

Figures 9 & 10 show the constitution (in cross section) of an embodiment of the extreme ultraviolet radiation (EUV) light source device of this invention. Figure 9 is a front view of this embodiment of the EUV light source device; the EUV radiation are extracted from the left side of the figure. Figure 10 is a plane view of this embodiment of the EUV light source device.

The EUV light source device shown in Figures 9 & 10 has a chamber 1 that is the discharge vessel. The chamber 1 is largely divided into two spaces by a partition 1c in which there is an opening. The discharge area is located in one of the spaces. The discharge area comprises a heating and excitation means that heats and excites high temperature plasma raw material that includes an EUV radiating species. The discharge area comprises such things as a pair of electrodes 11, 12.

In the other space, EUV collector optics 2 that collect the EUV radiation that is emitted by high temperature plasma produced by heating and exciting high temperature plasma raw material and guide the EUV radiation through an EUV extraction area in the chamber 1 to the irradiation optics system of lithography tool are present that the illustration of which has been omitted. A debris trap to suppress the transfer of debris produced as a result of plasma generation by the discharge to the EUV radiation collection area is also located in that space. In this embodiment, the debris trap shown in Figures 9 & 10 comprises a gas curtain 13b and a foil trap 3.

The space where the discharge area is located is called the "discharge space 1a" below, and the space where the EUV collector optics are located is called the "collection space 1b."

A vacuum evacuation device 4 is connected to the discharge space 1 a, and a vacuum evacuation device 5 is connected to the collection space 1b. Now, the foil trap 3 can be supported in the collection space 1b of the chamber 1 by a foil trap support partition 3a, for example. In other words, in the example shown in figures 9 and 10, the collection space 1b is divided into two spaces by the foil trap support partition 3a.

Now, the discharge area is shown larger than the EUV collection area in Figures 9 & 10, but this is for ease of understanding; the actual size relationship is not as in Figures 9 & 10. In reality, the EUV collection area is larger than the discharge area. That is, the collection space 1b is larger than the discharge space 1a.

The parts of this embodiment of the EUV light source device and their operations are explained below.

(1) Discharge area

The discharge area comprises a first discharge electrode 11 that is a disk-shaped metal material and a second discharge electrode 12 that is similarly a disk-shaped metal material. The first and second discharge electrodes 11, 12 are made of a metal with a high melting point, such as tungsten, molybdenum, or tantalum, and are placed so that they are separated by a specified gap. Here, one of the two electrodes 11, 12 is grounded, and the other is the electrode on the high-voltage side.

The two electrodes 11, 12 can be placed with their surfaces in the same plane, but to facilitate generation of a discharge, it is preferable to place them with the edge portions of their peripheries, where the electric field is concentrated when power is applied, facing each other across the specified gap, as shown in Figure 10. That is, it is preferable to place the electrodes so that the hypothetical planes that contain the surface of each electrode intersect. Now, the specified gap is the shortest distance separating the edge portions of the peripheries of the two electrodes.

As described hereafter, when pulsed power is applied to the electrodes 11, 12 by the pulsed power supply means, a discharge is generated between the peripheral edge portions. Generally, the most discharge is generated where the gap between the peripheral edge portions of the electrodes 11, 12 is the shortest.

Consider the case in which the two electrodes 11, 12 are placed with their surfaces in the same plane. In this case, the specified gap is the shortest distance separating the side faces of the electrodes. The position of discharge generation in this case is on a hypothetical line of contact formed by contact between the side face of the disk-shaped electrode and a hypothetical plane perpendicular to that side face. The discharge can occur at any position on the hypothetical line of contact on each electrode. Therefore, there is a possibility that the discharge position will not be stable when the surfaces of the two electrodes are located in the same plane.

On the other hand, when the electrodes 11, 12 are placed so that their peripheral edge portion face each other across the specified gap as shown in Figure 10, the smallest gap will be between the peripheral edge portions of the electrodes 11, 12 and most of the discharge will occur there, and so the discharge position is stable. The space between the two electrodes where discharge occurs is called the "discharge region" hereafter.

As stated above, when the edge portions on the peripheries of the electrodes 11, 12 are placed facing each other across a specified gap, if seen from above as in Figure 10, the two electrodes are laid out as though radiating from the position where the hypothetical planes that contain the surfaces of the first and second electrodes intersect. In Figure 10, the longest distance between the peripheral edge portions of the two electrodes, arranged as though radiating, is set on the other side of the position of intersection of the hypothetical planes from the EUV collector optics described hereafter.

Here, the longest distance between the peripheral edge portions of the two electrodes, arranged as though radiating, could be placed on the same side of the position of intersection of the two planes as the EUV collector optics 2. In that case, however, the distance between the discharge region and the EUV collector optics 2 would be lengthened and the EUV collection efficiency would fall by that much, so it is not realistic.

The hybrid-type EUV light source device of this embodiment makes use of EUV radiation emitted from high temperature plasma that is generated by discharge current drive of high temperature plasma raw material that has been gasified by irradiation by a first laser beam (laser beam for raw material). The heating and excitation means for the high temperature plasma raw material is a large current from the discharge generated between the paired electrodes 11, 12. Therefore, a large thermal load accompanying discharge is imposed on the electrodes 11, 12. This sort of thermal load gradually wears down the electrodes and generates metallic debris.

An EUV light source device, when used as a light source for lithography, collects with its EUV collector optics 2 the EUV radiation emitted by a high temperature plasma, and the collected EUV radiation is output to the lithography tool. Metallic debris can damage the EUV collector optics 2 and the reflectivity of EUV radiation can deteriorate.

Further, gradual wear of the electrodes 11, 12 changes the shape of the electrodes. The discharge generated between the paired electrodes 11, 12 gradually becomes unstable, and the generation of EUV radiation becomes unstable as a result.

When this sort of hybrid-type EUV light source device is used as the light source for mass-production semiconductor lithography tool, it is necessary to suppress the electrode wear described above and prolong the service life as much as possible.

In response to demands of that kind, the EUV light source device shown in Figures 9 & 10 is constituted with a first electrode 11 and a second electrode 12 that are shaped like disks and that rotate at least during discharge. In other words, because the first and second electrodes 11, 12 rotate, the position on the electrodes where the pulsed discharge is generated changes with each pulse. Therefore, the thermal load imposed on the first and second electrodes 11, 12 is smaller, the speed of wear of the electrodes 11, 12 is reduced, and the service life of the electrodes can be prolonged. The first electrode 11 and the second electrode 12 may also be called the "first rotary electrode" and the "second rotary electrode" hereafter.

More specifically, at roughly the centers of the first rotary electrode 11 and the second rotary electrode 12 are attached, respectively, the rotor shaft 22e of a first motor 22a and the rotor shaft 22f of a second motor 22b. The first motor 22a and the second motor 22b rotate the rotor shafts 22e and 22f, by which means the first rotary electrode 11 and the second rotary electrode 12 are rotated. Now, there are no particular limits on the direction of rotation. Here, the rotor shafts 22e, 22f are introduced into the chamber 1 by way of mechanical seals 22c, 22d, for example. The mechanical seals 22c, 22d allow rotation of the rotary shafts while maintaining a reduced pressure atmosphere in the chamber 1.

As shown in Figure 9, the first rotary electrode 11 is placed so that a part of it is submerged in an electrically conductive first container 11b that contains a conductive power supply metal melt 11a. Similarly, the second rotary electrode 12 is placed so that a part of it is submerged in an electrically conductive second container 12b that contains a conductive power supply metal melt 12a.

The first container 11b and the second container 12b are connected to a power generator 8, which is the pulsed power supply means, by way of insulated power introduction areas 11c, 12c that are capable of maintaining a reduced pressure atmosphere in the chamber 1. As stated above, the first and second containers 11b, 12b and the power supply metal melts 11a, 12a are electrically conductive, and because a part of the first rotary electrode 11 and a part of the second rotary electrode 12 are submerged in the power supply metal melts 11a, 12a, pulsed power can be applied between the first rotary electrode 11 and the second rotary electrode 12 by impressing pulsed power from the pulsed power generator 8 between the first container 11b and the second container 12b.

Now, metals that will not be affected by EUV radiation during discharge are adopted for the power supply metal melts 11a, 12a. Further, the metal melts 11a, 12a function as a means of cooling discharge parts of the rotary electrodes 11, 12. Now, illustration of them has been omitted, but temperature regulation means to maintain the metal melts in molten condition are fitted to the first container 11b and the second container 12b.

(2) Discharge initiation mechanism

In this embodiment of the EUV light source device, there are a second laser source 24a that irradiates a second laser beam (laser beam for raw material) 24 on a specified point in the discharge region, and a second laser beam controller 24b that controls the operation of the second laser source 24a.

The rotary electrodes 11, 12 are placed so that their peripheral edge portions face each other across a specified gap, as stated above, and so the most discharge is generated where the distance between the peripheral edge portions of the two electrodes 11, 12 is shortest. Therefore, the discharge position is stable. The stability of the discharge position declines, however, if such things as discharge-induced wear cause changes in the shape of the edge.

Here, when the laser beam for initiation 24 is focused on a specified position in the discharge region, electron radiation causes conductivity to decline in the vicinity of the focal point of the laser. Accordingly, the position of the discharge channel is demarcated at the position where the laser focal point is set. For that reason, the positional stability of the point where EUV radiation occur is improved.

For the second laser source 24a that emits the second laser beam (laser beam for initiation) 24, it is possible to adopt, for example, a carbon dioxide gas laser source, a solid laser source such as a YAG laser, a $YVO_4$ laser, or a YLF laser, or an excimer laser source such as an ArF laser, a KrF laser, or and XeC1 laser.

In this embodiment, moreover, a laser beam is used as the energy beam that irradiates a specified point in the discharge region, but it is acceptable to use an ion beam or an electron beam in place of a laser beam to irradiate the high temperature plasma raw material.

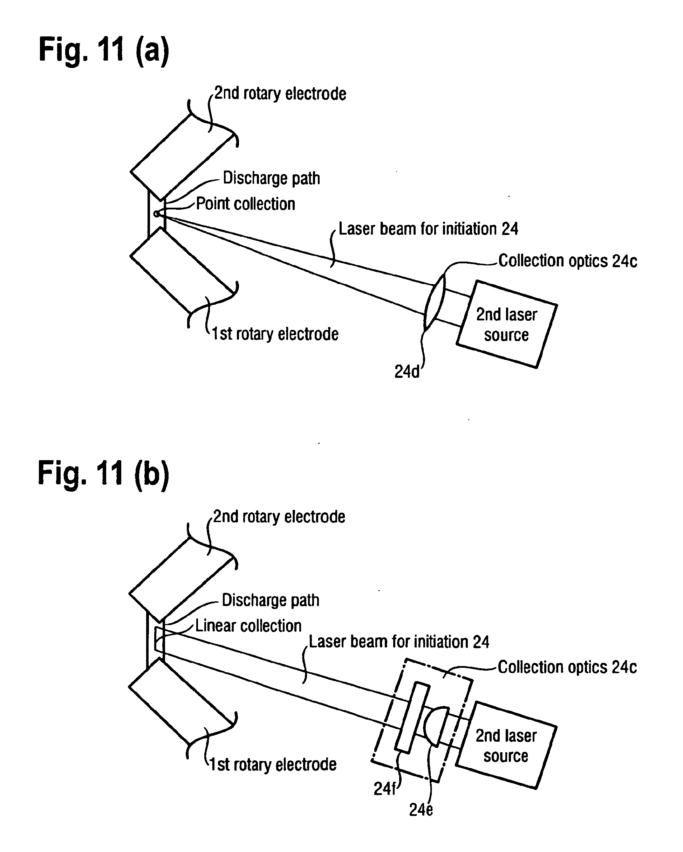

An example of collection of the second laser beam (laser beam for initiation) 24 is shown in Figure 11. Figure 11 (a) is an example of point collection of the second laser beam 24 on a specified point in the discharge region. A convex lens 24d, for example, is used as the collection optical system 24a. By collecting the second laser beam 24 in point shape on a specified point in the discharge region in the vicinity of the electrodes, dielectric breakdown can be induced between the electrodes. Here, conductivity is lowered by electron radiation in the vicinity of the laser focal point (collection point). The position of the discharge channel, therefore, can be demarcated as the position where the collection point of the laser is set.

In other words, the point where dielectric breakdown occurs is fixed by laser irradiation, by which means the position of the discharge channel is fixed as a localized region within the discharge region. For that reason, the positional stability of the point where EUV emission occurs is improved. By means of point collection, in particular, it is possible to make the point where EUV emission occurs smaller.

Figure 11(b) is an example of line collection of the second laser beam 24 on a specified point in the discharge region. Two cylindrical lenses 24e, 24f, for example, are used as the collection optical system 24b. As is well known, cylindrical lenses have the function of converging or spreading light in the axial direction only. The two cylindrical lenses 24e, 24f shown in Figure 11 (b) both have the function of converging the second laser beam 24 in their axial directions. Now, the two cylindrical lenses are placed so that the axial directions in which the laser beam for initiation 24 converges intersect each other.

By collecting the second laser beam 24 in linear form on a specified point in the discharge region that in the vicinity of the electrodes, dielectric breakdown can be induced between the electrodes. As in the case of point collection, the position of the discharge channel can be demarcated as the position where the collection point of the laser is set.

In other words, by fixing the linear collection position of the second laser beam 24 by laser irradiation, position of the discharge channel can be fixed as a localized region within the discharge region. For that reason, the positional stability of the point where EUV emission occurs is improved.

(3) Pulsed power generator

A pulsed power generator 8 that is the pulsed power supply means applies pulsed power with a short pulsewidth between the first container 11b and the second container 12b, or in other words between the first rotary electrode 11 and the second rotary electrode 12, which are the load, by way of an magnetic pulse compression circuit that comprises a capacitor and an magnetic switch.

Figures 9 & 10 show an example of the constitution of the pulsed power generator.

The pulsed power generator in Figures 9 & 10 is a two-stage magnetic pulse compression circuit that uses two magnetic switches SR2, SR3 that are saturateable reactors.

The magnetic switch SR1 is used to reducing switching losses of a solid switch SW that is an IGBT or other semiconductor switching element, and is also called an "magnetic assist". Now, the solid switch SW is the switching means mentioned previously, and is also called the "switching means" hereafter.

The constitution and operation of the circuit is explained below, following Figures 9 & 10. First, the charging voltage of the charger CH is adjusted to a set value Vin, and the main capacitor C0 is charged by the charger CH. At this time the IGBT or other solid switch SW is turned OFF.

When the main capacitor C0 is finished charging and the solid switch SW is turned ON, the voltage at the terminals of the solid switch SW is applied primarily to the terminals of the magnetic switch SR1.

When the time integral value of the charging voltage V0 of the main capacitor C0, which is applied to the terminals of the magnetic switch SR1, reaches the critical value determined by the properties of the magnetic switch SR1, the magnetic switch SR1 saturates and the magnetic switch closes; current flows through the loop comprising the main capacitor C0, the magnetic switch SR1, the primary side of a step-up transformer Tr1, and the solid switch SW. At the same time, current flows through the loop comprising the secondary side of the step-up transformer Tr1 and a capacitor C1, and the charge stored in the main capacitor C0 is transferred and charges the capacitor C1.

Following that, when the time integral value of the charging voltage V1 of the capacitor C1 reaches the critical value determined by the properties of the magnetic switch SR2, the magnetic switch SR2 saturates and the magnetic switch closes; current flows through the loop comprising the capacitor C1, the magnetic switch SR2, and a capacitor C2, and the charge stored in the capacitor C1 is transferred and charges the capacitor C2.

And following that, when the time integral value of the voltage V2 in the capacitor C2 reaches the critical value determined by the properties of the magnetic switch SR3, the magnetic switch SR3 saturates and the magnetic switch closes; a high-voltage pulse is applied between the first container 11b and the second container 12b, or in other words between the first rotary electrode and the second rotary electrode.

Here, the inductance of the staged charge transfer circuits made up of the magnetic switches SR2, SR3 and the capacitors C1, C2 is set to become less with transfer to the later stages; this allows a pulse compression operation such that the pulsewidth of the current pulses flowing in each stage become progressively narrower, and makes it possible to realize a strong discharge with short pulses between the first rotary electrode and the second rotary electrode, and the energy input to the plasma increases as well.

(4) Raw material supply and raw material gasification mechanisms

The high temperature plasma raw material 21 for the emission of extreme ultraviolet radiation is supplied in liquid or solid form by the raw material supply unit installed in the chamber 1 to the vicinity of the discharge region (the space where discharge occurs, which is the space between the peripheral edge portion of the first rotary electrode 11 and the peripheral edge portion of the second rotary electrode 12). More specifically, the high temperature plasma raw material 21 is supplied to a space other than the discharge region from which the gasified high temperature raw material can arrive at the discharge region.

The raw material supply unit 20 is mounted on the top wall, for example, of the chamber 1, and the high temperature plasma raw material 21 is supplied (dropped) in droplet form to the space in the vicinity of the discharge region.

When the high temperature plasma raw material supplied in droplet form drops down and arrives at the space in the vicinity of the discharge region, it is gasified by means of irradiation by the first laser beam (laser beam for raw material) 23 released by the first laser source 23a.

For the first laser source 23a that emits the first laser beam (laser beam for raw material) 23, it is possible to adopt, for example, a carbon dioxide gas laser source, a solid laser source such as a YAG laser, a $YVO_4$ laser, or a YLF laser, or an excimer laser source such as an ArF laser, a KrF laser, or an XeCl laser.

In this embodiment, moreover, a laser beam is used as the energy beam that irradiates the high temperature plasma raw material 21, but it is acceptable to use an ion beam or an electron beam in place of a laser beam to irradiate the high temperature plasma raw material.

As stated above, the high temperature plasma raw material gasified by irradiation by the first laser beam 23 spreads centered on the normal direction of the surface of the high temperature plasma raw material to which the first laser beam is incident. Therefore, it is necessary that the first laser beam 23 irradiate the high temperature plasma raw material surface on the side that faces the discharge region, so that the gasified high temperature raw material will spread in the direction of the discharge region.

Here, of the gasified high temperature plasma raw material supplied to the discharge region by irradiation by the first laser beam 23, a part that has not contributed to formation of high temperature plasma by the discharge, or of the clusters of atomic gas dissociated as a result of plasma formation, will contact and deposit on the low temperature portions of the EUV light source device as debris.

For that reason, it is preferable to supply the high temperature plasma raw material 21 and irradiate the high temperature plasma raw material 21 with the first laser beam 23 in such a way that the gasified high temperature raw material does not spread in the direction of the EUV collector optics 2.

More specifically, the raw material supply unit 20 is adjusted so that the high temperature plasma raw material 21 is supplied to a space between the paired electrodes 11, 12 and the EUV collector optics 2, a space other than the discharge region, from which it is possible for the gasified high temperature raw material to reach the discharge region. Moreover the first laser beam 23 is adjusted so that the first laser beam 23 will irradiate the raw material supplied to that space on the side of the surface of the high temperature plasma raw material that faces the discharge region, so that the gasified high temperature raw material will spread in the direction of the discharge region.

By means of such adjustments, it is possible to suppress the travel of debris to the EUV collector optics 2.

As stated above, the high temperature plasma raw material gasified by irradiation by the first laser beam 23 spreads centered on the normal direction of the surface of the high temperature plasma raw material to which the first laser beam 23 is incident. In greater detail, the density of the high temperature plasma raw material that is gasified and dispersed by irradiation by the first laser beam 23 is highest in the normal direction, and the density decreases as the angle from the normal line increases.

Based on the above, the supply position of the high temperature plasma raw material 21 relative to the discharge region and irradiation conditions such as the irradiation energy of the first laser beam 23 can be set appropriately so that the spatial density distribution of the gasified high temperature raw material supplied to the discharge region will meet the conditions so that EUV emission can be extracted efficiently after the high temperature plasma raw material in the discharge region is heated and excited.

Now, a raw material recovery means 25 to recover high temperature plasma raw material that was not gasified can be installed below the space to which the high temperature plasma raw material is supplied.

(5) EUV radiation collection area

The EUV radiation emitted from the discharge area is collected by grazing-incidence-type EUV collector optics 2 installed in the EUV radiation collection space and is guided from the EUV radiation extraction area 7 installed in the chamber 1 to the irradiation optical system of lithography tool, illustration of which has been omitted.

This grazing-incidence-type EUV collector optics 2 generally has a structure in which multiple thin, concave mirrors are nested with high precision. The shape of the reflective surface of each of the concave mirrors is, for example, an ellipsoid of revolution, a paraboloid of revolution, or a Wolter shape, and each concave mirror is shaped as a body of revolution. Here, a Wolter shape means that the light-incidence surface is a concave surface comprising, in order from the light-incidence side, a hyperboloid of revolution and an ellipsoid of revolution or a hyperboloid of revolution and a paraboloid of revolution.

The base material of each concave mirror is one such as nickel (Ni), for example. Because it reflects EUV radiation that has a very short wavelength the reflecting surface of the concave mirror is constituted with very good smoothness. The reflecting material in which this smooth surface is implemented is, for example, a metallic film such as ruthenium (Ru), molybdenum (Mo), or rhodium (Rh). The metallic film is finely coated onto the reflective surface of each concave mirror.

Because of such a constitution, the EUV collector optics are capable of good reflection and collection of EUV radiation with an angle of incidence from 0° to 25°.

(6) Debris trap

Between the discharge area and the EUV radiation collection area described above, there is a debris trap for the purpose of preventing damage to the EUV collector optics 2. The debris trap captures debris such as metallic powder generated by high temperature plasma-induced spatter from the peripheral edge portions of the first and second rotary electrodes 11, 12 that contact the high temperature plasma formed after discharge, as well as debris arising from such things as Sn or Li radiating species in the high temperature plasma raw material, and allows only the EUV radiation to pass through.

In the embodiment of the EUV light source device shown in Figures 9 & 10, as stated above, there is a debris trap that comprises a gas curtain 13b and a foil trap 3.

The gas curtain 13b is made up of gas supplied to the chamber 1 from the gas supply unit 13 by way of a nozzle 13a.

A gas curtain mechanism is shown in Figure 9. A nozzle 13a has a rectangular parallelepiped shape, and the openings through which the gas is released are long, thin rectangles. When the gas supply unit 13 supplies gas to the nozzle 13a, the gas is released in sheet form from the openings in the nozzle 13a, forming a gas curtain 13b. The gas curtain 13b changes the direction of travel of the debris, and the arrival of debris at the EUV collector optics 2 is suppressed. Here, it is desirable that the gas used for the gas curtain 13b have a high index of transparency to EUV radiation; such things as helium (He), rare gases like argon (Ar), or hydrogen ($H_2$) can be used.

Additionally, a foil trap 3 can be installed between the gas curtain 13b and the EUV collector optics 2. The foil trap 3 is described as a "foil-trap" in JP-A-2002-504746, for example. The foil trap 3 comprises multiple plates placed in the diametric direction of the high temperature plasma generating region so that they will not block the EUV radiation emitted from the high temperature plasma, and ring-shaped supports that support the plates.

When such a foil trap 3 is fitted between the gas curtain 13b and the EUV collector optics 2, pressure increases between the high temperature plasma and the foil trap 3. When the pressure increases, the gas density of any gas curtain gas that is present there increases, and collisions between the gas atoms and the debris increase. The debris loses energy through repeated collisions, and so its kinetic energy decreases. The energy, therefore, when debris collides with the EUV collector optics 2 will be decreased, and it is possible to decrease the damage to the EUV collector optics 2.

Now, it is acceptable to connect a gas supply unit 14 to the collection space 1b of the chamber 1 and introduce a buffer gas that is unrelated to the generation of EUV radiation. The buffer gas supplied by the gas supply unit 14 moves from the EUV collector optics 2 side, through the foil trap 3, to the space between the foil trap support partition 3a and the chamber partition 1c, and is evacuated by a vacuum evacuation device 4. Creating this sort of gas flow makes it possible to prevent debris not captured by the foil trap 3 from flowing into the EUV collector optics 2 side, and to reduce the damage from debris to the EUV collector optics 2.

It is acceptable here to supply halogen gases such as chlorine ($C1_2$) or hydrogen radicals from the gas supply unit 14 to the collection space, in addition to a buffer gas. These gases function as cleaning gases that react with and remove debris that is not eliminated by the debris trap and that deposits on the EUV collector optics 2. It is possible, therefore, to suppress functional deterioration in the form of reduced reflectivity of the EUV collector optics due to debris deposition.

## (7) Partition

The pressure in the discharge space 1a is set so that a good discharge will occur in order to heat and excite the high temperature plasma raw material that is gasified by laser beam for raw material irradiation, and it is necessary to maintain a vacuum atmosphere to some extent.

On the other hand, it is necessary for the debris trap to reduce the kinetic energy of debris in the collection space 1b, and so it is necessary to maintain a specified pressure in the debris trap area.

In Figures 9 & 10, the specified gas flows from the gas curtain and maintains the specified pressure at the foil trap 3, by which means the kinetic energy of debris is reduced. For this reason, it is necessary to maintain, in the collection space, a reduced pressure atmosphere of about several hundred Pa.

Here, in the EUV light source device of this invention, a partition 1c is installed to divide the interior of the chamber 1 into a discharge space and a collection space. There is, in this partition 1c, an opening that connects the two spaces spatially. Because the partition functions as pressure resistance, it is possible to evacuate the discharge space with a vacuum evacuation device 4 and the collection space with a vacuum evacuation device 5, and at the same time maintain a pressure of several Pa in the discharge space 1a and a suitable pressure in the collection space 1b by means of giving appropriate consideration to such things as the amount of the gas flow from the gas curtain 13b, the size of the opening, and the evacuation capability of each vacuum evacuation device.

## (8) Raw material monitor

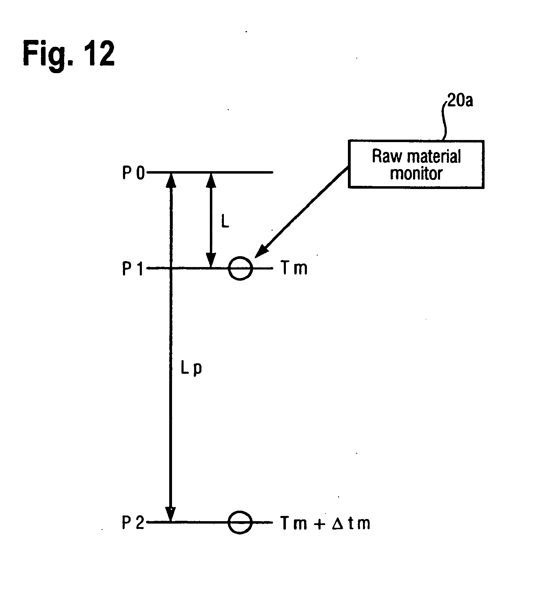

A raw material monitor 201 monitors the position of raw material dropped in droplet form from the raw material supply unit 20. As shown in Figure 9, for example, the raw material that drops from the raw material supply unit 20 is monitored for the time at which it arrives in the vicinity of the raw material supply monitor 20a (position P 1 in Figure 12). By means of this monitoring, as described below, it is possible to determine the period from the time when the raw material arrives at position P1 to its arrival at the position that is irradiated by the first laser beam (laser beam for raw material) 23 (position P2 in Figure 12). The monitoring is performed using, for example, well-known laser measurement methods. The raw material detection signal is transmitted from the raw material supply monitor 20a to a controller 26. The raw material 21 is dropped in droplet form, as noted above, and so the raw material detection signal will be an intermittent pulsed signal.

## (9) Operation of the extreme ultraviolet (EUV) light source device

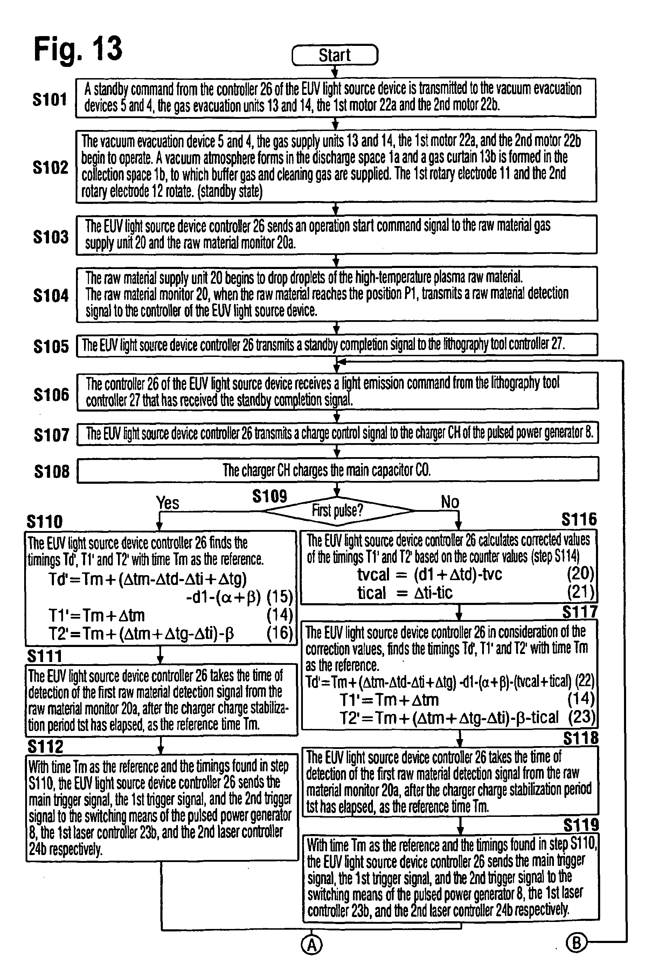

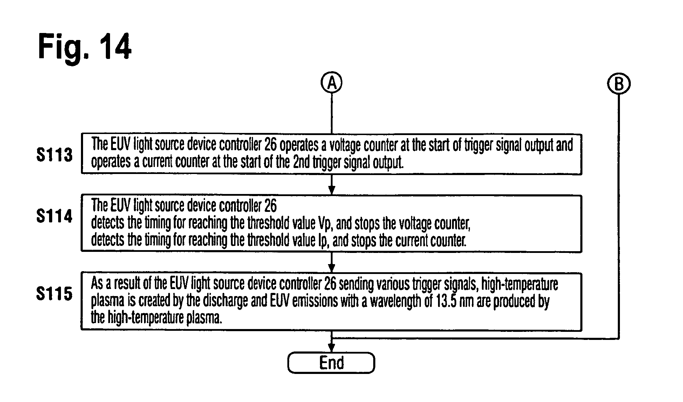

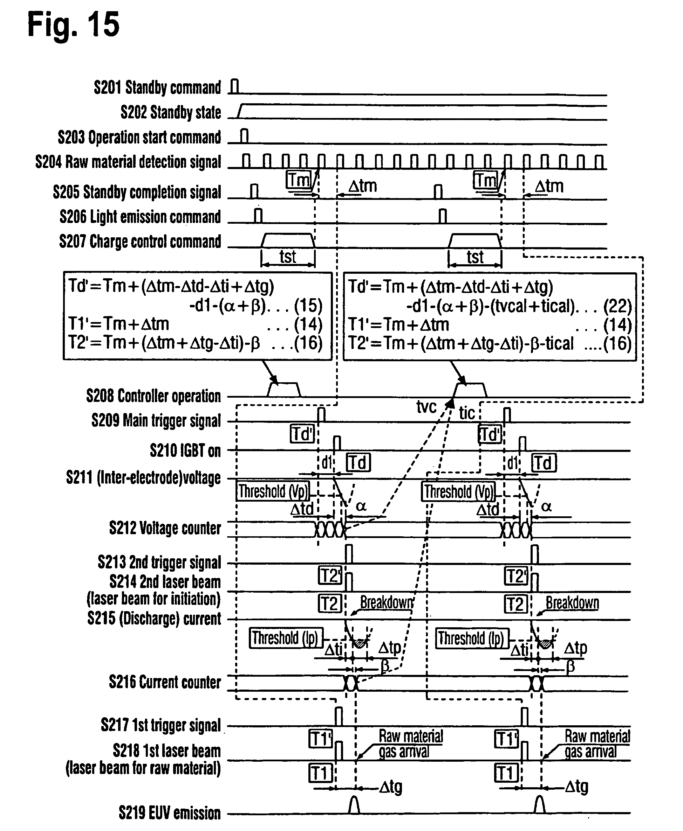

The EUV light source device of this embodiment operates as follows, for example when used as a light source for lithography. The operation of this embodiment is shown by the flow charts of Figures 13 & 14 and the time chart Figure 15 and is explained below with reference to these figures.

The controller 26 of the EUV light source device has stored the time data $\Delta td$, $\Delta ti$, $\Delta tg$ shown in Figures 1 & 2.

That is, $\Delta td$ is the period from the time when a trigger signal is input to the switching means of the pulsed power supply means (pulsed power generator 8) (time Td) to the time when the switching means is turned ON and the inter-electrode voltage reaches the threshold vale Vp. $\Delta ti$ is the period after discharge starts until the current flowing between the electrodes arrives at the threshold value Ip. And $\Delta tg$ is the period from the time that the first laser beam irradiates the raw material until at least a part of the gasified high temperature raw material of which the spatial density distribution is the specified distribution reaches the discharge region.

Generally, the greater the voltage V applied to the discharge electrodes 11, 12, the faster the rise time of the discharge waveform between the discharge electrodes. Consequently, Δtd depends on the voltage V applied to the discharge electrodes 11, 12. The controller 26 of the EUV light source device stores as a table the relationship between the voltage V and the period Δtd as determined experimentally in advance.

Further, the controller 26 of the EUV light source device stores the period Δtm from the time the raw material reaches a specified position (P1 in Figure 12, for example) until it reaches the position where the raw material 21 is irradiated by the first laser beam (laser beam for raw material) 23 (P2 in Figure 12, for example).

Further, the controller 26 stores the correction times α, β and the delay period d1 from the point when the trigger signal is output to the switching means of the pulsed power supply means to the point when that trigger signal is input to the switching means of the pulsed power supply means and the switching means is turned ON. The correction times α, β are described hereafter.

First, a standby command from the controller of the EUV light source device is transmitted to the vacuum evacuation device 5, the vacuum evacuation device 4, the gas evacuation unit 13, the gas evacuation unit 14, the first motor 22a, and the second motor 22b (steps S101 of Figure 13 and S201 of Figure 15).

Receiving the standby command, the vacuum evacuation device 5, the vacuum evacuation device 4, and the gas supply unit 13 and the gas supply unit 14 begin to operate. That is, the vacuum evacuation unit 4 operates and the discharge space becomes a vacuum atmosphere. On the other hand, when the vacuum evacuation unit 5 operates, the gas supply unit 13 also operates and the gas curtain 13b is formed. The gas supply unit 14 also operates and the buffer gas and cleaning gas are supplied to the collection space 1b As a result, the collection space1b reaches its specified pressure. Further, the first motor 22a and the second motor 22b operate and the first rotary electrode 11 and the second rotary electrode 12 rotate. The operations together are called the "standby state" hereafter (steps S102 of Figure 13 and S202 of Figure 15).

The controller 26 of the EUV light source device, following this standby state, sends an operation start command signal to the raw material gas supply unit 20 and the raw material monitor 20a (steps S103 of Figure 13 and S203 of Figure 15).

Receiving the operation start command signal, the raw material supply unit 20 begins to drop, in droplet form, the liquid or solid high temperature plasma raw material for EUV emission (tin in liquid form, for example). On the other hand, the raw material monitor 20, having received the operation start command signal, begins the monitoring operation and, when the raw material reaches the position P1 described hereafter, transmits a raw material detection signal to the controller 26 of the EUV light source device (steps S104 of Figure 13 and S204 of Figure 15).

Now, the first laser beam (laser beam for raw material) 23 does not irradiate the dropping raw material 21 at this time, and so it is recovered as is by the raw material recovery means 25.

The controller 26 of the EUV light source device transmits a standby completion signal to the lithography tool controller 27 (steps S105 of Figure 13 and S205 of Figure 15).

The controller 26 of the EUV light source device receives a light emission command from the lithography tool controller that has received the standby completion signal. Now, in the event that the intensity of the EUV emission is controlled from the lithography tool side, the light emission command will include EUV emission intensity data (steps S106 of Figure 13 and S206 of Figure 15).

The controller 26 of the EUV light source device transmits a charge control signal to the charger CH of the pulsed power generator 8. The charge control signal comprises, for example, such things as discharge start timing data. In the event that EUV emission intensity data is included in the light emission command from the lithography tool controller 27, as stated above, a charging voltage data signal for the main capacitor C0 is also included in the charge control signal.

For example, the relationship between the EUV emission intensity and the charging voltage for the main capacitor C0 is determined experimentally beforehand, and a table holding the correlation between the two is created. The controller 26 of the EUV light source device stores this table, and on the basis of the EUV emission intensity data included in the light emission command received from the lithography tool controller 27, it calls up data on the charging voltage for the main capacitor C0 from the table. On the basis of the called charging voltage data, the controller 26 of the EUV light source device transmits a charge control signal that includes charging voltage data for the main capacitor C0 to the charger CH of the pulsed power generator (steps S107 of Figure 13 and S207 of Figure 15).

The charger CH charges the main capacitor C0 as described above (step S108 of Figure 13).

The controller 26 of the EUV light source device decides whether this is the first EUV emission since the beginning of operation (called the "first pulse") (step 109 of Figure 13) and if it is the first pulse, proceeds from step S 109 to step S110. In the event that it is not the first pulse, it proceeds to step S116.

In step S110, the controller 26 of the EUV light source device calculates the timing for output of the main trigger signal to the switching means of the pulsed power supply means, the timing for transmission of the first trigger signal to the first laser controller 23b that controls the operation of the first laser source 23a, and the timing for transmission of the second trigger signal to the second laser controller 24b that controls the operation of the second laser source 24a.

In the case of the first pulse, it is not possible to use the feedback correction described hereafter without being able to use the count values of the voltage counter and the current counter described hereafter, and so the timings above are decided on the basis of previously stored time data $\Delta td$, $\Delta ti$, $\Delta tg$, $\Delta tm$, d1, $\alpha$, and $\beta$.

Now as shown in Figures 1 & 2, in reality it is desirable to set the time periods T1, T2 for irradiation of the first laser beam and the second laser beam 24 in relation to the time Td when the main trigger signal is input to the switching means of the pulsed power supply means (pulsed power generator 8) and the switching means turns ON.

In this embodiment, the delay period from the point Td' when the main trigger signal to the switching means of the pulsed power supply means is output to the point Td when the main trigger signal is input to the switching means of the pulsed power supply means and the switching means turns on is determined in advance. And so, the point Td when the switching means turns on is determined by correcting the point Td' when the main trigger signal to the switching means of the pulsed power supply means is output by adding the delay period d1.

On the other hand, the delay period d2 from the point T1' when the first trigger signal is sent until the first laser beam (laser beam for raw material) 23 irradiates and the delay period d3 from the point T2' when the second trigger signal is sent until the second laser beam (laser beam for initiation) irradiates are so small, on the order of ns, that they can be ignored; they are not considered here.

In the event that the first laser source 23a and the second laser source 24a are Q switch-type YAG laser devices, the time Td' when the main trigger signal to the switching means of the pulsed power supply means is output is taken as the reference for setting the timing T1' when the first trigger signal is sent to the first laser controller 23b that controls the operation of the first laser source 23a and the timing T2' when the second trigger signal is sent to the second laser controller 24b that controls the operation of the second laser source 24a. By this means, setting of the periods T1 and T2 when the first laser beam 23 and the second laser beam 24 are irradiated can be realized on the basis of the time Td when the main trigger signal is input to the switching means of the pulsed power supply means.

When the time for transmission of the main trigger signal (time Td') is taken as a reference, the timing T1' for sending the first trigger signal to the first laser controller 23b and the timing T2' for sending the second trigger signal to the second laser controller 24b that controls the operation of the second laser source 24a can be determined in the following way

As is clear from Figures 1 and 2, the timing T2 when the second laser beam 24 irradiates becomes, when the time Td when the switching means of the pulsed power supply means turns ON is taken as a reference,

$$T2 \geqq Td + \Delta t \qquad\qquad (1)$$

Accordingly, when the time Td' when the main trigger signal is transmitted is taken as a reference, the timing T2' for sending the second trigger signal to the second laser controller that controls the operation of the second laser source becomes

$$T2' + d3 \geqq (Td' + d1) + \Delta td \qquad\qquad (2)$$

Here, the delay period d3 is so small that it can be ignored, and so the timing T2' for sending the second trigger signal becomes

$$T2' \geqq Td' + d1 + \Delta td \qquad\qquad (3)$$

Here, after the inter-electrode voltage has certainly crossed the threshold value Vp the time to irradiate the second laser beam so that the second laser beam will be irradiated can be delayed somewhat from $\Delta td$. With this delay period defined as correction time $\alpha$, formula (3) can be transformed to become

$$T2' \geqq Td' + d1 + \Delta td + \alpha \qquad\qquad (4)$$

In this embodiment, that becomes

$$T2' = Td' + d1 + \Delta td + \alpha \qquad\qquad (5)$$

Now, the setting of T2' is not limited to formula (5), of course; it is enough to satisfy formula (4). For example, $T2' = Td' + d1 + \Delta td$ is acceptable.

From Figures 1 & 2, on the other hand, there is the following relationship between the timing T1 when the first laser beam 23 is irradiated and the timing T2 when the second laser beam 24 is irradiated is as follows.

$$T2 + \Delta ti \leqq T1 + \Delta tg \leqq T2 + \Delta ti + \Delta tp \qquad (6)$$

In this embodiment, after the discharge current has certainly crossed the threshold value Ip the time to irradiate the first laser beam 23 so that the first laser beam 23 will be irradiated can be delayed somewhat from $\Delta ti$. With this delay period defined as correction period $\beta$, the relationship between the timings T1 and T2 can be set as

$$T2 + \Delta ti + \beta = T1 + \Delta tg \qquad (7)$$

Here, the correction time $\beta$ becomes

$$0 \leqq \beta \leqq \Delta tp \qquad (8)$$

Now, the setting of the relationship between the timings T1 and T2 is not limited to formula (8), of course; it is enough to satisfy formula (6). For example,

$$T2 + \Delta ti = T1 + \Delta tg \text{ is acceptable, as is } T2 + \Delta ti + \Delta tp = T1 + \Delta tg.$$

For the relationship between the timing T1' when the first trigger signal is sent and the timing T2' when the second trigger signal is sent, formula (7) is transformed to become

$$(T2' + d3) + \Delta ti + \beta = (T1' + d2) + \Delta tg \qquad (9)$$

Here, the delay periods d2 and d3 can be ignored, so formula (9) becomes

$$T2' + \Delta ti + \beta = T1' + \Delta tg$$
$$T1' = T2' + \Delta ti + \beta - \Delta tg \qquad (10)$$

Substituting with formula (5), formula (10) becomes

$$T1' = (Td' + d1 + \Delta td + \alpha) + \Delta ti + \beta - \Delta tg$$
$$= Td' + d1 + (\Delta td + \Delta ti - \Delta tg) + (\alpha + \beta) \qquad (11)$$

When the time Td' for transmitting the main trigger signal is taken as a reference, as stated above, the timing T1' for sending the first trigger signal and the timing T2' for sending the second trigger signal are expressed by formula (5) and formula (11) respectively.

Here, the EUV light source device of this embodiment is supplied by dropping raw material in droplet form. Accordingly, the time when the dropping raw material reaches the position P2 for irradiation by the first laser beam in Figure 12 must be synchronized with the time Td' for transmitting the main trigger signal, the timing T1' for sending the first trigger signal, and the timing T2' for sending the second trigger signal.

Taking the time when the raw material arrives at the position P1 in Figure 12 as Tm, with the raw material arriving at the irradiation position P2 after Δtm has elapsed beyond Tm, then the time of arrival of the raw material at the irradiation point P2 will be Tm + Δtm. In other words, if the time Tm is the reference, it is necessary that

$$T1 = Tm + \Delta tm \qquad (12)$$

If formula (12) is transformed to a formula for the timing T1' for sending the first trigger signal, it becomes

$$(T1' + d2) = Tm + \Delta tm \qquad (13)$$

Here, the delay period d2 is so small that it can be ignored, and so formula (13) becomes

$$T1' = Tm + \Delta tm \qquad (14)$$

Accordingly, if time Tm is the reference, the time Td' for transmitting the main trigger signal, the timing T1' for sending the first trigger signal to the first 1 controller, and the timing T2' for sending the second trigger signal to the second laser controller that controls the operation of the second laser source can be found as follows.

$$Td' = Tm + (\Delta tm - \Delta td - \Delta ti + \Delta t\,g) - d1 - (\alpha + \beta) \qquad (15)$$

$$T1' = Tm + \Delta tm \qquad (14)$$

$$T2' = Tm + (\Delta tm + \Delta tg - \Delta ti) - \beta \qquad (16)$$

Here, from Figure 12, Δtm can be determined as follows.
As shown in Figure 12, the position where the raw material is discharged from the raw material supply unit 20 is P0, the position of the raw material monitored by the raw material monitor 20a is P1, and the irradiation position of the first laser beam 23 is P2, the distance from P0 to P1 is L, and the distance from P0 to P2 is Lp.
Further, the time when the raw material is at P0 is taken as the origin, the time when the raw material 21 reaches P1 as Tm, and the time when the raw material 21 reaches the irradiation position P2 as Tm + Δtm. With the drop speed of the raw material at position P0 as 0 and gravitational acceleration as G, then

$$L = (1/2)\, GTm^2 \qquad (17)$$

$$Lp = (1/2)\, G\, (Tm + \Delta tm)^2 \qquad (18)$$

From formulas (17) and (18), Δtm can be found as in formula (19).

$$\Delta tm = (2Lp/G)^{1/2} - (2L/G)^{1/2} \qquad (19)$$

In other words, in step S110 of Figure 13, the EUV light source device controller 26 uses the time data Δtd, Δti, Δtg, Δtm, d1, α, and β that were stored in advance and the formulas (15), (14), (16), and (19) to determine the timing Td' for transmitting the main trigger signal, the timing T1' for sending the first trigger signal to the first laser controller 23b, and the timing T2' for sending the second trigger signal to the second laser controller 24b that controls the operation of the second laser source 24a when the time Tm is taken as a reference (S208 of Figure 15).
Here, the time data Δtd is called up from the table that holds the correspondence between the voltage V and the period Δtd. For the data for the voltage V applied to the discharge electrodes, it is possible to use, without adjustment, the data of the charging voltage for the main capacitor C0 from the table that holds the interrelationships between charging voltage for the main capacitor C0 and the EUV emission intensity at the time the charge control signal is sent to the charger CH of the pulsed power generator in step S107, for example.

After the passage of the charger charge stabilization period tst, which is the period until the charge in the main capacitor C0 is stable, the controller 26 of the EUV light source device takes the time of detection of the first raw material detection signal from the raw material monitor 20a as the reference time Tm (steps S111 of Figure 13 and S204, S207 of Figure 15). Now, the setting of the reference time Tm is not necessarily limited to the time of detection of the first raw material detection signal after the charger charge stabilization period tst has elapsed. It is acceptable, for example, to set the reference time Tm to the time of detection of a specified number of raw material detection signals after the charger charge stabilization period tst has elapsed.

With the reference time Tm set in step S111 as the reference and using the timing Td' for transmitting the main trigger signal, the timing T1' for sending the first trigger signal to the first laser controller 23b, and the timing T2' for sending the second trigger signal to the second laser controller 24b that controls the operation of the second laser source 24a, which were calculated using formulas (15), (14), (16), and (19) with the time Tm as a standard, the controller 26 of the EUV light source device sends the main trigger signal, the first trigger signal, and the second trigger signal to the switching means of the pulsed power supply means (the pulsed power generator 8), the first laser controller 23b, and the second laser controller 24b respectively (steps S112 of Figure 13 and S209, S213, and S217 of Figure 15).

The controller 26 of the EUV light source device operates a voltage counter (not illustrated) that measures from the start of the main trigger signal output until the inter-electrode voltage reaches the threshold value Vp. Further, it operates a current counter (not illustrated) that measures from the start of the first trigger signal output until the discharge current reaches the threshold value Ip (steps S113 of Figure 14 and S212 and S216 of Figure 15).

Now, the voltage counter and the current counter are cleared to zero when a light emission command signal from the lithography tool controller 27 is input. The purpose of the voltage counter is to provide feedback control to regularize the period after output of the main trigger signal until the inter-electrode voltage reaches the threshold value Vp. The purpose of the current counter, on the other hand, is to provide feedback control to regularize the period after output of the second trigger signal until the discharge current reaches the threshold value Ip.

In other words, with the time Tm as a reference, the timing Td' for transmitting the main trigger signal, the timing T1' for sending the first trigger signal to the first laser controller, and the timing T2' for sending the second trigger signal to the second laser controller that controls the operation of the second laser source are decided on the basis of formulas (15), (14), (16), and (19), as described above, on the first iteration (the first pulse), but on the second and subsequent iterations, as described hereafter, they are decided on the basis of corrected values with the formulas (15), (14), (16), and (19) corrected on the basis of the count values from the voltage counter and the current counter.

The controller 26 of the EUV light source device detects the timing when the inter-electrode voltage has reached the threshold value Vp, by means of the unillustrated voltage monitor in Figures 9 & 10, and stops the voltage counter. Further, it detects the timing when the discharge current has reached the threshold value Ip, by means of the unillustrated current monitor, and stops the current counter (steps S 114 of Figure 14 and S212, S216 of Figure 15).

In step S 112 of Figure 13, the main trigger signal is sent at timing Td' on the basis of formula (15), and when the delay period d1 has elapsed after the main trigger signal is input to the switching means of the pulsed power supply means, the switching means (an IGBT, for example) is turned ON (steps S209, S210 of Figure 15).

When the switching means is turned ON, the voltage between the first rotary electrode 11 and the second rotary electrode 12 rises, and after period $\Delta td$, the inter-electrode voltage reaches the threshold value Vp. As described above, this threshold value Vp is the voltage value when the value of the discharge current that flows when discharge occurs is at or above the threshold value Ip (steps S210, S211 of Figure 15).

As stated above, in step S 112 the second trigger signal is sent to the second laser controller 24b at the timing T2' based on formula (16). As a result, at the time T2 at or after the time (Td + $\Delta td$) when the inter-electrode voltage reaches the threshold value Vp the second laser beam (laser beam for initiation) 24 irradiates the discharge region (steps 213, 214 of Figure 15).

When the second laser beam 24 irradiates the discharge region, discharge begins in the discharge region. When $\Delta ti$ has passed since the discharge begun, the magnitude of the discharge current reaches the threshold value Ip (steps S214, S215 of Figure 15). This threshold value Ip is the lower limit of the discharge current value necessary to obtain EUV radiation of the specified intensity. Now, the period that the discharge current value is at or above the threshold value Ip is $\Delta tp$.

As stated above, moreover, in step S112, the first trigger signal is sent to the first laser controller 23b at timing T1' based on formula (14). As a result, the first laser beam (laser beam for raw material) 23 irradiates at the time T1 during the period from (T2 + $\Delta ti$ - $\Delta tg$) to (T2 + $\Delta ti$ + $\Delta tp$ - $\Delta tg$) (steps S215, S217, S218 of Figure 15).

That is, as a result of the controller 26 of the EUV light source device sending the various trigger signals in step S 112, the position of the discharge channel is demarcated in the specified position. Further, in the discharge channel of which the position is demarcated, when at least a part of the gasified high temperature raw material of which the spatial density distribution is the specified distribution reaches the discharge channel, discharge occurs so that the magnitude of the discharge current is above the lower limit of the discharge current value necessary to obtain an EUV emission of the specified intensity.

The discharge occurs between the peripheral edge portions of the first rotary electrode 11 and the second rotary electrode 12, and plasma is formed. When the plasma is heated and excited by the large, pulsed current flowing through it and becomes a high temperature plasma, EUV radiation with a wavelength of 13.5 nm are produced by the high temperature plasma (steps S 115 of Figure 14 and S219 of Figure 15).

Now, the specified spatial density distribution mentioned above is set so that EUV radiation are produced as efficiently as possible. Specifically, it is set appropriately to provide an optimum spatial density distribution so that such things as the supply position of the high temperature plasma raw material relative to the discharge region, the irradiation direction of the first laser beam 23 on the high temperature plasma raw material, and the irradiation energy of the first laser beam 23 are as described above.

Further, the position of the discharge channel is demarcated in the specified position by second laser beam 24 irradiation, and so the positional stability of the position where plasma is produced is improved.

In other words, as a result of the controller 26 of the EUV light source device transmitting the various trigger signals, efficient generation of EUV radiation and stabilization of the position of EUV radiation generation can be realized.

The EUV radiation emitted by the plasma pass through the opening in the partition 1c and the foil trap 3 and are collected by the grazing-incidence-type EUV collector optics 2 located in the collection space 1b, then guided to the irradiation optical system of the lithography tool, illustration of which has been omitted, from the EUV extraction area 7 installed in the chamber 1.

When the initial EUV emission ends as described above, the process returns to step S106 of Figure 13, and awaits a light emission command from the lithography tool.

After receipt of the light emission command, the process moves through steps S107 and S108 described above to step S109. The subsequent EUV emission is not the first pulse, and so the process moves from step S109 to step S 116. In step S 116, the controller 26 of the EUV light source device uses the following formulas for feedback calculation of the timing T1' for sending the first trigger signal to the first laser controller 23b and the timing T2' for sending the second trigger signal to the second laser controller 24b that controls the operation of the second laser source 24a, based on the value of the voltage counter, which is the period measured in step S 114 after output of the main trigger signal until the inter-electrode voltage reaches the threshold value Vp, and the value of the current counter, which is the period after output of the second trigger signal until the discharge current reaches the threshold value Ip.

$$tvcal = (d1 + \Delta td) - tvc \qquad\qquad (20)$$

$$tical = \Delta ti - tic \qquad\qquad (21)$$

Here, tvcal is the correction value of the period after output of the main trigger signal until the inter-electrode voltage reaches the threshold value Vp, and tvc is the period measured by the voltage counter. Further, tical is the correction value of the period after output of the second trigger signal until the discharge current reaches the threshold value Ip, and tic is the period measured by the current counter (steps S 116 of Figure 13 and S208 of Figure 15).

Now as is clear from formula (20), tvcal is a correction value that sums the delay period d1, from the time Td' when the main trigger signal is output to the time Td when that main trigger signal is input to the switching means of the pulsed power supply means and the switching means is turned ON, and the period from the time Td when the switching means is turned ON to until the inter-electrode voltage reaches the threshold value Vp.

As stated above, a semiconductor switching element such as an IGBT that is capable of a large current flow is often used as the solid switch SW that is the switching means of the pulsed power supply means. With such an IGBT or other semiconductor switching means, there is a degree of variation in the period for actually turning ON after the gate signal (which corresponds to the main trigger signal in this embodiment) is input. In other words, formula (20) takes into consideration correction of the variation in the switching element.

The controller 26 of the EUV light source device gives consideration to the correction value found in step S 116 and uses the following formulas to decide, taking the time Tm as a reference, the time Td' for sending the main trigger signal, the timing T1' for sending the first trigger signal to the first laser controller 23b, and the timing T2' for sending the second trigger signal to the second laser controller 24b that controls the operation of the second laser source 24a (steps S 117 of Figure 13 and S208 of Figure 15).

$$Td' = Tm + (\Delta tm - \Delta td - \Delta ti + \Delta tg) - d1 - (\alpha + \beta) - (tvcal + tical) \qquad (22)$$

$$T1' = Tm + \Delta tm \qquad (14)$$

$$T2' = Tm + (\Delta tm + \Delta tg - \Delta ti) - d1 - \beta - tical) \qquad (23)$$

$$\Delta tm = (2Lp/G)^{1/2} - (2L/G)^{1/2} \qquad (19)$$

After the charger charge stabilization period tst, which is the period until the charge in the main capacitor C0 is stable, has passed, the controller 26 of the EUV light source device takes the time when the raw material detection signal from the raw material 20a is first detected as the reference time Tm (steps S 118 of Figure 13 and S204, S207 of Figure 15).

Now, the setting of the reference time Tm is not necessarily limited to the time of detection of the first raw material detection signal after the charger charge stabilization period tst has elapsed. It is acceptable, for example, to set the reference time Tm to the time of detection of a specified number of raw material detection signals after the charger charge stabilization period tst has elapsed.

Next, the controller 26 of the EUV light source device, taking the reference time Tm set in step S 118 as a reference, transmits the main trigger signal, the first trigger signal, and the second trigger signal to the switching means of the pulsed power supply means, the first laser controller 23b, and the second laser controller 24b, respectively, at the time Td' for sending the main trigger signal, the timing T1' for sending the first trigger signal to the first laser controller 23b, and the timing T2' for sending the second trigger signal to the second laser controller 24b that controls the operation of the second laser source 24a as found from formulas (22), (14), (23), and (19) with the time Tm as a reference (steps S119 of Figure 13 and S209, S214, S217 of Figure 15).

Next, the process moves to step S113 of Figure 14, and the controller 26 of the EUV light source device operated the voltage counter that measures from the beginning of output of the main trigger signal until the inter-electrode voltage reaches the threshold value Vp. Further, it operates the current counter that measures from the beginning of the second trigger signal until the discharge current reaches the threshold value Ip (steps S212, S216 of Figure 15). Now, the voltage counter and the current counter are cleared to zero when a light emission command signal from the lithography tool controller 27 is input.

The controller 26 of the EUV light source device detects the timing when the inter-electrode voltage reaches the threshold value Vp by means of a voltage monitor that is unillustrated in figures 9 and 10, and stops the voltage counter. Further, it detects the timing when the discharge current reaches the threshold value Ip by means of a current monitor that is unillustrated in figures 9 and 10, and stops the current counter (steps S 114 of Figure 14 and S212, S216 of Figure 15).

In step S 112, the main trigger signal is sent at the timing Td' based on formula (22), and when the delay period d1 has elapsed after input of the main trigger signal to the switching means of the pulsed power supply means, the switching means turns ON (steps S209, S210 of Figure 15).

When the switching means turns ON, the voltage between the first rotary electrode 11 and the second rotary electrode 12 rises and, after period $\Delta td$, the inter-electrode voltage reaches the threshold value Vp (steps S210, S211 of Figure 15).

In step S112, the second trigger signal is sent to the second laser controller 24b at the timing T2' based on formula (23), as stated above. As a result, at time T2 at or after the time (Td + $\Delta td$) when the inter-electrode voltage has reached the threshold value Vp (steps 213, 214 of Fig. 15), the second laser beam (laser beam for initiation) 24 irradiates the discharge region and discharge begins in the discharge region. When $\Delta ti$ has passed since discharge begun, the magnitude of the discharge current reaches the threshold value Ip described above (steps S214, S215 of Figure 15).

In step S112, the first trigger signal is sent to the first laser controller 23b at the timing T1' based on formula (14), as stated above. As a result, at time T1 during the period from (T2 + $\Delta ti$ - $\Delta tg$) to (T2 + $\Delta ti$ + $\Delta tp$ - $\Delta tg$), the first laser beam (laser beam for raw material) 23 irradiates (steps S215, S217, S218 of Figure 15).

In other words, as a result of the controller 26 of the EUV light source device sending the various trigger signals in step S 119, the position of the discharge channel is demarcated in the specified position. Further, in a state in which at least a part of the gasified high temperature raw material of which the spatial density distribution is the specified distribution has arrived at the discharge channel of which the position has been demarcated, discharge occurs in which the magnitude of the discharge current is above the lower limit of the discharge current value necessary to yield EUV radiation of the specified intensity.

The discharge occurs between the peripheral edge portions of the first rotary electrode 11 and the second rotary electrode 12, and a plasma is formed. By means of the large, pulsed current that flows through the plasma, the plasma is heated and excited and becomes a high temperature plasma. EUV radiation with a wavelength of 13.5 nm is produced by this high temperature plasma (steps S115 of Figure 14 and S219 of Figure 15).

Now, the specified spatial density distribution mentioned above is set to produce EUV radiation as efficiently as possible.

Further, because the position of the discharge channel is demarcated in the specified position, the positional stability of the position where EUV radiation is produced is improved.

In other words, in step S119 the EUV light source device controller transmits the various trigger signals and as a result, it is possible to realize efficient generation of EUV radiation and stabilization of the position of generation of the EUV radiation.

The EUV radiation emitted by the plasma pass through the opening in the partition 1 c and the foil trap 3 and are collected by the grazing-incidence-type EUV collector optics 2 located in the collection space 1b, then guided to the irradiation optical system of the lithography tool, illustration of which has been omitted, from the EUV extraction area 7 installed in the chamber 1.

While the lithography process continues, this process repeats from step S106 to step S 115. If the lithography process is completed, this process ends after step S 115.

By means of the operations above, the spatial density distribution of the gasified high temperature raw material supplied to the discharge region by irradiation with the first laser beam 23 can be set to produce EUV radiation as efficiently as possible. Now, so that this sort of optimum spatial density distribution can be set as a result of first laser beam 23 irradiation, such things as the position in which the raw material is supplied to the discharge region, the direction of irradiation of the raw material by the first laser beam 23, and the irradiation energy of the first laser beam 23 can be set appropriately in advance.

On the other hand, by focusing the second laser beam 24 on a specified position in the discharge region, it is possible to demarcate the position of the discharge channel in the position set by the laser focal point, as well as starting the discharge. For that reason, the positional stability of the point of generation of EUV radiation is improved.

Here, the irradiation timing of the first laser beam 23 and the irradiation timing of the second laser beam 24 are set as described above, and so, in a state in which at least a part of the gasified high temperature raw material of which the spatial density distribution is the specified distribution has arrived at the discharge channel of which the position has been demarcated, discharge occurs in which the magnitude of the discharge current is above the lower limit of the discharge current value.

As a result, efficient EUV emission can be realized.

In particular, feedback control is done in this embodiment in order to regularize the period after the main trigger signal is output until the inter-electrode voltage reaches the threshold value Vp and the period after the second trigger signal is output until the discharge current reaches the threshold value Ip. For this reason, it is possible to reliably realize efficient EUV radiation even if, for example, variation occurs in the operation of the IGBT or other semiconductor switching element used as the solid switch SW that is the switching means of the pulsed power supply means.

Now, it is acceptable to place magnets 6 in the vicinity of the discharge region that produces the plasma, as shown in Figure 10, and to apply a magnetic field to the plasma.

In the EUV light source device of this invention, as stated above, high temperature plasma raw material is supplied to a space in the vicinity of the discharge region in a discharge space in a vacuum atmosphere, the high temperature plasma raw material is gasified by laser beam irradiation of the supplied high temperature plasma raw material, and the gasified high temperature raw material is supplied to the discharge region. Next, a discharge is generated at the point when the gasified gas is supplied to the discharge region, and the plasma that produces EUV radiation is created. It is thought that the plasma created in this way spreads because of the grain density slope of the gasified high temperature plasma raw material in the discharge region and is lost. That is, the plasma spreads, and so it is thought the plasma size gets larger.

Consider the case in which a uniform magnetic field is applied roughly parallel to the direction of discharge generated between the first and second rotary electrodes.

Charged particles in a uniform magnetic field are subject to the Lorentz force. The Lorentz force works in the direction perpendicular to the magnetic field, and so charged particles exhibit uniform circular motion in a plain perpendicular to the magnetic field. In the direction parallel to the magnetic field, on the other hand, the charged particles are not subject to an external force, and so exhibit uniform motion in their initial speed. Accordingly, the motion of the charged particles is a composite of those mentioned, and becomes helical motion at a fixed pitch along the magnetic field (in the direction of the magnetic field.

Therefore, when a uniform magnetic field is applied roughly in parallel to the direction of discharge generated between the first and second rotary electrodes 11, 12, it can be inferred that if the magnetic field is applied such that the turning radius of the charged particles in spiral motion around the magnetic force lines is small enough, it will be possible to reduce the amount of dispersion of the plasma. In other words, it is thought that compared with the case in which no magnetic field is applied, the plasma size can be made smaller. Further, it thought that it is possible to prolong the life of the plasma, since the plasma disappears naturally as it disperses, and so it is thought that if a magnetic field is applied as described above, it will be possible to emit EUV longer than if no magnetic field is applied.

In other words, when a magnetic field is applied as described above, it is possible to reduce the size of the high temperature plasma that emits EUV (that is, the size of the EUV radiation source) and prolong the period of EUV emission. Therefore, the EUV light source device of this invention becomes better suited as a light source for lithography by means of applying a magnetic field.

Further, if the spiral radius of the charged particles described above is small enough relative to the minimum distance from the plasma generation position to the EUV collector optics 2, the high-speed ion debris among the debris arising from the high temperature plasma raw material will exhibit helical motion with this turning radius and will not arrive at the collector optics. That is, it is supposed that by applying a magnetic field it is possible to reduce the amount of ion debris flying off.

2. Variations of the embodiment shown in Figures 9 & 10

In the EUV light source device of this invention, the high temperature plasma raw material to emit extreme ultraviolet radiation is provided to the vicinity of the discharge region in a liquid or solid state. In embodiment 1 described above, the raw material is supplied to the EUV light source device in the form of droplets.

Of course, the high temperature plasma raw material supply mechanism is not limited to the constitution shown in the embodiment described above. Other examples of the raw material supply unit for the high temperature plasma raw material are discussed below.

(1) first variation

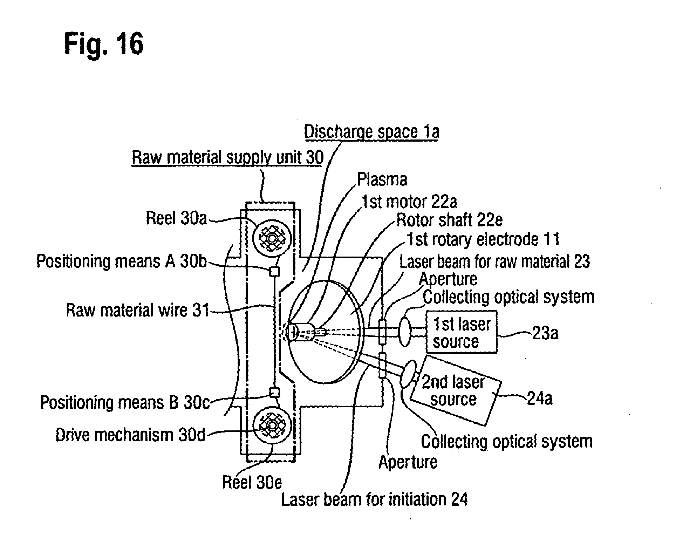

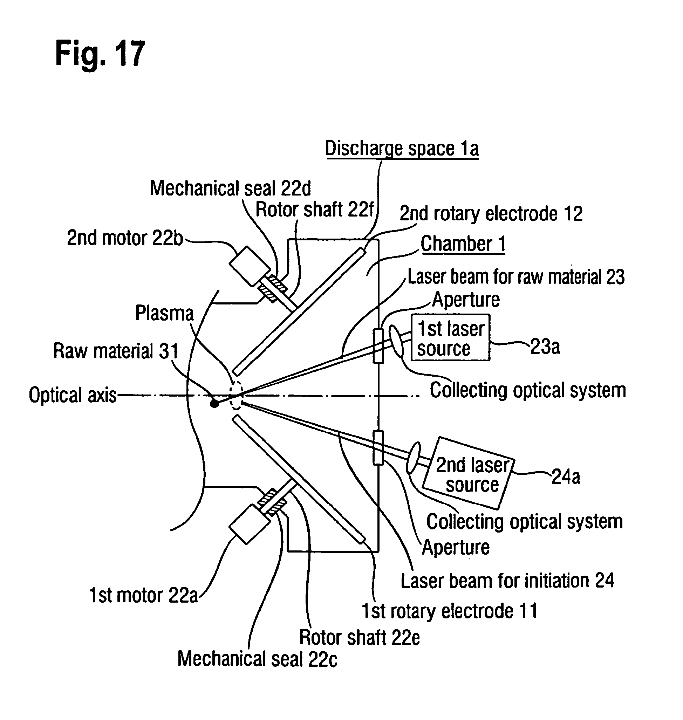

Figures 16 & 17 are diagrams to explain the first variation of the embodiment described above. In greater detail, Figure 16 is a front view of the EUV light source device of this invention; EUV emission is extracted from the left side of the figure. In other words, Figure 16 shows replacement of the raw material supply unit portion of the EUV light source device embodiment shown in Figure 9. Now, Figure 16 emphasizes the location and constitution of the raw material supply unit, and omits a portion of the EUV light source device for ease of understanding. Now, the omitted portion is the same as in Figure 9.

Figure 17, on the other hand, is a top view of the EUV light source device of this embodiment; as in Figure 16, a portion of the EUV light source device is omitted.

In the variation shown in Figures 16 & 17, raw material 31 is used in wire form as the high temperature plasma raw material; specifically, it is a metal wire that includes a radiating species for extreme ultraviolet radiation, such as Sn (tin), for example.

The raw material supply unit 30 of the first variation has the function of supplying raw material wire 31 to the specified space. This raw material supply unit 30 comprises a reel 30a, a reel 30e, a positioning means 30b, a positioning means 30c, raw material wire 31 and a drive mechanism 30d.

Now, the drive mechanism 30d is drive-controlled by a controller, illustration of which has been omitted from Figures 16 & 17.

The raw material wire 31 is wound on reel 30a and reel 30e. The reel 30a is the upper reel that delivers the raw material wire. The reel 30e, on the other hand, is the lower reel that takes up the raw material wire 31 delivered by the reel 30a. The raw material wire 31 is delivered from the real 30a by being taken up by the reel 30e, which is driven by the drive mechanism 30d.

The raw material wire 31 delivered from the real 30a gasifies when it is irradiated by the first laser beam (laser beam for raw material) 23 from the first laser source 23a. As stated above, the direction of spread of the gasified raw material for high temperature plasma depends on the position of incidence of the first laser beam 23 on the raw material 31.

Therefore, the raw material wire 31 is positioned by the positioning means 30b and the positioning means 30c so that position of incidence of the first laser beam 23 on the raw material 31 faces the discharge region. Now, the position in which it is positioned is a position from which the raw material gasified by first laser beam 23 irradiation of the raw material wire 31 can reach the discharge region.

Then, the beam axis of the first laser beam 23 that is irradiated from the first laser source 23a and the energy of the first laser beam 23 are adjusted so that when the raw material wire 31 is supplied and the first laser beam 23 irradiates the raw material wire 31, the gasified high temperature plasma raw material (raw material wire) will spread in the direction of the discharge region.

Here, the distance between the raw material wire 31 and the discharge region is set so that the gasified high temperature raw material that spreads in the direction of the discharge region because of laser beam irradiation will reach the discharge region in the specified spatial density distribution.

Now, the raw material wire 31 is preferably supplied to a space between the paired electrodes 11, 12 and the EUV collector optics 2, as shown in Figures 16 & 17.

When the first laser beam 23 irradiates the raw material wire 31 supplied in this way and irradiates the surface of the raw material wire on the side facing the discharge region, the gasified raw material wire will spread in the direction the discharge region and will not spread in the direction of the EUV collector optics 2.

In other words, by setting the supply position of the raw material wire with respect to the discharge region and the irradiation position of the first laser beam 23 as described above, it is possible to suppress debris traveling toward the EUV collector optics 2.

(2) second variation

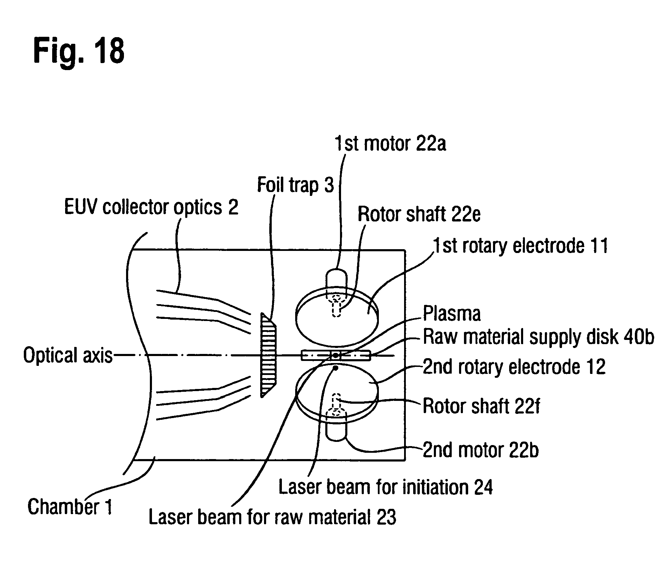

Figures 18, 19, and 20 are diagrams to explain the second variation of the embodiment described above. In greater detail, Figure 18 is a front view of this embodiment of the EUV light source device; EUV radiation are extracted at the left side of the figure. That is, Figure 18 shows a replacement for the raw material supply unit 20 in the embodiment of the EUV light source device shown in Figure 9.

Now, Figure 18 emphasizes the location and constitution of the raw material supply unit, and omits a portion of the EUV light source device for ease of understanding. Now, the omitted portion is the same as in figure 9.

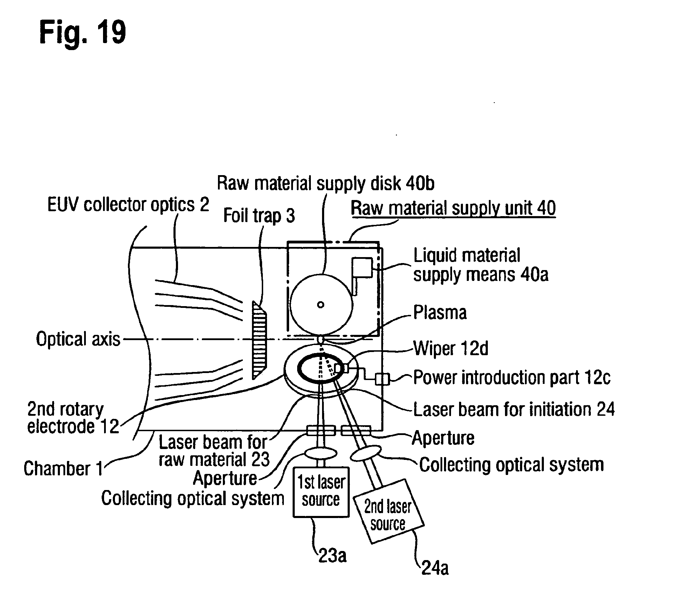

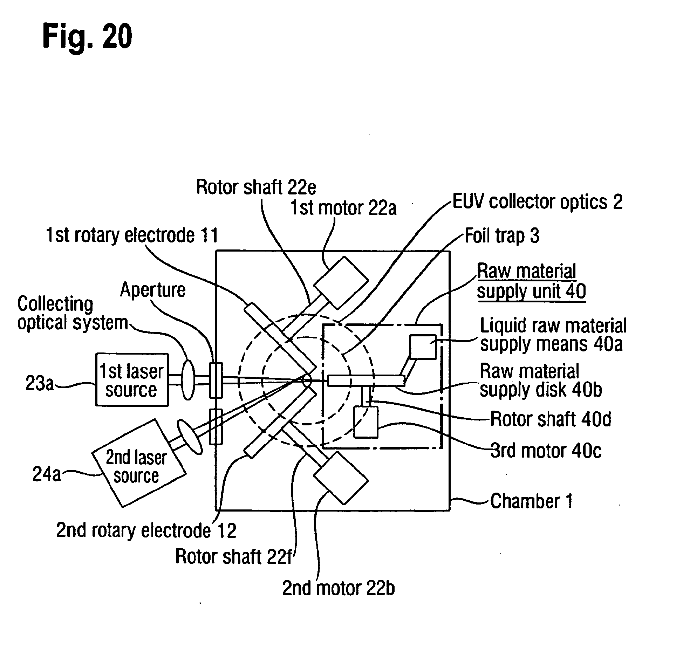

Figure 19, on the other hand, is a plan view of the EUV light source device of this invention and Figure 20 is a side view of the EUV light source device of this invention; as in Figure 18, a portion of the EUV light source device is omitted. Now, a case in which power is supplied to the electrodes 11, 12 through wipers is shown in Figure 19; the supply of pulsed power to electrode 12, for example, is done from a power introduction part 12c by way of a wiper 12d, as shown in the figure.

In the variation shown in Figures 18-20, a liquid raw material is used as the high temperature plasma raw material; specifically, this is a liquid raw material that includes a radiating species for extreme ultraviolet radiation; it includes Sn (tin), for example.

The raw material supply unit 40 has the function of supplying liquid raw material to a specified space. This raw material supply unit 40 comprises a liquid raw material supply means 40a, a raw material supply disk 40b, and a third motor 40. Now, the liquid raw material supply means 40a and the third motor drive mechanism, illustration of which has been omitted, are drive-controlled by a controller, illustration of which has been omitted in Figures 18-20.

There is a groove on the side surface of the raw material supply disk 40b. First, the liquid raw material is supplied to the groove by the liquid raw material supply means 40a. Next, the raw material supply disk 40b is rotated in one direction by the third motor 40c. The liquid raw material supplied to the groove moves with the rotation of the groove.

When the liquid raw material supplied to the groove is irradiated by the first laser beam (laser beam for raw material) 23 that is irradiated by the first laser source 23a, it is gasified. As described above, the direction in which the gasified high temperature plasma raw material spreads depends on position of incidence of the first laser beam 23 on the raw material. Therefore, the raw material supply disk 40b is located in respect to the discharge region so that the position of incidence of the first laser beam 23 on the liquid raw material supplied to the groove faces the discharge region.

Specifically, the raw material supply disk is placed so that the grooved side surface faces the discharge region. Now, the position in which the raw material supply disk 40b is located is a position from which the raw material gasified by first laser beam 23 irradiation of the liquid raw material supplied to the groove can reach the discharge region.

Then, the beam axis of the first laser beam 23 that is irradiated from the first laser source 23a and the energy of the first laser beam 23 are adjusted so that when the liquid raw material is supplied and the first laser beam 23 irradiates the groove facing the discharge region, the gasified high temperature plasma raw material (liquid raw material) will spread in the direction of the discharge region.

Here, the distance between the raw material supply disk 40b and the discharge region is set so that the gasified high temperature raw material that spreads in the direction of the discharge region because of laser beam irradiation will reach the discharge region in the specified spatial density distribution.

Here, the liquid raw material supplied to the groove moves with the rotation of the groove, and so by continuously supplying liquid raw material to the groove from the liquid raw material supply means, it is possible to supply it continuously to the specified irradiation position of the first laser beam 23.

Now, in the constitution of the second variation, as shown in Figures 18-20, the liquid raw material supplied to the groove moves toward the vicinity of the discharge region, to a space on a plane perpendicular to the optical axis, and the first laser beam 23 irradiates the liquid raw material supplied to the groove from a direction perpendicular to the optical axis. For that reason, the gasified high temperature raw material (liquid raw material) does not spread in the direction of the EUV collector optics 2. Therefore, hardly any debris produced by first laser beam 23 irradiation of the high temperature plasma raw material or discharge generated in the discharge region travels toward the EUV collector optics 2.

(3) third variation

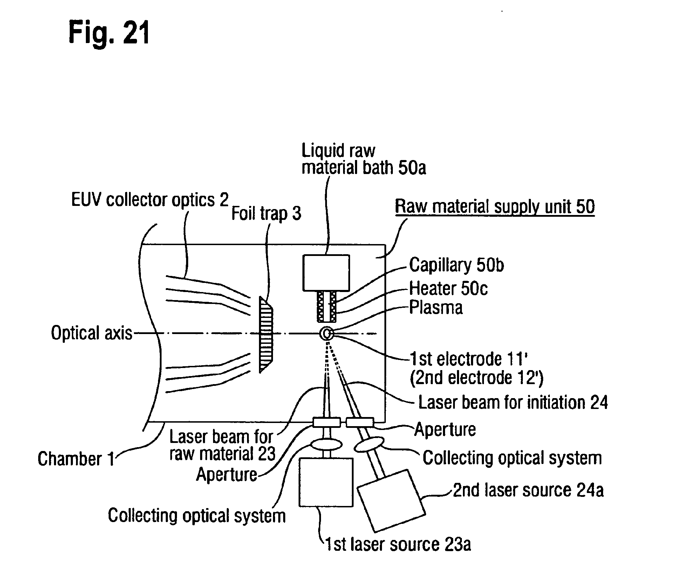

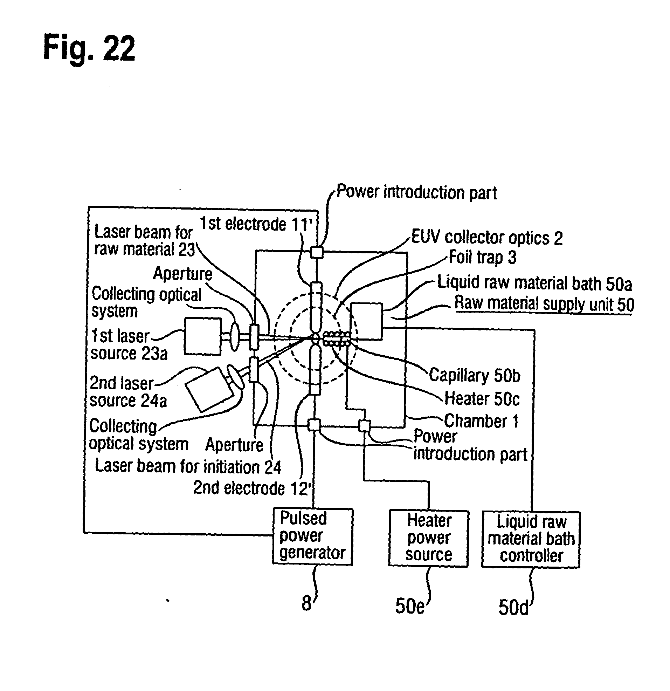

Figures 21 & 22 are diagrams to explain the third variation of the embodiment described above. In greater detail, Figure 21 is a front view of the EUV light source device of this invention; EUV emission is extracted from the left side of the figure. Figure 22, on the other hand, is a top view of the EUV light source device of this embodiment.
Figures 21 & 22 show replacement of the raw material supply unit 20 portion of the EUV light source device embodiment shown in figure 9. Now, Figure 21 emphasizes the location and constitution of the raw material supply unit, and omits a portion of the EUV light source device for ease of understanding. Now, the omitted portion is the same as in Figure 9.
In the variation shown in Figures 21 & 22, a liquid raw material is used as the high temperature plasma raw material. Specifically, it is a liquid raw material that includes a radiating species for extreme ultraviolet radiation, such as Sn (tin), for example.
The raw material supply unit 50 of the third variation has the function of supplying liquid raw material to the specified space. This raw material supply unit 50 comprises a liquid raw material bath 50a, a capillary 50b, a heater 50c, a liquid raw material bath controller 50d, and a heater power source 50e. Now, the liquid raw material bath controller 50d, and the heater power source 50e are drive-controlled by a controller, illustration of which has been omitted from Figures 21 and 22.
The liquid raw material bath 50a accommodates the liquid raw material that contains the radiating species for extreme ultraviolet radiation. A capillary 50b, a very fine tube, is fitted to the liquid raw material bath 50a. The capillary 50b connects through to the raw material accommodation area of the liquid raw material bath 50a. In the raw material supply unit 50 of the third variation, the liquid raw material accommodated in the liquid raw material bath 50a is drawn by capillary action into the capillary 50b and led to the tip of the capillary 50b.
Sn (tin), for example, can be used as the liquid raw material including a radiating species for extreme ultraviolet radiation that is accommodated in the liquid raw material bath 50a. The temperature of the liquid raw material bath 50a is controlled by the liquid raw material bath controller 50d so that the Sn is maintained in a liquid state. Further, the capillary 50b is heated by a heater 50c in order to avoid solidification of the liquid raw material in the tube. Power is supplied to the heater 50c by a heater power source 50e.
When the first laser beam (laser beam for raw material) 23 from the first laser source 23a irradiates the liquid raw material that reaches the tip of the capillary 50b, the liquid raw material is gasified. The direction in which the gasified high temperature plasma raw material spreads depends on position of incidence of the first laser beam 23 on the raw material.
Therefore, the tip of the capillary 50b is located so that the position of incidence of the first laser beam 23 on the liquid raw material that reaches the tip of the capillary 50b faces the discharge region. Now, the position in which the tip of the capillary 50b is located is a position from which the raw material gasified by first laser beam 23 irradiation of the liquid raw material that reaches the tip of the capillary 50b can reach the discharge region.
Then, the beam axis of the first laser beam 23 that is irradiated from the first laser source 23a and the energy of the first laser beam 23 are adjusted so that when the liquid raw material is supplied to the tip of the capillary 50b and the first laser beam 23 irradiates the capillary tip, the gasified high temperature plasma raw material (liquid raw material) will spread in the direction of the discharge region.
Here, the distance between the tip of the capillary 50b and the discharge region is set so that the gasified high temperature raw material that spreads in the direction of the discharge region because of laser beam irradiation will reach the discharge region in the specified spatial density distribution.
Further, the liquid raw material supplied to the tip of the capillary 50b is moved from the liquid raw material bath 50a by capillary action, and so it is possible to supply it continuously to the specified irradiation position of the laser beam for raw material 23.
Now, in the third variation shown in Figures 21 & 22, a first electrode 11' and a second electrode 12', which are columnar electrodes, are employed. This first electrode 11' and second electrode 12' are separated by a specified gap, and both are connected the pulsed power generator 8. It is possible, of course, to employ rotary electrodes as the electrodes.
Further, in the constitution of the third variation, as shown in Figures 21 & 22, the tip of the capillary 50b that supplies the liquid raw material is positioned in a space on a plane perpendicular to the optical axis, and the first laser beam 23 irradiates the liquid raw material supplied to the tip of the capillary 50b positioned in that position. For that reason, the gasified high temperature raw material (liquid raw material) does not spread in the direction of the EUV collector optics 2. Therefore, hardly any debris produced by first laser beam 23 irradiation of the high temperature plasma raw material or discharge generated in the discharge region travels toward the EUV collector optics 2.

(4) Gasified raw material release nozzle

In this invention, as stated above, the high temperature plasma raw material is gasified by irradiation with the first energy beam (energy beam for raw material) 23. The gasified high temperature plasma raw material spreads at a specified speed. By setting appropriately the supply position of the raw material with respect to the discharge region, the irradiation direction of the raw material by the first energy beam 23, and the irradiation energy of the first energy beam 23, it is possible to supply the gasified high temperature raw material to the discharge region. Such settings also make it possible to set the spatial density distribution of the gasified high temperature raw material in the discharge region to the specified distribution.

At this time, it is desirable that as much as possible of the high temperature plasma raw material that spreads toward the discharge region because of irradiation by the first energy beam 23 does reach the discharge region. It is not desirable that too much of the high temperature plasma raw material reach destinations other than the discharge region, since that would lower the extraction efficiency of EUV radiation from the high temperature plasma raw material supplied. Moreover, the portion of the high temperature plasma raw material that arrives at destinations other than the discharge region is liable to contact and deposit on low temperature portions within the EUV light source device.

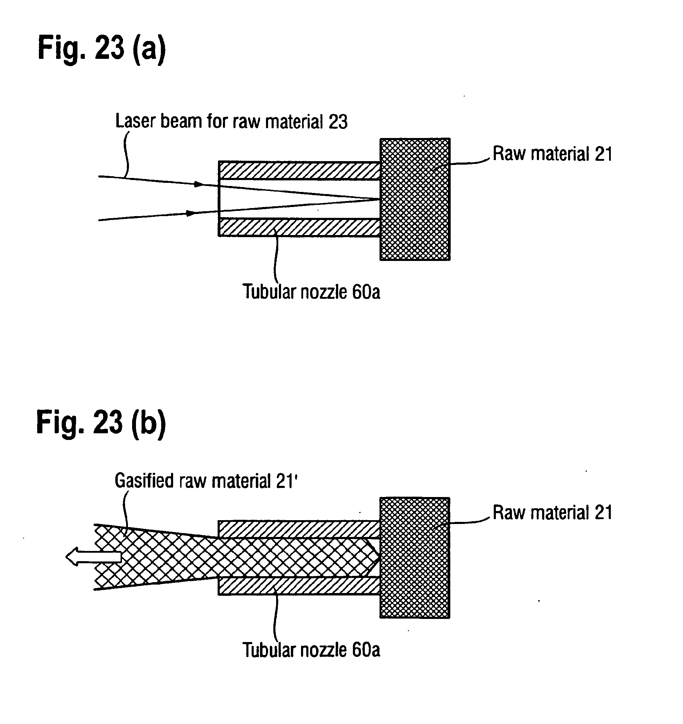

It is possible here to fit, as shown in Figure 23, a tubular nozzle to spray raw material to the position where the first energy beam 23 irradiates high temperature plasma raw material.

Figure 23 is a concept drawing of the use of a tubular nozzle.

As shown in Figure 23(a), the first energy beam 23 passes through the through hole of the tubular nozzle 60a. Having passed through the tubular nozzle 60a, the first energy beam 23 irradiates the high temperature plasma raw material 21 and gasifies the raw material. As shown in Figure 23(b), the gasified raw material 21 passes through the tubular nozzle 60a and is sprayed from the tubular nozzle 60a. The gasified raw material that sprays from the tubular nozzle 60a is limited as to its angle of spray from the tubular nozzle 60a. For that reason, it is possible to supply to the discharge region with good directionality and high density.

Now, the shape of the tubular nozzle is not limited to a straight tube as shown in Figure 23. It is acceptable to use the shape of a high-speed spray nozzle with a constriction of part of the nozzle.

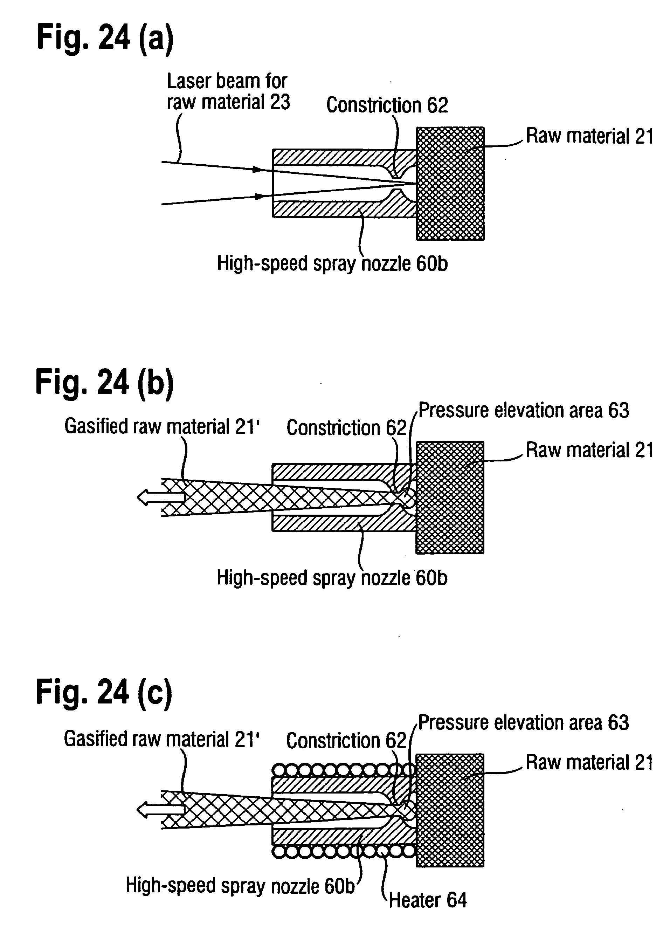

As shown in Figure 24(a), the first energy beam 23 passes through the through hole of the high-speed spray nozzle 60b. When the first energy beam 23 has passed through the high-speed spray nozzle 60b and irradiated the high temperature plasma raw material 21, the raw material is gasified. Here, a constriction 62 has been formed inside the high-speed spray nozzle 60b, and so the pressure of the gasified raw material rises sharply in the space between the constriction 62 and portion of the high temperature plasma raw material 21 irradiated by the first energy beam 23 (the pressure elevation area 63 shown in Figure 24(b)). Then, as shown in Figure 24(b), the gasified raw material is accelerated from the opening of the constriction 62, and is sprayed out as a high-speed gas flow with good directionality.

Here, the spray direction of the high-speed gas flow depends on the direction of the high-speed spray nozzle 60b. In other words, the direction of travel of the gasified raw material 21' does not depend on the direction of incidence of the first energy beam 23 on the high temperature plasma raw material 21.

Now, the cross-sectional area of the opening of the constriction 62 is small, and so it is conceivable that if the period during which the first energy beam 23 does not irradiate the high temperature plasma raw material 21 is too long, the high temperature plasma raw material will solidify and the opening will be closed up. Accordingly, it is good to heat the high-speed spray nozzle 60b with a heater 64, as shown in Figure 24(c), so that the high temperature plasma raw material 21 will not solidify within the high-speed spray nozzle 60b.

The tubular nozzle 60a and the high-speed spray nozzle 60b shown in Figures 23 & 24 can be applied to the embodiment and the various variations described previously. It is most effective, however, if the tubular nozzle 60a and the high-speed spray nozzle 60b are as close as possible to the high temperature plasma raw material 21.

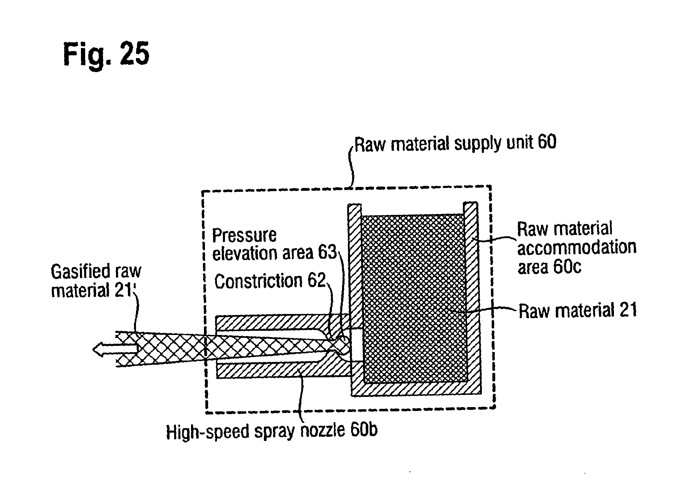

In particular, the high-speed spray nozzle 60b must be constituted with a pressure elevation area 63, and so it is desirable that the space between the constriction 62 of the high-speed spray nozzle 60b and the part of the high temperature plasma raw material 21 that is irradiated by the first energy beam 23 be constituted as air-tight as possible. For example, it is preferable to use a raw material supply unit 60 with the raw material accommodation area 6c and the high-speed spray nozzle 60b constituted as a single piece, as shown in Figure 25.

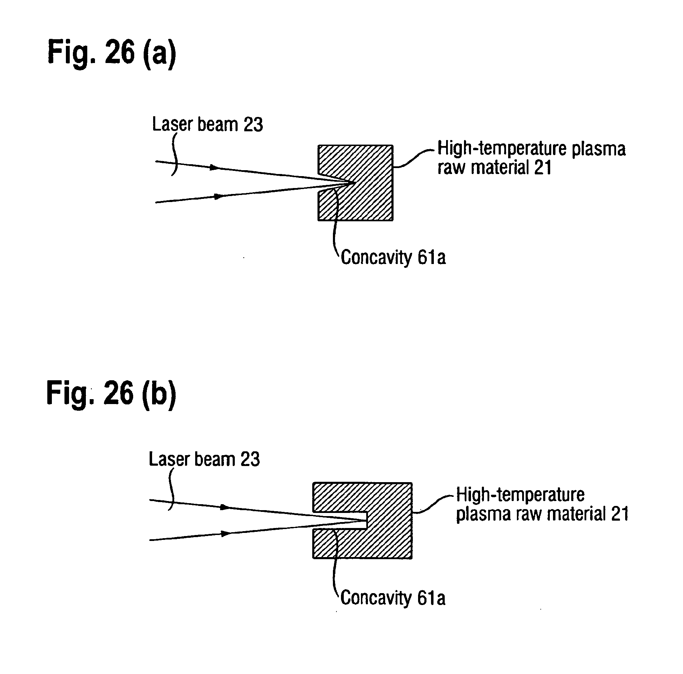

Now, the flow-control mechanism is not limited to the example noted above. It is acceptable, for example, to form a concavity 61a in advance in the solid high temperature plasma raw material 21 at the position irradiated by the laser beam 23, as in Figure 26.

When the laser beam 23 irradiates the high temperature plasma raw material 21, the high temperature plasma raw material 21 is gasified and a low temperature plasma 21' is formed. Here, the low temperature plasma that sprays out of the concavity 61a has a restricted angle of spray by the walled nozzle of concavity 61a. For that reason, a low temperature plasma gas flow with good directionality can be supplied continuously and selectively to the discharge channel.

(5) Operation of the EUV light source device in variations of the embodiment described previously

In the variations noted above, high temperature plasma raw material is supplied continuously to the irradiation position of the first laser beam (laser beam for raw material) 23. Therefore, the example of operation of the EUV light source device in these variations differs somewhat from the example of operation of the EUV light source device in the embodiment described previously.

The first variation is taken as an example below to explain the operation of the EUV light source device.

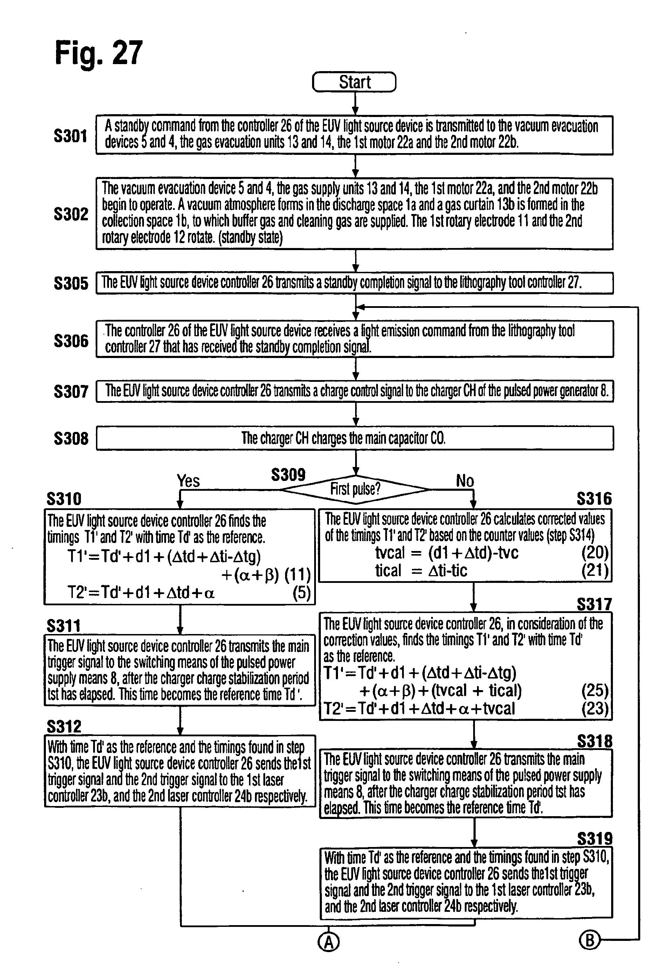

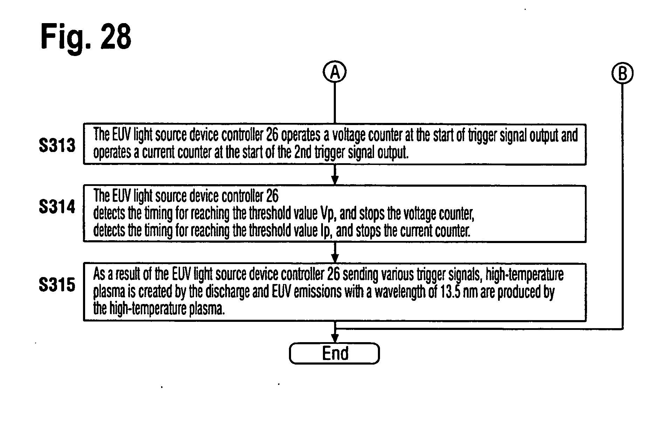

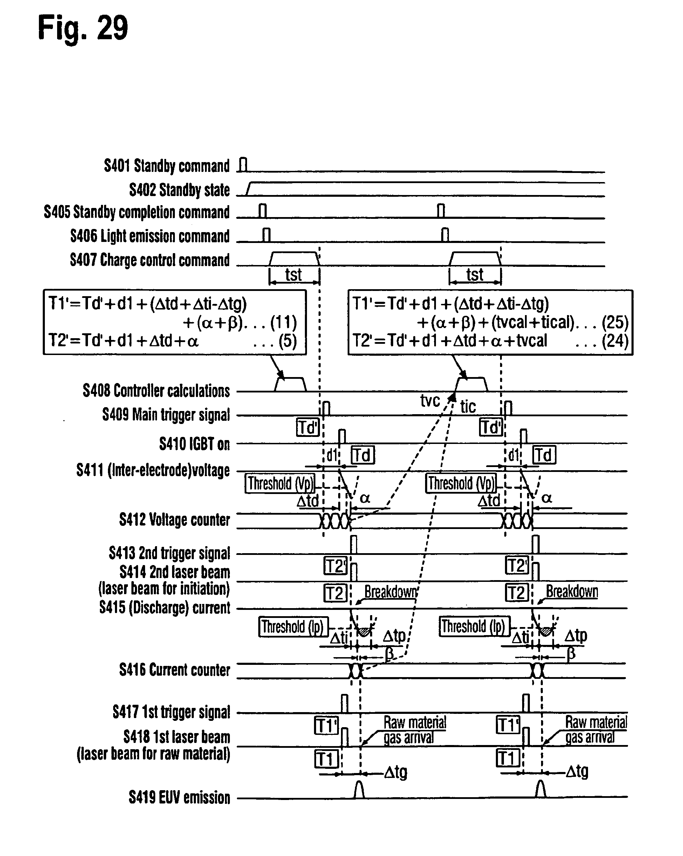

Figures 27 & 28 are flowcharts showing the operation of this embodiment, and Figure 29 is a time chart; the operation of this embodiment is explained below with reference to Figures 27 to 29. Now, there are not great differences of operation between this variation and the embodiment explained previously, and so brief explanations will be given of the portions that are the same as was explained in Figures 13 to 15.

The controller 26 of the EUV light source device stores the period data $\Delta td$, $\Delta ti$, and $\Delta tg$, as stated previously. Now as stated previously, $\Delta td$ is the period from the point when the main trigger signal is input to the switching means of the pulsed power supply means (time Td) until the switching means turns ON and the inter-electrode voltage reaches the threshold value Vp; $\Delta ti$ is the period after discharge begins until the magnitude of the current flowing between the electrodes reaches the threshold value Ip, and $\Delta tg$ is the period from the point when the first laser beam irradiates the raw material until at least a part of the gasified raw material reaches the discharge region.

Further, the relationship between the voltage V and the period $\Delta td$ is determined experimentally in advance and stored in a table. Also stored are the previously described correction periods $\alpha$ and $\beta$ and the delay period d1 from the point when the main trigger signal is output to the switching means of the pulsed power supply means to the point when the switching means turns ON.

First, the controller 26 of the EUV light source device transmits a standby command (steps S301 of Figure 27 and S401 of Figure 29), and the vacuum evacuation devices 4, 5, the gas supply units 13, 14 and so on, having received the standby command, begin to operate, as described previously. A vacuum atmosphere comes about in the discharge space 1a by this means. Further, a buffer gas and cleaning gas are supplied to the collection space 1b, and the collection space 1b reaches the specified pressure. Further, the first motor 22a and the second motor 22b operate, and the first rotary electrode 11 and the second rotary electrode 12 rotate. Moreover, the reel 30e is driven to rotate by the drive mechanism 30d, and the raw material wire 31 is delivered from the reel 30a; a standby state is in effect (steps S302 of Figure 27 and S402 of Figure 29).

The controller 26 of the EUV light source device transmits a standby completion signal to the controller 27 of the lithography tool (steps S303 of Figure 27 and S405 of Figure 29).

The controller 26 of the EUV light source device receives a light emission command from the controller 27 of the lithography tool (steps S306 of Figure 27 and S406 of Figure 29).

After the standby state is realized, the controller 26 of the EUV light source device transmits a charge control signal to the charger CH of the pulsed power generator 8. The charge control signal comprises such things as a discharge start timing data signal, for example, and the charging voltage data signal for the main capacitor C0 is also included in this charge control signal. The controller 26 of the EUV light source device refers to the table that holds the relationship between the previously described EUV emission intensity and the charging voltage for the main capacitor C0, and determines the charging voltage data for the main capacitor C0, and it transmits a charge control signal that includes the charging voltage signal for the main capacitor C0 to the charger CH of the pulsed power generator (steps S307 of Figure 27 and S407 of Figure 29).

The charger CH charges the main capacitor C0 as described above (step S308 of Figure 27).

Next, the controller 26 of the EUV light source device decides whether the EUV emission is the first since operation began (called the "first pulse") (step S309 of Figure 27); if it is the first pulse, the process moves from step S309 to S310.

If it is not the first pulse, the process moves to step S316.

In step 310, the controller 26 of the EUV light source device calculates the timing for sending the first trigger signal to the first laser controller 23b that controls the operation of the first laser beam 23 and the timing for sending the second trigger signal to the second laser controller 24b that controls the operation of the second laser beam 24.

In the event of the first pulse, no feedback correction is possible, as stated previously, and so those timings are decided on the basis of the period data $\Delta td$, $\Delta ti$, $\Delta tg$, d1, $\alpha$, and $\beta$.

In other words, taking the previously described time Td' when the main trigger signal is output to the switching means of the pulsed power supply means as a reference, the previously described formulas (11) and (5) are used to find the timing T1' for sending the first trigger signal to the first laser controller 23b that controls the operation of the first laser source 23a and the timing T2' for sending the second trigger signal to the second laser controller 24b that controls the operation of the second laser source 24a (step S408 of Figure 29).

By this means, it is possible, taking the time Td when the main trigger signal is input to the switching means of the pulsed power supply means as a reference, to set the time periods for irradiation of the first laser beam and the second laser beam.

Next the controller 26 of the EUV light source device, after passage of the charger charge stabilization period tst, which is the period until the main capacitor C0 charge is stable, transmits the main trigger signal to the switching means of the pulsed power supply means. This timing is Td' (steps S311 of Figure 27 and S409 of Figure 29).

The controller 26 of the EUV light source device, taking the time Td' for sending the main trigger signal as a reference, transmits the first trigger signal and the second trigger signal to the first laser controller 23b and the second laser controller 24b, respectively, at the timing T1' for sending the first trigger signal to the first laser controller 23b and the timing T2' for sending the second trigger signal to the second laser controller 24b that were found in step 310 using formulas (11) and (5) (steps S312 of Figure 27 and S413, S417 of Figure 29).

Further, as described previously, the controller 26 of the EUV light source device operates the voltage counter, which measures from the beginning of the output of the main trigger signal until the inter-electrode voltage reaches the threshold value Vp, and the current counter, which measures from the beginning of the output of the second trigger signal until the discharge current reaches the threshold value Ip (steps S313 of Figure 28 and S410, S412 of Figure 29).

Now, the voltage counter and the current counter, as previously stated, have the purpose of providing feedback control in order to regularize the period for inter-electrode voltage to reach the threshold value Vp after the main trigger signal is output and the period for the discharge current to reach the threshold value Ip after the second trigger signal is output. In other words, the timing T1' for sending the first trigger signal and the timing T2' for sending the second trigger signal are, for the first iteration (first pulse), decided on the basis of formulas (5) and (11), as stated above, and on the second and subsequent iterations they are decided on the basis of values that are corrections of the formulas (5) and (11) based on the count values of the voltage counter and the current counter.

The controller 26 of the EUV light source device detects the timing, from an unillustrated voltage monitor, at which the inter-electrode voltage reaches the threshold value Vp and stops the voltage counter. It also detects the timing, from a current counter (not shown), at which the discharge current reaches the threshold value Ip and stops the current counter (steps S314 of Figure 28 and S412, S416 of Figure 29).

Here, when the main trigger signal is sent at timing Td' in step S311, once the delay period d1 elapses after that main trigger signal is input to the switching means of the pulsed power supply means, the switching means (an IGBT, for example) turns ON (steps S409, S410 of Figure 29).

When the switching means is turned ON, the voltage between the first rotary electrode 11 and the second rotary electrode 12 rises, and after period Δtd, the inter-electrode voltage reaches the threshold value Vp. As stated above, this threshold voltage Vp is the voltage value that occurs when the value of the discharge current flowing when discharge occurs at or above the threshold value Ip (steps S410, S411 of Figure 29).

In step S312, as stated above, the second trigger signal is sent to the second laser controller 24b at the timing T2', which is based on formula (5). As a result, the discharge region is irradiated by the second laser beam (laser beam for initiation) 24 at the point T2 at or after the time (Td + Δtd) the inter-electrode voltage reaches the threshold value Vp (steps S413, S414 of Figure 29).

When the discharge region is irradiated by the second laser beam 24, discharge begins in the discharge region. The magnitude of the discharge current reaches the threshold value Ip mentioned above when Δti has passed since discharge begun (steps S414, S415 of Figure 29). This threshold value Ip is the lower limit of the discharge current value necessary to yield and EUV emission of the specified intensity.

In step S312, as stated above, the first trigger signal is sent to the first laser controller 23b at the timing T1', which is based on formula (11). As a result, the discharge region is irradiated by the first laser beam (laser beam for raw material) 23 at the point T1 when the discharge current reaches the threshold value Ip, between (T2 + Δti - Δtg) and (T2 + Δti + Δtp - Δtg) (steps S415, S417, S418 of Figure 29).

In other words, the controller 26 of the EUV light source device transmits the main trigger signal in step S311 and the first trigger signal and the second trigger signal in step S312, and as a result, the position of the discharge channel is demarcated in the specified position. Further, in the discharge channel of which the position is demarcated, when at least a part of the gasified high temperature raw material of which the spatial density distribution is the specified distribution reaches the discharge channel, discharge occurs so that the magnitude of the discharge current is above the lower limit of the discharge current value necessary to obtain an EUV emission of the specified intensity.

When a plasma is formed by this means and the plasma is heated and excited and achieves a high temperature because of a large, pulsed current flowing through the plasma, an EUV emission with a wavelength of 13.5 nm is produced from the high temperature plasma (steps S315 of Figure 28 and S419 of Figure 29).

As stated previously, the EUV radiation emitted by the plasma passes through the opening in the partition 1c and the foil trap 3, is collected by the grazing-incidence-type EUV collector optics 2 located in the collection space 1b, and guided to the irradiation optical system of the unillustrated lithography tool from the EUV radiation extraction area in chamber 1.

When the initial iteration of EUV emission is completed in this way, the process returns to step S306 and awaits a light emission command from the lithography tool. After receipt of the light emission command, the process moves through steps S307 and S308 described above to step S309. The subsequent EUV emission is not the first pulse, and so the process moves from step S309 to step S316. In step S316, the controller 26 of the EUV light source device uses formulas (20) and (21) for feedback calculation of the timing T1' for sending the first trigger signal to the first laser controller 23b and the timing T2' for sending the second trigger signal to the second laser controller 24b that controls the operation of the second laser source 24a, based on the value of the voltage counter and the value of the current counter (steps S316 of Figure 27 and S408 of Figure 29).

The controller 26 of the EUV light source device gives consideration to the correction value found in step S316 and uses the following formulas to decide, taking the time Td' for sending the main trigger signal as a reference, the timing T1' for sending the first trigger signal to the first laser controller 23b, and the timing T2' for sending the second trigger signal to the second laser controller 24b that controls the operation of the second laser source 24a (steps S317 of Figure 27 and S408 of Figure 29).

$$T2' = Td' + d1 + \Delta td + \alpha + tvcal \qquad (24)$$

$$T1' = Td' + d1 + (\Delta td + \Delta ti - \Delta tg) + (\alpha + \beta) + (tvcal + tical) \qquad (25)$$

After the charger charge stabilization period tst, which is the period until the charge in the main capacitor C0 is stable, has elapsed, the controller 26 of the EUV light source device transmits the main trigger signal. This timing is taken as Td' (steps S318 of Figure 27 and S409 of Figure 29).

Then, taking the point Td' when the main trigger signal was sent to the switching means of the pulsed power supply means as a reference, the first trigger signal and the second trigger signal are transmitted to the first laser controller 23b and the second laser controller 24b, respectively, at the timing T1' for sending the first trigger signal to the first laser controller 23b and the timing T2' for sending the second trigger signal to the second laser controller 24b as found from formulas (24) and (25) with the time Td' as a reference (steps S319 of Figure 27 and S413, S417 of Figure 29).

Next, the process moves to step S313 of Figure 28, and as described previously, the voltage counter that measures from the beginning of output of the main trigger signal until the inter-electrode voltage reaches the threshold value Vp is made to operate, as is the current counter that measures from the beginning of the second trigger signal until the discharge current reaches the threshold value Ip (steps S410, S412 of Figure 29).

Then, the timing when the inter-electrode voltage reaches the threshold value Vp is detected by means of an unillustrated voltage monitor, and the voltage counter is stopped. Further, the timing when the discharge current reaches the threshold value Ip is detected by means of an unillustrated current monitor and current counter is stopped (steps S314 of Figure 28 and S412, S416 of Figure 29).

Here, in step S311, the main trigger signal is sent at the timing Td' and the switching means is turned ON as described previously (steps S409, S410 of Figure 29); after $\Delta td$, the inter-electrode voltage reaches the threshold value Vp (steps S410, S411 of Figure 29).

In step S312, the second trigger signal is sent to the second laser controller 24b at the timing T2' based on formula (5) and the second laser beam (laser beam for initiation) 24 irradiates the discharge region at the point T2 on or after the point (Td + $\Delta td$) when the inter-electrode voltage reaches the threshold value Vp (steps S413, S414 of Figure 29).

Irradiating the discharge region with the second laser beam starts discharge in the discharge region, and when $\Delta ti$ has passed since the discharge begun, the magnitude of the discharge current reaches the threshold value Ip noted above (steps S414, S415 of Figure 29.)

In step S312, as stated above, the first trigger signal is sent to the first laser controller 23b at the timing T1' based on formula (11). As a result, at time T1 during the period from (T2 + $\Delta ti$ - $\Delta tg$) to (T2 + $\Delta ti$ + $\Delta tp$- $\Delta tg$), the first laser beam (laser beam for raw material) 23 irradiates (steps S415, S417, S418 of Figure 29).

By this means, the position of the discharge channel is demarcated in the specified position as a result of the controller 26 of the EUV light source device transmitting the various trigger signals in steps S318 and S319.

Further, in a state in which at least a part of the gasified high temperature raw material of which the spatial density distribution is the specified distribution has arrived at the discharge channel of which the position has been demarcated, discharge occurs in which the magnitude of the discharge current is above the lower limit of the discharge current value necessary to yield EUV radiation of the specified intensity.

The discharge occurs between the peripheral edge portions of the first rotary electrode 11 and the second rotary electrode 12, and a plasma is formed. By means of the large, pulsed current that flows through the plasma, the plasma is heated and excited and produces high temperature plasma. EUV radiation with a wavelength of 13.5 nm (steps S315 of Figure 28 and S419 of Figure 29). The EUV radiation emitted by the plasma passes through the opening in the partition 1c and the foil trap 3, is collected by the grazing-incidence-type EUV collector optics 2 located in the collection space 1b, and guided to the irradiation optical system of the unillustrated lithography tool from the EUV radiation extraction area in chamber 1.

Then, the process is repeated from step S306 to step S315 while the lithography process continues. When the lithography process is completed, this process ends after step S315.

By means of the operations above, as stated previously, the spatial density distribution of the gasified high temperature raw material supplied to the discharge region by irradiation with the first laser beam 23 can be set to produce EUV radiation as efficiently as possible. Further, by focusing the second laser beam 24 on a specified position in the discharge region, it is possible to demarcate the position of the discharge channel in the position set by the laser focal point, as well as starting the discharge. Because of this, the positional stability of the EUV emission point of generation is improved.

The irradiation timing of the first laser beam 23 and the irradiation timing of the second laser beam 24 are set as described above, and so, in a state in which at least a part of the gasified high temperature raw material of which the spatial density distribution is the specified distribution has arrived at the discharge channel of which the position has been demarcated, discharge occurs in which the magnitude of the discharge current is above the lower limit of the discharge current value. As a result, efficient EUV emission can be realized.

Further, feedback control is performed to regularize the period after output of the main trigger signal until the inter-electrode voltage reaches the threshold value Vp and the period after output of the second trigger signal until the discharge current reaches the threshold value Ip, and so it is possible to reliably realize efficient EUV radiation even if variation occurs in the operation of the semiconductor switching element used as the solid switch SW that is the switching means of the pulsed power supply means.

(6) Adjustment irradiation

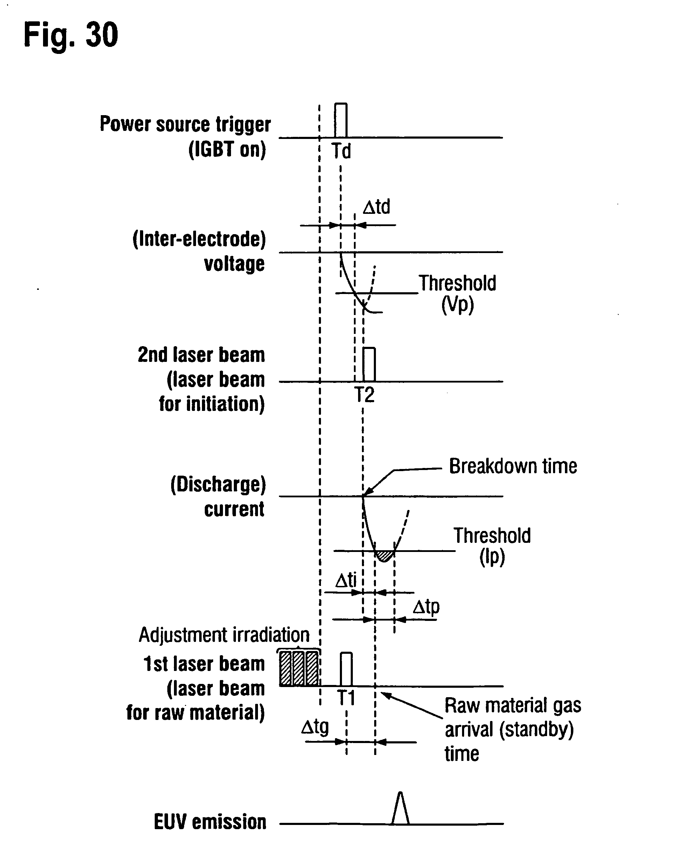

It is acceptable to perform adjustment irradiation of the first energy beam 23 in order to facilitate the generation of a discharge between the discharge electrodes. A brief explanation of a strategy for improving the discharge start-up characteristics follows. In the EUV light source device embodiment shown in Fig. 9 and Fig. 10 mentioned above, for example, the execution procedure of the adjustment irradiation is explained. A timing chart for the case of implementation of adjustment irradiation is shown in Figure 30.

In the EUV light source device shown in the embodiment described previously, the timing of irradiation of the first laser beam (laser beam for raw material) 23 for raw material supply and the timing of the second energy beam (laser beam for initiation) 24 are set appropriately so that the discharge current of the discharge that occurs in the discharge region will be at or above the specified threshold value when at least part of the gasified high temperature raw material with the specified spatial density distribution arrives at the discharge region, as stated above.

In this procedure, before first laser beam (laser beam for raw material) 23 of which the timing is set appropriately with the second laser beam 24 irradiates, the first laser beam 23 irradiates the high temperature plasma raw material at least one time.

In the example shown in Figure 30, before first laser beam 23 of which the timing is set appropriately with the second laser beam 24, the first laser beam 23 irradiates three times. This kind of laser beam irradiation is called "adjustment irradiation."

When adjustment irradiation is implemented, the gasified high temperature raw material arrives at the discharge region. The first laser beam (laser beam for raw material) 23 that is adjustment irradiated is not correlated with the second laser beam 24 for discharge initiation and the second laser beam 24 is not irradiated, and so a part of the gasified high temperature plasma raw material that reaches the discharge region adheres to the first electrode 11 and the second electrode 12.

In this state, when the second laser beam 24 irradiates the specified position in the discharge region, a part of the high temperature plasma raw material that has adhered to the first discharge electrode 11 and the second discharge electrode 12 that are positioned in the vicinity of the discharge region is gasified. The gasified raw material contributes to the discharge, and so the reliable generation of a discharge between the discharge electrodes is facilitated. In other words, the start-up characteristics of the discharge are improved.

Now, because a part of the high temperature plasma raw material that has adhered to the discharge electrodes 11, 12 that are positioned in the vicinity of the discharge region is gasified, at least a part of the second energy beam must irradiate the portion of high temperature plasma raw material that has adhered to the discharge electrodes 11, 12.

3. Pulse lengthening

Pulse lengthening of EUV radiation in this invention is explained next.

The following explanation concerns (1) the basic constitution of an EUV light source device that implements the EUV radiation generating method of this invention, (2) the EUV generation procedures of this invention, (3) irradiation timing of the energy beams (laser beams), (4) the raw material supply system (5) the flow-control mechanism, (6) the inter-relationship of the electrode position, the high temperature plasma raw material position, and energy beam (laser beam) irradiation position, (7) the energy of the raw material gasification energy beam, and (8) an example of the concrete constitution. The explanation takes laser beams as an example of energy beams, but such things as electron beams are also acceptable for the energy beams.

(1) Basic constitution of an EUV light source device that implements the EUV radiation generating method of this invention

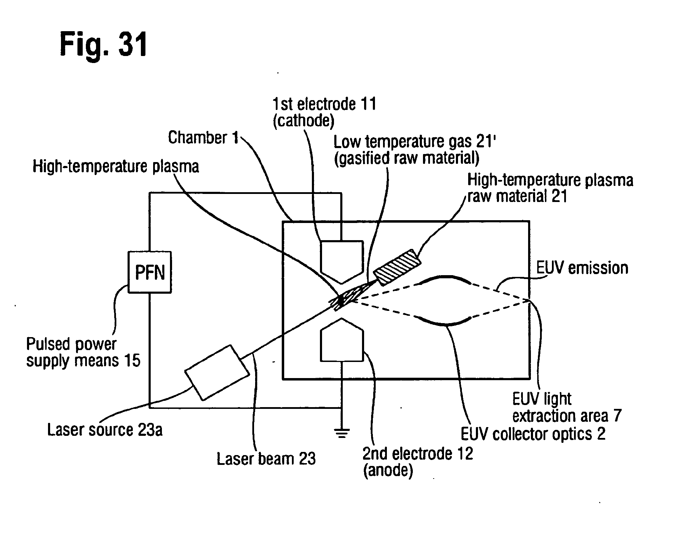

An example of the basic constitution is explained first. Figure 31 shows an example of the basic constitution of an EUV light source device that is pulse-lengthened on the basis of this invention.

In the figure, a first electrode 11 and a second electrode 12 are installed within a chamber 1, which is the discharge vessel. The first electrode 11 is the cathode, for example, the second electrode 12 is the anode, and the second electrode 12 is grounded. That is, a high, negative voltage is applied between the electrodes.

The two electrodes are connected to a pulsed power supply means 15. The PFN (Pulse Forming Network) circuit type, for example, is adopted for the pulsed power supply means 15 in order to run a current with a long pulse width between the two electrodes.

High temperature plasma raw material 21 is set in place in the vicinity of the paired electrodes but outside the discharge region. Metals such as tin (Sn) or lithium (Li) can be used as the high temperature plasma raw material 21. These can be either solid or liquid. Figure 31 shows a schematic example in which the high temperature plasma raw material 21 is a solid metal.

A laser source 23a is used to produce a low temperature plasma (gasified high temperature raw material). A laser beam 23 emitted from the laser source 23a is guided within the chamber 1 and irradiates the solid or liquid high temperature plasma raw material 21. The irradiation energy of the laser is of a level to gasify the solid or liquid high temperature plasma raw material but not to raise the electron temperature much, in a range from $10^8$ W/cm$^2$ to $10^{19}$ W/cm$^2$, for example.

When the laser beam irradiates the high temperature plasma raw material 21, at least a part of the high temperature plasma raw material 21 is gasified and sprayed out as low temperature plasma 21'. By setting the conditions of the irradiating laser beam appropriately, it is possible to have the gasified high temperature raw material (low temperature plasma 21') spray out from the solid, for example, raw material 21 continuously for a period of about 10 $\mu$s.

As stated above, the low temperature plasma is in a state with an ion density of about $10^{17}$ cm$^{-3}$ to $10^{20}$ cm$^{-3}$ and with an electron temperature that does not exceed about 1 eV, constituted so as to be supplied selectively to a discharge channel formed in advance between the electrodes.

Now, the discharge channel is made narrow by the self-magnetic field of the discharge current. The vapor of material that sprays from a solid material or a liquid material because of laser irradiation generally travels while expanding in three dimensions. Therefore, the low temperature plasma gas that sprays out from the high temperature plasma raw material 21 is controlled into a steady flow with good directionality by means of a flow control mechanism, illustration of which has been omitted. Now, the example of the flow-control mechanism is explained later.

(2) EUV generation procedures of this invention

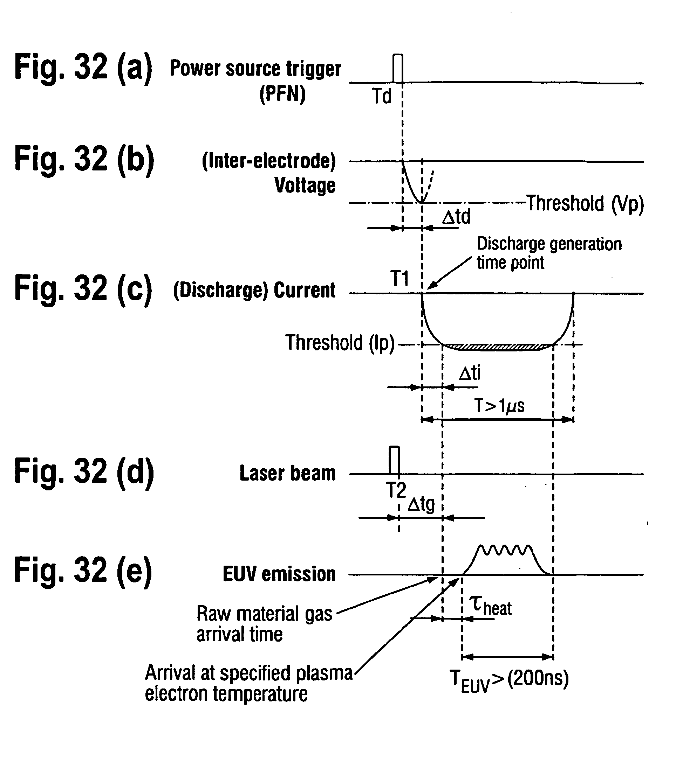

The EUV generation procedures of this invention are explained with reference to the timing chart shown in Figure 32. The multi-pinch method is taken as an example.

First, a trigger signal is input (time Td) to the switching means of the pulsed power supply means (an IGBT, for example) of the pulsed power supply means 15 that applies pulsed power between the paired electrodes 11, 12 ((a) in Figure 32), and the switching means is turned ON.

Accompanying that, the inter-electrode voltage rises ((b) in Figure 32). Then discharge occurs at the point T1 (= Td + $\Delta$td) when the voltages reaches a threshold value Vp ((c) in Figure 32). The discharge is generated by the action of a discharge start-up means, illustration of which has been omitted from Figure 31. The threshold value Vp is the voltage value when the value of the discharge current that flows when discharge is generated is at or above the threshold value Ip (or Ip2 in the case of the non-pinch method). That is, if discharge occurs at less than the threshold value Vp, the peak value of the discharge current will not reach the threshold value Ip or Ip2.

At time point T1 the discharge current begins to flow between the electrodes, and a discharge channel is formed. Then, at the point when $\Delta$ti has elapsed (T1 + $\Delta$ti), the value of the discharge current reaches the threshold value Ip. This threshold value Ip, as noted above, is set so that $P_B$ » Pp (formula (104), stated previously) when $P_B$ is the compression pressure due to the self-magnetic field inherent to the current and Pp is the pressure of the plasma. In other words, it is the current value capable of adequately compressing the low temperature plasma gas by means of the self-magnetic field.

Now, the threshold value Ip is a current value having energy capable of heating low temperature plasma gas (the ion density in the plasma is about $10^{17}$ to $10^{20}$ cm$^{-3}$ and the electron temperature is about 1 eV) to between 20 and 30 eV or more.

At the time (T1 + $\Delta$ti), moreover, the diameter of the discharge channel flowing through the discharge region is sufficiently narrow.

A laser beam irradiates the high temperature plasma raw material located outside the discharge region at or after this time (T1 + $\Delta$ti), so that at least a part of the low temperature plasma gas having an ion density corresponding to EUV emission conditions and a low electron temperature will have reached the narrow discharge channel selectively ((d) in Figure 32). Taking the period from the point when the laser beam irradiates the high temperature plasma raw material until at least a part of the low temperature plasma gas reaches the discharge channel as $\Delta$tg, a laser beam irradiates the high temperature plasma raw material at time point T2, which is time point (T1 + $\Delta$ti - $\Delta$tg) or thereafter. Figure 32 shows a case in which the time point T2 = (T1 + $\Delta$ti - $\Delta$tg).

After the period $\tau_{heat}$ which begins at the time point (T1 + $\Delta$ti = T2 + $\Delta$tg), the electron temperature of the low temperature plasma gas reaches 20 eV to 30 eV under the action of the discharge, and it becomes a high temperature plasma; EUV emission from this high temperature plasma begins ((e) in Figure 32).

Because low temperature plasma gas with an ion density corresponding to EUV emission conditions and a low electron temperature is supplied continuously to the narrow discharge channel, the pinch effect or the confinement effect of the self-magnetic field occurs repeatedly. Therefore, the diameter of the narrow discharge channel shows a pulsating action, narrowing and broadening, but it is kept in a relatively narrow state. In other words, the pinch effect of the low temperature plasma is repeated and EUV emission continues.

The EUV radiation produced in the discharge region are reflected by the EUV collector optics 2 and released to an unillustrated irradiation area from the EUV extraction area 7.

The period for which EUV emission is maintained under the conventional DPP method or LAGDPP method using the pinch effect is, for example, 200 ns or less. Here, it becomes possible to pulse-lengthen the EUV emission relative to the conventional DPP method or LAGDPP method using the pinch effect by setting the discharge circuit, which comprises the pulsed power supply means 15 and the paired electrodes (first electrode 11 and second electrode 12), so that the period for which the discharge channel at the threshold value Ip is maintained continues from the point (T1 + $\Delta$ti = T2 + $\Delta$tg) when a part of the low temperature plasma gas arrives at the narrow discharge channel for (200 ns + $\tau_{heat}$).

Under the conventional DPP method or LAGDPP method using the pinch effect, the duration of the discharge channel is 1 $\mu$s or less, and when the initial plasma is pinched, the duration of the EUV emission (period A in Figure 39) is 200 ns or less at the longest.

It was learned, as a result of experimental verification by the present inventors, that when the duration of the discharge channel is at least 1 $\mu$s or more, it is possible to reliably prolong the period that the discharge channel continues with a current value at or above Ip or at or above Ip2 beyond 200 ns. That is, when the duration of the discharge channel is set to 1 $\mu$s or more, it is possible to reliably prolong the duration of the EUV emission beyond the conventional EUV emission duration (200 ns)

Now, in the case of the non-pinch method, pulse lengthening of the EUV emission will be realized by the same mechanism as described above if the threshold value is set to be Ip2, and so detailed explanation of that is omitted.

In this invention, there is no need to run a large current through the discharge space as in the EUV emission pulse-lengthening method of WO 2006/120942 A1 and JP-A-2007-123138, in which the plasma current waveform is controlled by maintaining a pinched state. Further, there is no need to change the waveform of the plasma current I shown in Figure 40(a), and so the discharge current (plasma current) waveform in this method has no polarity reversal point.

(3) Irradiation timing of the energy beams (laser beams)

In the EUV generation procedure described above, the timing with which the laser beam irradiates the high temperature plasma raw material is set so that at least a part of the low temperature plasma gas reaches the narrow discharge channel at or after the time when the value of the discharge current has reached the threshold value Ip.

Consider the case in which at least a part of the low temperature plasma gas reaches the narrow discharge channel before the value of the discharge current has reached the threshold value Ip (case A) and the case in which, following the discharge, at least a portion of the low temperature plasma gas before the plasma is generated reaches the region where the discharge channel is produced (case B).

In case A and case B, the low temperature plasma gas cannot be heated sufficiently until the discharge current reaches the threshold value Ip, and as a result, there is an increased proportion of low temperature plasma that does not contribute to EUV radiation and the efficiency of the EUV emission drops.

Further, in case A and case B, until the value of the discharge current reaches the threshold value Ip, the low temperature plasma gas, which is the high temperature plasma raw material provided selectively as a steady flow, expands in the region where the discharge channel is produced after the discharge and its density drops. Accordingly, the density of the high temperature plasma raw material in the discharge region nears the initial conditions of the pinch in Figure 38. In such a state, the diameter of the discharge channel broadens, and so a large current is necessary as the discharge current in order to narrow the discharge channel to make a high temperature plasma.

In case B, in particular, the low temperature plasma is supplied prior to discharge, and so the discharge channel is formed by a gas discharge of the high temperature plasma gas with a reduced density because of expansion, and the diameter of the discharge channel is broader than in case A. Therefore, fast, short current pulses with high power, to a degree, are required to narrow the discharge channel and make the initial plasma into a high temperature plasma by means of the pinch effect (close to path 2 in Figure 38).

In this invention, as stated above, a discharge circuit is formed to prolong the duration of the discharge channel, and so it is difficult to realize the current pulses that are required in case B.

Therefore, it is important to set the timing of laser beam irradiation of the high temperature plasma raw material so that at least a part of the low temperature plasma gas arrives at the narrow discharge channel at least after discharge has begun (case A) and preferably at or after the point when the value of the discharge current reaches the threshold value Ip, as shown in Figure 32.

(4) Raw material supply system

In this invention, as stated above, irradiation of high temperature plasma raw material with a laser beam or other energy beam produces a low temperature plasma gas with an ion density corresponding to EUV emission conditions and a low electron temperature (ion density from $10^{17}$ cm$^{-3}$ to $10^{20}$ cm$^{-3}$; electron temperature not exceeding 1 eV), and supplies that low temperature plasma to the discharge region. Figure 31 shows a schematic example in which the high temperature plasma raw material is a solid metal, but as stated above, it is acceptable for the high temperature plasma raw material to be a liquid.

As an example of the constitution of a raw material supply system that uses a solid high temperature plasma raw material to supply low temperature plasma gas to the discharge region, that shown schematically in Figure 31 is constituted to irradiate with a laser beam a solid metal (Sn, for example) placed in a specified region in the vicinity of the discharge region.

Another example is constituted to use two reels to supply a high temperature plasma raw material formed as a wire to a space from which the low temperature plasma gas formed by laser beam irradiation can reach a specified region and to irradiate that high temperature plasma raw material wire with a laser beam.

As an example, on the other hand, of the constitution of a raw material supply system that uses a liquid high temperature plasma raw material to supply low temperature plasma gas to the discharge region, there is that constituted so as to put the liquid high temperature plasma raw material into droplet form, to supply it by dropping to a space from which the low temperature plasma gas formed by laser beam irradiation can reach a specified region, and to irradiate that high temperature plasma raw material in the form of droplets with a laser beam when the high temperature plasma raw material in the form of droplets reaches the space noted above.

Now, as an example using a solid high temperature plasma raw material, it is possible to constitute the electrodes themselves of solid high temperature plasma raw material (Li, for example) as described in WO 2006/120942 A1, irradiate the electrodes with the laser beam to create low temperature plasma gas, and supply that low temperature plasma gas to the discharge channel.

The constitution described in JP-A-2007-505460 and corresponding US 2007/0090304 A1 is possible as a further example of the use of a high temperature plasma raw material in liquid form. That is, the electrodes are structured as rotary electrodes, and a heated "metal melt" liquid high temperature plasma raw material is accommodated in containers. Part of the rotary electrodes (the peripheral part) is submerged in the containers that accommodate the liquid high temperature plasma raw material. Then, by rotating the electrodes, the liquid high temperature plasma raw material that adheres to the peripheral surfaces of the electrodes is delivered to the discharge region. Irradiating this transported liquid high temperature plasma raw material with a laser beam produces a low temperature plasma gas, and the low temperature plasma gas is supplied to the discharge channel.

Nevertheless, this constitution is one in which the high temperature plasma raw material is located in the discharge region; producing low temperature plasma gas and supplying it to the discharge region on the basis of such a method is not desirable for the following reasons.

In the case of the constitutions described in JP-A-2007-505460 and corresponding US 2007/0090304 A1 and WO-A-2006/120942, the plasma (or neutral vapor) produced when a laser beam irradiates the electrode surface can be a vehicle to start discharge, Therefore, the supply of low temperature plasma gas is done in advance of the discharge, which increases the proportion of low temperature plasma that does not contribute to EUV radiation, as stated above, and the efficiency of EUV emission drops.

Further, the low temperature plasma gas is provided before discharge, and so gas discharge of high temperature plasma raw material that has expanded and decreased in density causes a discharge channel to form, and the diameter of the discharge channel broadens. Therefore, current with power that is high, to a degree, becomes necessary to narrow the discharge channel and form a high temperature plasma.

Further, in addition to supply by laser beam irradiation, the supply of low temperature plasma gas to the discharge channel can be done by vaporizing the electrode itself (or a liquid high temperature plasma raw material adhered to the electrode) by raising the temperature of the electrode by means of the drive current that accompanies advancement of the electrode.

Accordingly, the parameters of the low temperature plasma gas change from moment to moment depending on the discharge current, and the output of EUV radiation fluctuates. Because of fluctuation of the discharge channel during discharge, moreover, the position of the high temperature plasma fluctuates and the apparent size of the high temperature plasma increases.

These drawbacks come about because the high temperature plasma raw material and the electrode are united and the supply of low temperature plasma gas depends on both the laser beam irradiation and the discharge current (plasma current).

In this invention, therefore, the high temperature plasma raw material and the electrode are separate and the supply of low temperature plasma gas depends on laser beam irradiation only; it is independent of the discharge current. In other words, the raw material supply system is constituted so that control of the supply of low temperature plasma gas and control of the drive current that flows between the electrodes are mutually independent, as in the example of constitution shown in Figure 31 and other examples of constitution (wire and droplet forms) discussed previously.

(5) Flow-control mechanism

The low temperature plasma gas, as stated above, is constituted so that it is supplied selectively to the discharge channel that is narrowed by the self-magnetic field after the discharge is generated. Normally the material vapor sprayed out from the solid material or liquid material by laser beam irradiation travels while expanding in three dimensions. Therefore, when the low temperature plasma gas is made to spray out by laser beam irradiation of a solid or liquid high temperature plasma raw material, a flow with good directionality is constituted by means of flow control of the flow of spraying low temperature plasma gas, and the flow is set to be supplied continuously, concentrated on the narrow discharge channel vicinity.

Those shown in Figures 23-25 can be used as flow-control mechanisms to control the flow of spraying low temperature plasma gas noted above. The flow-control mechanism can also be constituted as shown in Fig. 26.

(6) Inter-relationship of the electrode position, the high temperature plasma raw material position, and energy beam (laser beam) irradiation position

In this invention, as stated above, the low temperature plasma is caused to arrive at the discharge channel by a laser beam. The positional relationship is as shown in Figure 4, for example.

That is, a pair of plate-shaped electrodes 11, 12 is separated by a specified gap. The discharge channel is produced in the discharge region positioned in the gap space of the paired electrodes 11, 12.

The low temperature plasma gas 21' that is gasified and produced by irradiation of the high temperature plasma raw material 21 with the laser beam 23 spreads in the direction of laser incident. For that reason, the low temperature plasma gas 21' can be supplied to the discharge channel produced in the discharge region by means of laser beam 23 irradiation of the high temperature plasma raw material 21 surface that faces the discharge region.

As stated previously, of the low temperature plasma gas supplied to the discharge region by laser beam irradiation, a portion that does not contribute to the formation of high temperature plasma by the discharge or a portion of the clusters of gas in atomic form dissociated as an effect of plasma formation will contact the lower temperature portions within the EUV light source device and accumulate as debris.

Here, as shown in Figure 4(b), in the event that the high temperature plasma raw material 21 is supplied to the paired electrodes 11, 12 on a side that does not face the EUV collector optics 2, then as stated previously, the low temperature plasma gas 21' produced by laser beam irradiation will spread in the direction of the discharge channel and the EUV collector optics 2, and debris will be released toward the EUV collector optics 2. Therefore it is preferable to locate the high temperature plasma raw material 21 in the space between the paired electrodes 11, 12 and the EUV collector optics 2, facing the space in the vicinity of the discharge region, as shown in Figure 4(a).

When the laser beam 23 irradiates high temperature plasma raw material 21 placed in this way on the side of the surface of the high temperature plasma raw material that faces the discharge region, as described above, the low temperature plasma gas 21' spreads in the direction of the discharge region, but it does not spread in the direction of the EUV collector optics 2.

Now, the high temperature plasma raw material 21 is placed in the vicinity of the discharge region in a space on a plane perpendicular to the optical axis, as shown in Figure 5, and the low temperature plasma gas 21' does not spread in the direction of the EUV collector optics 2, even though the laser beam 23 irradiates the high temperature plasma raw material 21 from a direction perpendicular to the optical axis. Therefore, hardly any of the debris generated by laser beam irradiation of the high temperature plasma raw material 21 or by discharge between electrodes 11, 12 travels toward the EUV collector optics 2.

(7) Energy of the raw material gasification energy beam

As stated previously, the period $\Delta$tg from the point when the laser beam irradiates the high temperature plasma raw material until at least a part of the low temperature plasma gas reaches the discharge channel depends on the positions of discharge channel and the high temperature plasma raw material, the direction of laser beam irradiation of the high temperature plasma raw material, and the irradiation energy of the laser beam; it can be set to the specified time by appropriate setting of these parameters.

As explained above, in the EUV generating method of this invention, a narrow discharge channel is formed in the discharge region in advance and a steady flow of low temperature plasma gas with an ion density corresponding to EUV emission conditions and a low electron temperature (ion density from $10^{17}$ cm$^{-3}$ to $10^{20}$ cm$^{-3}$; electron temperature not exceeding 1 eV) is selectively supplied to the narrow discharge channel from outside the discharge region.

The timing of the supply of low temperature plasma gas here is set so that the low temperature plasma gas (ion density from $10^{17}$ to $10^{20}$ cm$^{-3}$; electron temperature not exceeding 1 eV) arrives at the narrow discharge channel at or after the point when the value of the discharge current reaches the threshold value (Ip or Ip2).

As a result, the discharge acts on the low temperature plasma gas and, passing through path II of figure 6, high temperature plasma that fulfills the EUV emission conditions is formed and EUV radiation is produced.

Here, low temperature plasma gas is supplied to the discharge channel and EUV radiation are realized through path (II) of figure 6, and so a large discharge current is not necessary as in the conventional DPP method and the LAGDPP method; EUV emission is made possible by running a relatively small current through the discharge region. It is possible, moreover, to input energy into the plasma efficiently, without implementing fast and short pulses of discharge current as in the prior art. Therefore, discharge current pulses can be set longer than in the prior art.

The EUV emission continues while a discharge channel that is narrow, to some degree, is maintained. Therefore, by constituting the discharge circuit so that discharge current pulses are longer than in the conventional DPP method or LAGDPP method and pulse-lengthening the discharge current pulses, it is possible to prolong the duration of the narrow discharge channel relative to the prior art, and longer pulses of EUV emission can be realized as a result.

In the multi-pinch method, the threshold value Ip is set so that $P_B \gg Pp$ as expressed in formula (104) above, when $P_B$ is the compression pressure due to the self-magnetic field inherent to the current and Pp is the pressure of the plasma.

In other words, the threshold value Ip is the current value at which adequate compression of the low temperature plasma gas by the self-magnetic field is possible. Now, the threshold value Ip is the current value that has energy capable of heating the electron temperature of the low temperature plasma gas to between 20 eV and 30 eV or more. Here, the diameter of the discharge channel that runs through the discharge region is narrowed sufficiently at the point when the value of the discharge current becomes Ip.

Supplying low temperature plasma to the narrow discharge channel continuously enables repetition of the pinch effect or the confinement effect of the self-magnetic field. At this time the diameter of the narrow discharge channel narrows and broadens in a pulsating action, but it is maintained in a relatively narrow state.

This sort of repetition of the pinch effect or the confinement effect of the self-magnetic field sustains the period that the discharge current continues.

In this invention, as described above, the discharge current pulse can be set longer than in the prior art and it is possible to maintain a continuous pinch effect or confinement effect of the self-magnetic field for a long period, and so it is possible to realize pulse-lengthening of the EUV emission (multi-pinch method).

In the non-pinch method, moreover, the threshold value Ip2 is set to PB $\geqq$ Pp, as represented in formula (105) above. In other words, Ip2 is the current value that compresses the low temperature plasma gas weakly (at a level where the low temperature plasma does not lose ion density by expanding). Now, the threshold value Ip2 described above is the value of current that has energy capable of heating the low temperature plasma gas to an electron temperature of 20 eV to 30 eV or more. Here, the diameter of the discharge channel through the discharge region is narrowed at the point when the discharge current reaches Ip2.

As a result of supplying low temperature plasma gas to the narrow discharge channel continuously, the low temperature plasma gas is heated while being maintained at a level where it does not lose ion density by expanding and becomes a high temperature plasma, and EUV is emitted by this high temperature plasma.

This heating of low temperature plasma gas, while maintaining its ion density, is sustained as long as the discharge current continues. In this invention, as stated above, the discharge current pulse can be set longer than in the prior art and the plasma temperature and density necessary for EUV emission can be maintained for a long period by heating the low temperature plasma, and so it is possible to realize pulse-lengthening of the EUV emission (non-pinch method).

Now, the diameter of the discharge channel is greater in the non-pinch method than in the multi-pinch method, and so the size of the high temperature plasma is also greater than in the multi-pinch method.

It was learned, as a result of experimental verification by the present inventors, that when the duration of the discharge channel is at least 1 $\mu$s or more, it is possible to reliably prolong the period that the discharge channel continues with a current value at or above Ip or at or above Ip2 beyond 200 ns. That is, when the duration of the discharge channel is set to 1 $\mu$s or more, it is possible to reliably prolong the duration of the EUV emission beyond the conventional EUV emission duration (200 ns).

There is no need, as stated above, for the large current or the fast and short pulses of discharge current seen in the conventional DDP and LAGDPP methods. Consequently, it is possible to reduce the thermal load on the electrodes relative to that of the prior art, and it becomes possible to suppress the occurrence of debris.

In this invention, moreover, there is no need to control the plasma current waveform in order to maintain the pinch effect of high temperature plasma, as in the pulse-lengthening technology of the prior art, and so there is no need to run a large current through the discharge space. Further, there is no need to change the waveform of the plasma current, and so highly precise current control is unnecessary. In other words, the discharge current (plasma current) waveform in this method has no polarity reversal point.

Further, it is preferable to constitute the raw material supply system so that control of the supply of low temperature plasma and control of the drive current between the electrodes are mutually independent.

With such a constitution, the supply of low temperature plasma is unaffected by the discharge current (plasma current), and so EUV emission stability is improved.

Moreover, it is desirable to place (or supply) the high temperature plasma raw material between the paired electrodes and the EUV collector optics and to irradiate the laser beam toward the surface of the high temperature plasma raw material on the side that faces the discharge region.

When this is done, the low temperature plasma gas will spread in the direction of the discharge region, but it will not spread in the direction of the EUV collector optics. Therefore, it becomes possible to control the travel of debris toward the EUV collector optics.

A specific example of the constitution of a pulse-lengthened EUV light source device is explained next.

As stated above, the EUV emission method of this embodiment is one in which low temperature plasma gas is supplied steadily to a narrow discharge channel established in advance, and the pulse width of EUV emission is pulse-lengthened by setting the discharge current pulse longer than in the prior art.

Accordingly, after a low temperature plasma gas is obtained, the vacuum arc discharge gradually moved to a gas discharge. That is, a narrow discharge channel of gas discharge is finally established, and low temperature plasma gas is selectively supplied to this narrow discharge channel of the gas discharge.

Here, the position in which the discharge channel of the gas discharge is formed is not necessarily the same as the position where the vacuum arc discharge channel was formed. Sometimes the position of the gas discharge channel changes with the shift from vacuum arc discharge to gas discharge.

In other words, although the discharge channel of the gas discharge is formed in the vicinity of the position of the discharge channel of the vacuum arc discharge, there is not necessarily high precision in the stability of the position of the gas discharge channel.

In the event that the EUV light source is used as a light source for lithography, high stability of the EUV light source is sought. That is, greater precision of the positional stability of the discharge channel during gas discharge is sought.

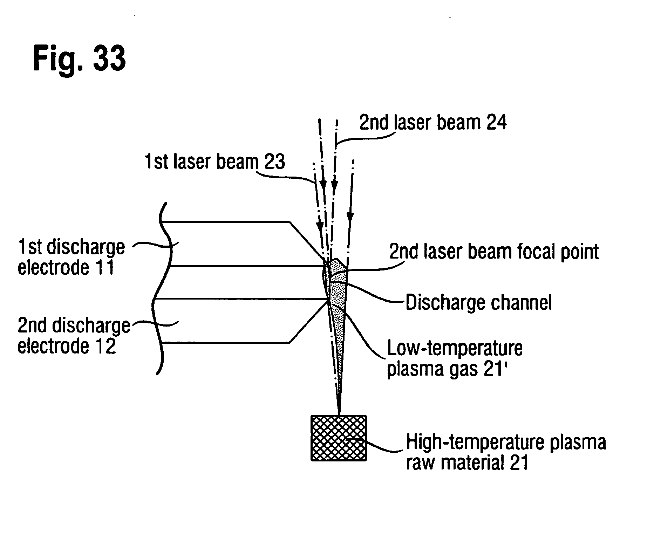

Figure 33 shows the state at the beginning of discharge between the electrodes in this example of embodiment; in this embodiment discharge between the electrodes begins when at least a part of the low temperature plasma has arrived.

As shown in Figure 33, a part of the low temperature plasma gas produced by first laser beam irradiation of the high temperature plasma raw material reaches the discharge region, and the discharge region is filled with low temperature plasma gas that is somewhat low in density, at which point the second laser beam is focused on a specified position in the discharge region and discharge begins. As stated above, the discharge region is filled with low-density, low temperature plasma gas, and so the discharge becomes a gas discharge at this time.

Here, conductivity in the vicinity of the focal point of the second laser beam is increased by the release of electrons. Therefore, the position of the discharge channel of the gas discharge is demarcated at the position where the laser focal point is set. In other words, the position of the gas discharge is demarcated by the second laser beam.

In such an EUV radiation method shown in this embodiment, the position of the gas discharge channel itself is demarcated, and so it is possible to realize higher precision of the positional stability of the discharge channel in the gas discharge.

(8) Example of the constitution of the pulse-lengthened EUV light source device of this invention

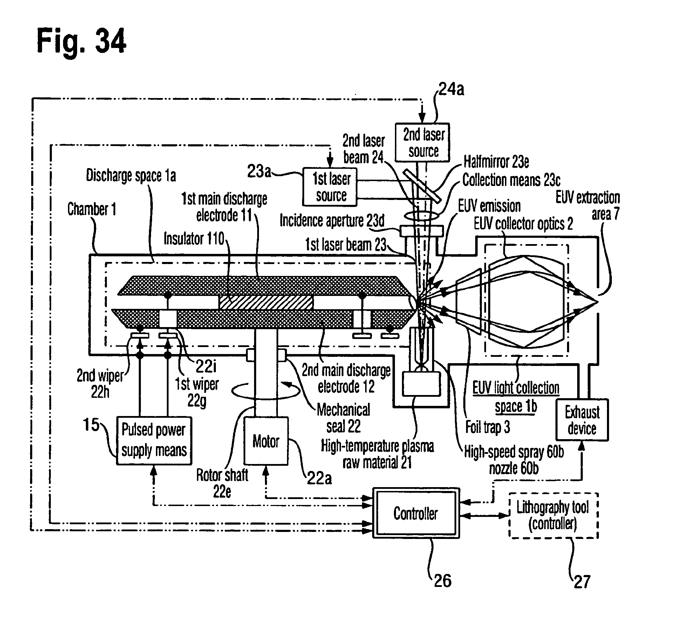

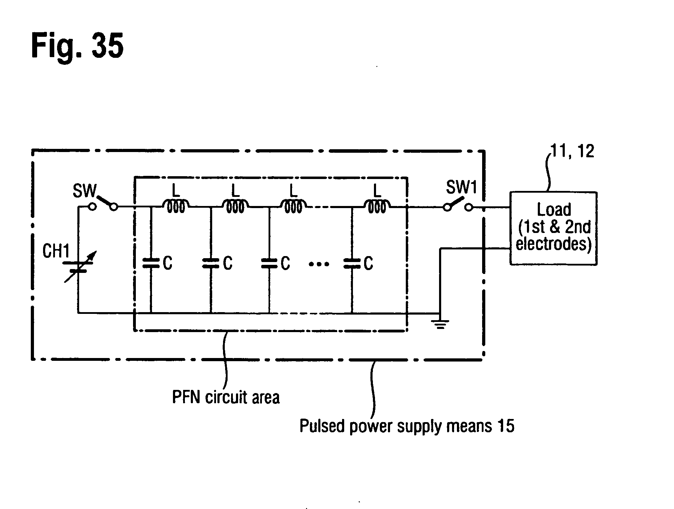

Figures 34 & 35 show an embodiment of an EUV light source device using the extreme ultraviolet radiation (EUV) generating method of this invention.

Figure 34 is a diagram of the EUV light source device mentioned above; EUV radiation are extracted from the right side of the figure. Figure 35 is an example of the constitution of the pulsed power supply means in Figure 34.

The EUV light source device shown in Figure 34 has a chamber 1 that is the discharge vessel. Within the chamber 1 there are a discharge space 1a, where high temperature plasma is produced by inputting power into the low temperature plasma gas mentioned above, and an EUV radiation collection space 1b, where the EUV radiation emitted by the high temperature plasma is collected and guided to the irradiation optical system of the lithography tool, illustration of which has been omitted, from an EUV extraction area 7 installed in the chamber 1. The chamber 1 is connected to an evacuation device 5, and a reduced-pressure atmosphere within the chamber 1 is created by this evacuation device.

The constitution of various areas is explained below.

(a) Discharge area

The discharge area 1a comprises a first discharge electrode which is a metal disk, a second discharge electrode 12 which is similarly a metal disk, and an insulator 110 sandwiched between them. The center of the first discharge electrode 11 and the center of the second discharge electrode 12 are placed on roughly the same axis, and the first discharge electrode 11 and the second discharge electrode 12 are fixed in positions separated by the thickness of the insulator 110. Here, the diameter of the second discharge electrode 12 is larger than the diameter of the first discharge electrode 11. Now, the first discharge electrode 11 and the second discharge electrode 12 rotate, and so they are called rotary electrodes hereafter.

The second discharge electrode 12 is fitted to the rotor shaft 22e of a motor 22. Here, the second discharge electrode 12 is fitted to the rotor shaft 22e so that the center of the first discharge electrode 11 and the center of the second discharge electrode 12 are positioned on roughly the central axis of the rotor shaft 22e.

The rotor shaft 22e is introduced into the chamber 1 by way of a mechanical seal 22c, for example. The mechanical seal 22c allows the rotor shaft 22e to rotate while maintaining a reduced-pressure in the chamber 1.

A first wiper 22g and a second wiper 22h, constituted of carbon brushes, for example, are fitted to the under side of the second discharge electrode 12. The second wiper 22h is electrically connected to the second discharge electrode 12. The first wiper 22g, on the other hand, is electrically connected to the first discharge electrode 11 by way of through holes 22i that penetrate the second discharge electrode 12.

Now, an insulation mechanism, illustration of which has been omitted, is constituted to prevent dielectric breakdown between the second discharge electrode 12 and the first wiper 22g that is electrically connected to the first discharge electrode 11.

The first wiper 22g and the second wiper 22h are electrical contacts that maintain electrical connection while wiping, and are connected to the pulsed power supply means 15. The pulsed power supply means 15 supplies power, by way of the first wiper 22g and the second wiper 22h, between the first discharge electrode 11 and the second discharge electrode 12.

That is, even though operation of the motor 22a rotates the first discharge electrode 11 and the second discharge electrode 12, power from the pulsed power supply means 15 is applied, by way of the first wiper 22g and the second wiper 22h, between the first discharge electrode 11 and the second discharge electrode 12.

The pulsed power supply means 15, as shown in Figure 31, includes a PFN circuit area and applies pulsed power with a relatively long pulse width, for example, between the first discharge electrode 11 and the second discharge electrode 12 which are the load. Now, the wiring between the pulsed power supply means 15 and the first wiper 22g and the second wiper 22h goes through insulated current introduction terminals, illustration of which has been omitted. The current introduction terminals are fitted to the chamber 1 and enable electrical connection from the power supply means to the first wiper 22g and the second wiper 22h while maintaining a reduced-pressure atmosphere in chamber 1.

The peripheral portions of the first discharge electrode 11 and the second discharge electrode 12, which are metal disks, are constituted with an edge shape. As shown hereafter, when power is applied to the first discharge electrode 11 and the second discharge electrode 12 by the power supply means 15, a discharge is generated between the edge-shaped portions of the electrodes. As the discharge grows, the electrodes attain a high temperature, and so the first discharge electrode 11 and the second discharge electrode 12 are made of a metal with a high melting point, such as tungsten, molybdenum or tantalum. Moreover, the insulator 110 is made of something such as silicon nitride, aluminum nitride, or diamond.

When a discharge to produce EUV radiation is generated, the first and second discharge electrodes 11, 12 are rotated. By this means, the position on the electrodes where the discharge is generated changes with each pulse. Therefore, the thermal load imposed on the first and second discharge electrodes 11, 12 can be made smaller, the speed of discharge electrode wear can be reduced, and the service life of the discharge electrodes can be prolonged.

(b) Power supply means

Figure 35 shows an example of the equivalent circuit of the power supply means 15. The equivalent circuit of the power supply means 15 shown in Figure 35 comprises a charger CH1, a solid switch SW, a PFN circuit area with an LC distributed parameter circuit with n stages of a capacitor C and a coil L in a cascade connection, and a switch SW1. The example of operation of the power supply means is as follows. First, the charging voltage of the charger CH1 is adjusted to a set value Vin. Thus, when the solid switch SW is turned ON, the n capacitors C of the PFN circuit are charged, and a voltage is applied between the first main discharge electrode and the second main discharge electrode when the switch SW1 is turned ON.

Thereafter, current flows between the electrodes when a discharge occurs between the electrodes. Here, the circuit loops formed by the individual capacitors C and the load have differing individual impedances, and so the cycles of current flowing in the individual circuit loops differ from one another. The currents that flow in individual circuit loops overlap, and there is a current pulse with a long pulsewidth between the electrodes as a result.

(c) Low temperature plasma gas supply means

In Figure 34, the means for supplying low temperature plasma gas comprises high temperature plasma raw material 21, a laser source 23a that irradiates this high temperature plasma raw material 21 with a laser beam 23, and a high-speed spray nozzle 60b that is the flow-control means that controls a steady flow of low temperature plasma gas spraying from the high temperature plasma raw material with good directionality.

The high temperature plasma raw material 21 is located in a space on a plane that is roughly perpendicular to the optical axis of the EUV collector optics 2, and in the vicinity of the discharge region between the first discharge electrode 11 and the second discharge electrode 12. Placement of the high-speed spray nozzle 60b is set so that the low temperature plasma gas sprayed from the nozzle is provided selectively to the region where a narrow discharge channel is produced in the discharge region.

Because of such placement of the high temperature plasma raw material 21 and the high-speed spray nozzle 60b, the low temperature plasma gas provided to the discharge channel does not spread in the direction of the EUV collector optics 2. Therefore, hardly any debris produced by laser beam 23 irradiation of the high temperature plasma raw material 21 and by discharge generated between the electrodes travels toward the EUV collector optics 2.

The high-speed spray nozzle 60b is a tubular piece with a constriction inside, as shown in Figure 24(a). When the laser beam 23 that passes into the high-speed spray nozzle irradiates the high temperature plasma raw material 21, the high temperature plasma raw material 21 is gasified and low temperature plasma gas is produced. Here, the constriction is fitted inside the high-speed spray nozzle 60b, and so when the space between the constriction and the high temperature plasma raw material is irradiated by the laser beam, there is a sharp increase in pressure because of the low temperature plasma gas. Thus, the low temperature plasma gas is accelerated by the opening of the constriction and is sprayed out as a high-speed gas flow with good directionality. Here, the spray direction of the high-speed gas flow depends on the direction of the high-speed spray nozzle. That is, the direction of travel of the gasified raw material does not depend on the direction of laser beam incidence on the high temperature plasma raw material.

The laser beam 23 from the laser source 23a is incident to the high temperature plasma raw material by way of a half mirror 23e, a collection means 23c, and an incidence aperture 23d fitted in the chamber 1.

Further, the wavelength of the second laser beam 24 from the second laser source 24a is set in a wavelength region to which the half mirror 23e is transparent; the second laser beam 24 passes through the half mirror 23e, the collection means 23c, and an incidence aperture 23d and is collected to a specified position in the discharge space.

The first laser beam 23, which has its wavelength set to a wavelength reflected by the half mirror, is reflected by the half mirror which is positioned with an incline of about 45°. Then, because the direction of incidence on the half mirror 23e of the second laser beam 24, the wavelength of which is set to a wavelength to which the half mirror 23e is transparent, is almost the same as the direction of reflection of the first laser beam 23, it is possible for both to use the same incidence aperture 23d in the chamber 1.

Such things as a Q-switched $ND^+$-YAG laser device, for example can be used as the first laser source 23a that emits the first laser beam 23 and the second laser source 24a that emits the second laser beam. Either the wavelength of the first laser beam 23 or the wavelength of the second laser beam 24 can undergo wavelength conversion by a wavelength conversion element.

As stated previously, at the point when a part of the low temperature plasma gas produced by first laser beam 23 irradiation of the high temperature plasma raw material 21 reaches the discharge region and the discharge region is filled with the low temperature plasma gas with a somewhat low density, the second laser beam 24 is focused on a specified position in the discharge region and discharge begins.

Accordingly, it is necessary to irradiate the high temperature plasma raw material 21 with the first laser beam 23 prior to discharge; in the event that the first laser beam 23 irradiates the high temperature plasma raw material 21 while a high voltage from the power supply means 15 is applied between the first discharge electrode 11 and the second discharge electrode 12, a discharge may be triggered by the first laser beam 23. For that reason, it is necessary that application of the high voltage between the first discharge electrode 11 and the second discharge electrode occur after the first laser beam 23 has been emitted by the first laser source 23a.

(d) EUV emission collection area

The EUV emission from the discharge space 1a is collected by grazing-incidence-type EUV collector optics 2 in the EUV emission collection space 1b, and is guided to the irradiation optical system of lithography tool, illustration of which has been omitted, from the EUV extraction area 7 in the chamber 1.

The EUV collector optics 2 have multiple mirrors that are ellipsoids of revolution or paraboloids of revolution of different diameters, for example. These mirrors are located on the same axis, with their central axes of revolution overlapping so that their focal points are in approximately the same position; their smooth reflective surfaces have nickel (Ni), for example, as the base material, coated with a fine metallic film of ruthenium (Ru), molybdenum (Mo) or rhodium (Rh), and they can reflect EUV radiation well at a grazing incidence from 0° to 25°.

Now, the discharge space 1a is shown as larger than the EUV radiation collection space 1b in Figure 34, but that is for ease of understanding; the actual size relationship is not shown in Figure 34. In reality, the EUV radiation collection space 1b is larger than the discharge space 1a.

(e) Debris trap

A debris trap, which captures debris such as metal power produced by spattering of the peripheral portions of the first and second discharge electrodes 11, 12 by the high temperature plasma and debris from the Sn or Li radiating species and which allows only the EUV radiation to pass through, is located between the discharge space 1a and the EUV radiation collection space 1b in order to prevent damage to the EUV collector optics 2.

In the EUV light source device shown in Figure 34, a foil trap 3 is adopted as the debris trap. The foil trap 3 is, for example, what is described as a "foil-trap" in U.S. Patent 6,359,969. So that the foil trap will not block EUV emitted by the high temperature plasma, the foil trap comprises multiple plates placed in the radial direction of the region where high temperature plasma is generated and ring-shaped supports that support these plates. The foil trap 3 is installed between the discharge space 1a and the EUV collector optics 2. Pressure within the foil trap is increased over that of the surrounding atmosphere, and so debris that passes through the foil trap loses kinetic energy due to the effect of that pressure. Therefore, it is possible to reduce damage to the EUV collector optics by reducing the energy of debris that collides with the EUV collector optics.

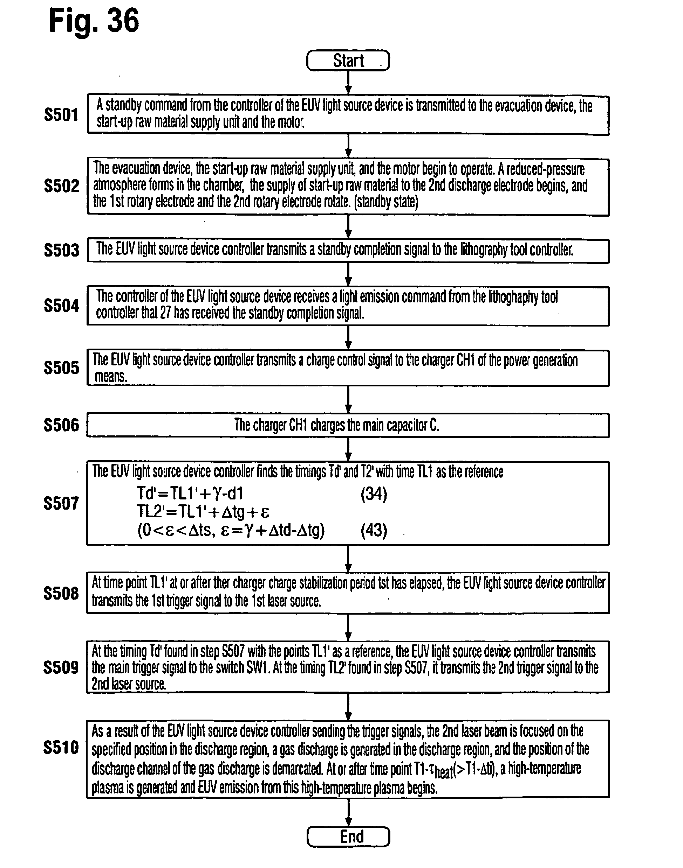

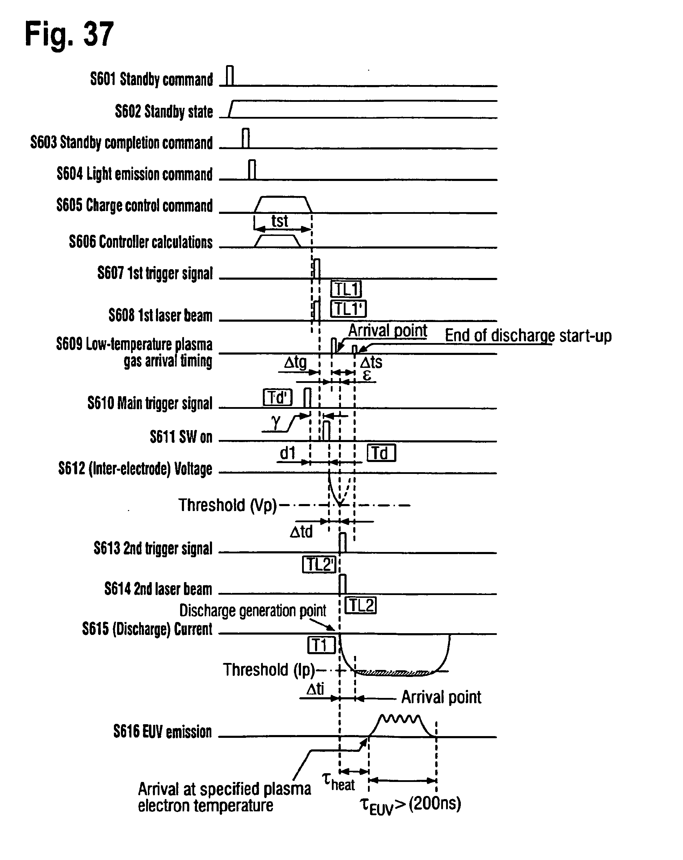

The action of the EUV light source device is explained below with reference to figures 36 and 37. The multi-pinch method is used in this example.

The controller 26 of the EUV light source device has stored the period data $\Delta td$, $\Delta tg$, $\Delta ts$, $\gamma$, and $\delta$.

$\Delta td$ is the period from the point (Td) when a trigger signal is input to SW1, which is the switching means of the power supply means 15, until the switching means is in an ON state and the inter-electrode voltage reaches the threshold value Vp. $\Delta tg$ is the period from the point when the first laser beam irradiates the high temperature plasma raw material until at least a part of the low temperature plasma gas reaches the discharge region. $\Delta ts$ is the period, taking the point when at least a part of the low temperature plasma gas reaches the discharge region as a reference, until the density of the low temperature plasma gas in the discharge region is in the range where a gas discharge can be started by a laser trigger.

On the other hand, $\gamma$ and $\delta$ are correction periods, to be explained in detail later.

Generally speaking, the larger the voltage V applied to the discharge electrodes 11, 12 is, the more quickly the voltage waveform between the discharge electrodes 11, 12 rises. Therefore, $\Delta td$ depends on the voltage V applied to the discharge electrodes 11, 12. The controller 26 of the EUV light source device has the relationship between the voltage V and $\Delta td$, as determined experimentally beforehand, stored in a table.

The controller 26 also has stored the delay period d1 from the point when the main trigger signal is output to the switch SW, which is the switching means of the power supply means 15, until the switching means turns ON.

First, a standby command from the controller 26 of the EUV light source device is transmitted to the evacuation device 5 and the motor 22a (steps S501 of Figure 36 and S601 of Figure 37).

Having received the standby command, the evacuation device 5 begins operation. That is, the evacuation device 5 operates and a reduced-pressure atmosphere is formed within the chamber 1. Moreover, the motor 22a operates, and the first rotary (discharge) electrode 11 and the second rotary (discharge) electrode 12 rotate. The operational states described above are collectively called the "standby" state hereafter (steps S502 of Figure 36 and S602 of Figure 37).

The controller 26 of the EUV light source device transmits a standby completion signal to the controller 27 of the lithography tool (steps S503 of Figure 36 and S603 of Figure 37).

The controller 26 of the EUV light source device receives a light emission command from controller 27 of the lithography tool that has received the standby completion signal. Now, in the event that the intensity of the EUV emission is controlled by the lithography tool, this light emission command includes the EUV emission intensity data (steps S504 of Figure 36 and S604 of Figure 37).

The controller 26 of the EUV light source device transmits a charge control signal to the charger CH1 of the power supply means 15. The charge control signal comprises such things as discharge start-up timing signals, for example. In the event that the intensity of the EUV emission is controlled by the lithography tool, as described above, this charge control signal includes the charging voltage data signals for each of the capacitors C of the PFN circuit area of the power supply means 15.

For example, the relationships between the intensity of EUV emission and the charging voltage of each capacitor C can be determined experimentally beforehand and a table created to hold the relationships between the two. The controller 26 of the EUV light source device, having stored this table, calls up the charging voltage data for each capacitor C of the PFN circuit area from the table, on the basis of the EUV emission intensity data included in the light emission command received from the controller 27 of the lithography tool. On the basis of this called data, the controller 26 of the EUV light source device transmits a charge control signal that includes charging voltage data signals for each capacitor C to the charger CH1 of the power supply means (steps S505 of Figure 36 and S605 of Figure 37).

The charger CH1 charges each capacitor C as described above (steps S505 of Figure 36 and S605 of Figure 37).

The controller 26 of the EUV light source device calculates the timing for outputting the main trigger signal to the switch SW1 of the power supply means 15, taking the timing for outputting the first trigger signal to the first laser source 23a as a reference. These timings are decided on the basis of the period data d1 that was stored in advance. Moreover, the controller 26 of the EUV light source device calculates the timing for outputting the second trigger signal to the second laser source 24a, taking the timing for outputting the first trigger signal to the first laser source 23a as a reference. These timings are decided on the basis of the period data d1, $\Delta tg$, $\Delta ts$, and $\Delta td$ that was stored in advance (steps S507 of Figure 36 and S606 of Figure 37).

Now, in reality, it is desirable that the point Td when the switch SW1, which is the switching means of the power supply means 15, is turned ON and the point TL2 when the second laser beam is emitted by the second laser source take the point TL1, when the first trigger signal is out put to the first laser source 23a and the first laser source 23a emits the first laser beam, as a reference.

In this embodiment, the delay period d1, from the point Td' when the main trigger signal is output to the switching means of the power supply means 15 to the point Td when the main trigger signal is input to the switching means of the pulsed power supply means 15 and the switching means turns ON, is determined in advance. Then the point Td when the switching means turns ON is determined by using the delay period d1 to correct the point Td' when the main trigger signal is output to the switching means of the power supply means 15.

On the other hand, the delay period d2, from the point TL1' when the first trigger signal is output until the first laser beam irradiates, is on the order of ns, small enough to ignore in the case of a Q-switched $ND^+$ -YAG laser, and is not considered here. Moreover, the delay period d3, from the point TL2' when the second trigger signal is output until the second laser beam irradiates, is on the order of ns, small enough to ignore in the case of a Q-switched $ND^+$ -YAG laser, and is not considered here. In other words, they are regarded as TL1' = TL1 and TL2' = TL2.

That is, by taking the point TL1' when the first trigger signal is output to the first laser source 23a as a reference and setting the timing Td' for outputting the main trigger signal to the switch SW1 of the power supply means 15 and the timing TL2' for outputting the second trigger signal to the second laser source 24a, it is actually possible to realize the setting of the point Td when the switch SW1, which is the switching means of the power supply means 15, turns ON and the point TL2 when the second laser beam is emitted by the second laser source 24a, taking the point TL1, when the first laser beam 23 is emitted by the first laser source 23a, as a reference.

Taking the point TL1', when the first trigger signal is transmitted, as a reference, the timing Td' for outputting the main trigger signal to the switch SW1 of the power supply means 15 can be found in the following way.

In this embodiment, discharge begins when the second laser beam 24 is focused on a specified position in the discharge region at the point when a part of the low temperature plasma gas produced by irradiating the high temperature plasma raw material 21 with the first laser beam 23 reaches the discharge region and the discharge region is filled with a somewhat low concentration of low temperature plasma gas.

It is necessary, therefore, to irradiate the high temperature plasma raw material 21 with the first laser beam 23 prior to the discharge. Here, if the first laser beam 23 were to irradiate the high temperature plasma raw material 21 while a high voltage from the power supply means was applied between the first discharge electrode 11 and the second discharge electrode 12 which are the load, the first laser beam 23 would pass through the vicinity of the discharge region, and so a discharge would be triggered by the first laser beam 23. In other words, in the event that a portion of the first laser beam 23 irradiates the discharge electrodes 11, 12, thermions would be released from the irradiated discharge electrodes and discharge would begin.

For this reason, it is necessary that the high voltage be applied between the first discharge electrode 11 and the second discharge electrode 12 after the first laser beam 23 is emitted by the first laser source 23a.

In other words, when the point TL1, when the first laser beam 23 is emitted from the first laser source 23a, is taken as a reference, the point Td when the switch SW1, which is the switching means of the power supply means 15, is turned ON becomes

$$Td \geqq TL1 \qquad\qquad (30)$$

Therefore, when the point TL1' when the first trigger signal is transmitted is taken as the reference, the timing Td' for sending the main trigger signal to the switch SW1 of the power supply means becomes

$$Td' + d1 \geqq TL1' + d2 \qquad\qquad (31)$$

Here, the delay period d2 is so small that it can be ignored, and so the timing for sending the main trigger signal becomes

$$Td' + d1 \geqq TL1' \qquad\qquad (32)$$

In this embodiment, the point Td when the main trigger signal is transmitted and the switch SW1 turns ON is set so that the point Td is delayed slightly beyond the point TL1 when the first laser beam is to be emitted, in order that voltage will be applied only after the first trigger signal has been transmitted and the first laser beam 23 has reliably been emitted. Defining this delay period as the correction period γ, formula (32) is converted to

$$Td' + d1 = TL1' + \gamma \qquad\qquad (33)$$

That is, if the point TL1' when the first trigger signal is transmitted is taken as the reference, then the timing Td' for sending the main trigger signal to the switch SW1 of the power supply means becomes

$$Td' = TL1' + \gamma - d1 \qquad\qquad (34)$$

When the main trigger switch has been transmitted and the switch SW1 is in the ON state, the inter-electrode voltage rises. Here, discharge must be generated at or after the point T1 (= Td + Δtd) when the inter-electrode voltage has reached the threshold value Vp. As stated above, the threshold value Vp is the voltage value when the value of the discharge current flowing when a discharge is generated is at or above the threshold value Ip or Ip2.

In other words, if a discharge occurs below the threshold value Vp, the peak value of the discharge current will not reach the threshold value Ip or Ip2.

In this embodiment, discharge begins when the second laser beam is focused on a specified position in the discharge region. Therefore, the timing TL2 for emitting the second laser beam must be set at or after the point T1 when the inter-electrode voltage has reached the threshold value Vp.

That is,

$$TL2 \geqq Td + \Delta td \qquad\qquad (35)$$

Accordingly, the relationship between the timing TL2' for sending the second trigger signal and the timing Td' for sending the main trigger signal becomes

$$TL2' \geqq Td' + d1 + \Delta td \qquad (36)$$

On the other hand, in this embodiment discharge begins when the second laser beam 24 is focused on a specified position in the discharge region at the point when part of the low temperature plasma gas produced by irradiating the high temperature plasma raw material 21 with the first laser beam 23 reaches the discharge region and the discharge reason is filled with a somewhat low concentration of low temperature plasma gas. As stated above, a steady flow of low temperature plasma gas is generated from the high temperature plasma raw material 21 by first laser beam 23 irradiation.

Immediately after the point when the first of the steady flow of low temperature plasma gas arrives at the discharge region (the point when at least part of the low temperature plasma gas arrives at the discharge region), the density of the low temperature plasma gas that occupies the discharge region is slight and, triggered by second laser beam 24 irradiation, a gas discharge plasma is generated.

Because the steady flow continues, however, the density of the low temperature plasma gas occupying the discharge region increases with the passage of time and reaches a specified level (for example, ion density from $10^{17}$ $cm^{-3}$ to $10^{20}$ $cm^{-3}$). In this case, it is difficult to generate a gas discharge even with the second laser beam 24 as a trigger, and either no discharge is generated or a spark discharge is generated by the voltage increase. In other words, the start of discharge cannot be controlled by the second laser beam 24 and it is not possible to demarcate the position of the discharge channel.

Therefore, irradiation of the second laser beam 24 must be done while the density of the low temperature plasma gas occupying the discharge region is somewhat low.

Taking the time when at least a part of the low temperature plasma gas arrives at the discharge region as a reference, and where $\Delta ts$ is the period when the low temperature plasma gas density in the discharge region is in the range where a gas discharge can be started by a laser trigger and $\Delta tg$ is the period from the point when the first laser beam irradiates the high temperature plasma raw material until at least a part of the low temperature plasma gas arrives at the discharge region, the timing TL2 for emitting the second laser beam 24 must satisfy the following formula.

$$TL1 + \Delta tg \leqq TL2 \leqq TL1 + \Delta tg + \Delta ts \qquad (37)$$

Therefore, the relationship between the timing TL2' for sending the second trigger signal and the timing TL1' for sending the first trigger signal becomes

$$TL1' + \Delta tg \leqq TL2' \leqq TL1' + \Delta tg + \Delta ts \qquad (38)$$

That is, the timing TL2' for sending the second trigger signal must be set to satisfy the following formulas.

$$TL2' \geqq Td' + d1 + \Delta td \qquad (36)$$

$$TL1' + \Delta tg \leqq TL2' \leqq TL1' + \Delta tg + \Delta ts \qquad (38)$$

For ease of understanding, this can be put as

$$TL2' = Td' + d1 + \Delta td \qquad (39)$$

51

The following results from substituting formula (34) into formula (39).

$$TL2' = TL1' + \gamma + \Delta td \qquad\qquad (40)$$

Further, the timing TL2' for sending the second trigger signal is set to match the point TL1' + $\Delta$tg when at least a part of the low temperature plasma gas reaches the discharge region, following application of the correction period $\varepsilon$ (0 < $\varepsilon$ < $\Delta$ts). That is

$$TL2' = TL1' + \gamma + \Delta td \qquad\qquad (40)$$

$$TL2' = TL1' + \Delta tg + \varepsilon \qquad (0 < \varepsilon < \Delta ts) \qquad (41)$$

The relationship between the correction period $\varepsilon$ and the correction period $\gamma$ becomes

$$\varepsilon = \gamma + \Delta td - \Delta tg \qquad\qquad (42)$$

In other words, in this embodiment, the timing TL2' for sending the second trigger signal is set as follows.

$$TL2' = TL1' + \Delta tg + \varepsilon \qquad (0 < \varepsilon < \Delta ts, \, \varepsilon = \gamma + \Delta td - \Delta tg) \qquad (43)$$

By setting the timing TL2' for sending the second trigger signal as in formula (43), the second laser beam will irradiate during the time range when the inter-electrode voltage has reached Vp and the density of the low temperature plasma gas in the discharge region is such that a laser-triggered gas discharge can begin.

The controller 26 of the EUV light source device sets the time point TL1' at or after the point when the charger charge stabilization period tst, which is the period until the charge in each capacitor C becomes stable, has elapsed, and transmits the first trigger signal to the first laser source 23a at that point TL1' (steps S508 of Figure 36 and S605, S607 of Figure 37).

The controller 26 of the EUV light source device transmits the main trigger signal to the switch SW1 at the timing Td' for transmitting the main trigger signal when the time TL1', which was set in step S607, is the reference. It also sends the second trigger signal to the second laser source 24a at the timing TL2' for sending the second trigger signal when the point TL1'is the reference (steps S509 of Figure 36 and S610, S613 of Figure 37).

The first laser beam 23 irradiates the high temperature plasma raw material 21 at almost the same time that the first trigger signal is transmitted in step S608 (S607, S608 of Figure 37).

When the first laser beam irradiates the high temperature plasma raw material, a steady flow of low temperature plasma gas is generated from the high temperature plasma raw material, and after period $\Delta$tg a part of the low temperature plasma gas reaches the discharge region (S609 of Figure 37).

As stated above, in step 609 the main trigger signal is sent to the switch SW1 of the power supply means 15 at timing Td' on the basis of formula (34). As a result, the switch SW1 is in an ON state after period d1, the voltage rises between the first rotary electrode 11 and the second rotary electrode 12, and after period $\Delta$td the inter-electrode voltage reaches the threshold value Vp. As stated above, this threshold voltage Vp is the voltage value in the event that the discharge current value when discharge has occurred is at or above the threshold value Ip (S610, S611, S612 of Figure 37).

In step S609, on the other hand, the second trigger signal is sent to the second laser source 24a at timing TL2' based on formula (43), as stated above.

As a result, the second laser beam 24 is focused on a specified position in the discharge region when the inter-electrode voltage reaches Vp and the density of the low temperature plasma gas in the discharge region is in a state in which a laser-triggered gas discharge can begin.

As a result, a gas discharge is generated in the discharge region. As stated above, conductivity is increased in the vicinity of the second laser beam 24 due to electron emission. Therefore, the position of the discharge channel of the gas discharge is demarcated in the position where the laser focal point was set. In other words, the position of the gas discharge is demarcated by the second laser beam (S613, S614 of Figure 37).

After $\Delta$ti has elapsed after the beginning of discharge, the magnitude of the discharge current reaches the threshold value Ip (S615 of Figure 37).

At the point T1 + $\tau_{heat}$ (> T1 + $\Delta$ti), the electron temperature of the low temperature plasma gas has reached 20 to 30 eV and it becomes a high temperature plasma; EUV emission from the high temperature plasma begins (steps S510 of Figure 36 and S616 of Figure 37).

The low temperature plasma gas begins to be supplied to the discharge region before discharge begins, and even after a narrow discharge channel of gas discharge is formed, the low temperature plasma gas continues to be supplied to this narrow discharge channel of discharge gas, and so there is repetition of the pinch effect or confinement effect of the self-magnetic field. Therefore, the diameter of the narrow discharge channel shows a pulsating action, narrowing and broadening, but it is kept in a relatively narrow state. In other words, the low temperature plasma is pinched repeatedly and the EUV emission continues.

In the conventional DDP and LAGDPP methods using the pinch effect, the period for which an EUV emission is maintained is, for example, 200 ns or less, and so by setting the discharge circuit that comprises the pulsed power supply means 15 and the paired electrodes (first electrode 11 and second electrode 12) so that the period that a discharge channel in which the current value remains at or above Ip is maintained continues for (200 ns + $\tau_{heat}$) or more from the point T1 when the discharge begins, it is possible to realize EUV emission that are pulse-lengthened relative to the conventional DDP and LAGDPP methods using the pinch effect.

The EUV emission from the high temperature plasma passes through the foil trap 3 and is collected by the grazing-incidence-type EUV collector optics 2 located in the collection space, and it is guided to the irradiation optical system of the lithography tool, illustration of which has been omitted, from the EUV extraction area 7 in the chamber 1.

In the EUV generating method of this embodiment, as in the EUV generating method of embodiment 1, it is possible to realize pulse-lengthening of the EUV radiation by the multi-pinch method and by the non-pinch method.

Moreover, it is possible to make the thermal load on the electrodes smaller than in the prior art, and to suppress the occurrence of debris. Furthermore, there is no need to run a large current through the discharge space or to change the waveform of the discharge current in order to maintain the pinch effect, as in conventional pulse-lengthening technology. In other words, there is no need for highly precise current control.

In this embodiment, in particular, the second laser beam is focused on a specified position in the discharge region at a point when a part of the low temperature plasma gas produced by first laser beam irradiation of the high temperature plasma raw material reaches the discharge region and the discharge region is filled with a somewhat low concentration of low temperature plasma gas, and this, rather than a vacuum arc discharge, starts the gas discharge.

Here, conductivity in the vicinity of the focal point of the second laser beam is increased by the release of electrons. Therefore, the position of the discharge channel for gas discharge is demarcated in the position where the focal point of the laser is set. In other words, the position of the gas discharge is demarcated by the second laser beam.

In the EUV emission method shown in this embodiment, the position of the gas discharge channel itself is demarcated, and so it is possible to realize higher precision in the positional stability of the position of the discharge channel in the gas discharge.

Now, it is desirable that the pulse width of the second laser beam that demarcates the position of the discharge channel of the gas discharge be somewhat short. If the pulse width of the second laser beam is a short pulse, the peak power of the second laser beam will be greater. In other words, there will be less ion drift in the region where the second laser beam is focused, and the degree of dissociation will be greater. Accordingly, the diameter of the discharge channel will be narrower and the boundaries of the discharge channel will be more definite. In other words, the diameter of the high temperature plasma that is the EUV emission source will be smaller, and it will be possible to provide an EUV light source device that is well-suited as a light source for lithography. The pulse width mentioned above is ideally 1 ns or less.

## Claims

1. An extreme ultraviolet light source device that comprises
   a vessel having a discharge region,
   a raw material supply means (20, 30, 40, 50) for supplying liquid or solid raw materials (21, 31) that will emit extreme ultraviolet radiation,
   a first energy beam irradiation means for gasifying the raw material (21, 31) by irradiating the raw material with a first energy beam (23) directed toward the raw material (21, 31),
   a pair of electrodes (11, 12; 11', 12') separated by a specified gap for heating and exciting the gasified raw material (21, 31) by discharge within said discharge region of the vessel and for generating a high temperature plasma,
   a pulsed power supply means (8, 15) for supplying pulsed power to the electrodes (11, 12; 11', 12'),
   a collector optical means (2) for collecting extreme ultraviolet radiation emitted from high temperature plasma generated by discharge in the discharge region of the pair of electrodes (11, 12; 11', 12'), and
   an extreme ultraviolet radiation extraction area in which the collected extreme ultraviolet radiation is extracted,

**characterized in**
**that** the raw material supply means (20, 30, 40, 50) supplies the liquid or solid raw materials (21, 31) to a space other than the discharge region and from which gasified raw material (21, 31) can reach the discharge region, **that** the first energy beam (23) is directed to the raw material (21, 31) supplied to said space from which the gasified raw material can reach the discharge region, and
**that** it comprises a second energy beam irradiation means for initiating discharge in the discharge region and for demarcating a discharge path in a specified position of the discharge region by irradiating a second energy beam (24) between the electrodes (11,12; 11', 12') on which power is applied.

2. An extreme ultraviolet light source device as described in claim 1, wherein the first energy beam irradiation means and the second energy beam irradiation means each have means for an operational timing set so that the discharge current of the discharge generated in the discharge region is at or above a specified threshold value (Ip) when at least part of the gasified raw material (21, 31) having a specified spatial density distribution reaches the discharge region.

3. An extreme ultraviolet light source device as described in claim 1 or 2, wherein the raw material supply means (20) is adapted to supply the raw material (21) by dropping it in droplet form in a gravitational direction.

4. An extreme ultraviolet light source device as described in claim 1 or 2, wherein the raw material supply means (30) is adapted to put the raw material (31) in wire form and continually move the raw material wire.

5. An extreme ultraviolet light source device as described in claim 1 or 2, wherein the raw material supply means (40) has a raw material supply disk (40b), and is adapted to supply the raw material by putting the raw material in liquid form, supplying the liquid raw material to the raw material supply disk (40b), and rotating the raw material supply disk (40b) to which the liquid raw material has been supplied to move the supplied portion of liquid raw material on the raw material supply disk (40b) to an irradiation position of the energy beam (23).

6. An extreme ultraviolet light source device as described in claim 1 or 2, wherein the raw material supply means (50) has a capillary (50b), and is adapted to supply the raw material by putting the raw material in liquid form and supplying the liquid raw material to the irradiation position of the energy beam (23) by way of the capillary (50b).

7. An extreme ultraviolet light source device as described in claim 1 or 2, wherein a tubular nozzle is placed between the first beam irradiation means and the raw material (21, 31) such that the the first energy beam (23) passes through the tubular nozzle (60a/60b) to gasify raw material (21, 31), and wherein at least part of the gasified raw material (21, 31) is sprayed by the tubular nozzle (60a, 60b).

8. An extreme ultraviolet light source device as described in claim 7, wherein a constriction (62) is provided within the tubular nozzle (60b).

9. An extreme ultraviolet light source device as described in any one of claims 1 to 8, further comprising a magnetic field impression means that applies a magnetic field to the discharge region that is roughly parallel to a direction of discharge generated between the pair of electrodes (11, 12; 11', 12').

10. An extreme ultraviolet light source device as described in any one of claims 1 to 9, wherein the electrodes are disk-shaped electrodes (11, 12) and wherein the electrodes (11, 12) are configured to be rotatingly driven so that the discharge generation position on the electrode surface changes.

11. An extreme ultraviolet light source device as described in claim 10, wherein the disk-shaped electrodes (11, 12) are placed so that edge portions on the periphery of the electrodes (11, 12) are separated by a specified gap.

12. An extreme ultraviolet light source device as described in any one of claims 1 to 11, wherein the energy beam irradiation means are lasers (23a, 24a).

13. An extreme ultraviolet light source device as described in claim 1, **characterized in that** the pulsed power supply means (8, 15) is configured to supply pulsed power of 1 μs or more to the electrodes (11, 12; 11', 12'), and wherein, after the discharge path is demarcated between the electrodes (11, 12; 11', 12') by the second energy beam irradiation means, raw material gas, having an ion density in the discharge path that is nearly the same as the ion density under extreme ultraviolet radiation emission conditions, is supplied to the discharge path.

14. An extreme ultraviolet light source device as described in claim 13, wherein the first energy beam irradiation means and the second energy beam irradiation means each have means for an operational timing set so that the discharge current of the discharge generated in the discharge region is at or above a specified threshold value (Ip) when gasified raw material having a specified spatial density distribution reaches the discharge region.

15. An extreme ultraviolet light source device as described in claim 13 or 14, wherein the raw material supply means (20) is adapted to supply the raw material (21) by dropping it in droplet form in a gravitational direction.

16. An extreme ultraviolet light source device as described in claim 13 or 14, wherein the raw material supply means (30) is adapted to put the raw material (31) in wire form and continually move the raw material wire.

17. An extreme ultraviolet light source device as described in claim 13 or 14, wherein the raw material supply means has a raw material supply disk (40b), and is adapted to supply the raw material by putting the raw material in liquid form, supplying the liquid raw material to the raw material supply disk(40b), and rotating the raw material supply disk (40b) to which the liquid raw material has been supplied to move the supplied portion of liquid raw material on the raw material supply disk (40b) to an irradiation position of the energy beam (23).

18. An extreme ultraviolet light source device as described in claim 13 or 14, wherein the raw material supply means (50) has a capillary (50b), and is adapted to supply the raw material by putting the raw material (21) in liquid form and supplying the liquid raw material (21) to the irradiation position of the energy beam (23) by way of the capillary (50).

19. An extreme ultraviolet light source device as described in claim 13 or 14, wherein a tubular nozzle (60a, 60b) is placed between the first energy beam irradiation means and the raw material (21, 31) such that the first energy beam (23) passes through the tubular nozzle (60a, 60b), and wherein at least part of the gasified raw material (21) is sprayed from the tubular nozzle (60a, 60b).

20. An extreme ultraviolet light source device as described in claim 19, wherein a constriction (62) is provided within the tubular nozzle (60b).

21. An extreme ultraviolet light source device as described in any one of claims 13 to 20, further comprising a magnetic field impression means that applies a magnetic field to the discharge region that is roughly parallel to a direction of discharge generated between the pair of electrodes (11, 12; 11', 12').

22. An extreme ultraviolet light source device as described in any one of claims 13 to 21, wherein the electrodes (11, 12) are disk-shaped electrodes (11, 12) and wherein the electrodes (11, 12) are configured to be rotatingly driven so that the discharge generation position on the electrode surface changes.

23. An extreme ultraviolet light source device as described in claim 22, wherein the disk-shaped electrodes (11, 12) are placed so that edge portions on the periphery of the electrodes (11, 12) are separated by a specified gap.

24. An extreme ultraviolet light source device as described in any one of claims 13 to 23, wherein the energy beam irradiation means are lasers (23a, 24a).

25. An extreme ultraviolet radiation generating method that generates extreme ultraviolet radiation by using a first energy beam (23) to irradiate and gasify a liquid or solid raw material (21, 31) supplied to a discharge region between a pair of electrodes (11, 12; 11', 12') within a vessel for the emission of extreme ultraviolet radiation, and heating and exciting the gasified raw material (21, 31) by generating a high temperature plasma with a discharge from the pair of electrodes (11, 12; 11', 12'), comprising the steps of:

   **characterized in that** it comprises the steps irradiating the first energy beam toward raw material (21, 31) supplied to a space, other than the discharge region, from which the gasified raw material (21, 31) can reach the discharge region,
   irradiating the discharge region with a second energy beam (24) so as to initiate discharge in the discharge region due to the paired electrodes (11, 12; 11', 12'), and so as to demarcate a discharge path in a specified position in the discharge region.

26. An extreme ultraviolet radiation generating method as described in claim 25, wherein the first energy beam (23) and the second energy beam (24) each have their irradiation timing set so that the discharge current of the discharge generated in the discharge region is at or above a specified threshold value (Ip) when at least part of the gasified raw material (21, 31) having a specified spatial density distribution reaches the discharge region.

27. An extreme ultraviolet radiation generating method as described in claim 26, wherein time data (ti) on the start of discharge and time data (Δti) on when the discharge current reaches the specified threshold value (Ip) is acquired, and the irradiation timing of the first energy beam (23) and of the second energy beam (24) is modified on the basis of both of said time data.

28. An extreme ultraviolet radiation generating method as described in claim 27, wherein the first energy beam (23) irradiates the raw material (21, 31) once prior to irradiation with the first energy beam (23) and the second energy beam (24) on the basis of said time data.

29. An extreme ultraviolet radiation generating method as described in claim 25, **characterized in**
after the discharge path is demarcated between the electrodes (11, 12; 11', 12'), supplying raw material gas to the discharge path of which the ion density in the discharge path is nearly the same as the ion density under extreme ultraviolet radiation emission conditions, and
heating the raw material gas by the discharge to a temperature that fulfills conditions for extreme ultraviolet radiation emission and producing extreme ultraviolet radiation continuously for at least 200 ns.

30. An extreme ultraviolet radiation generating method as described in claim 29, wherein the first energy beam (23) and the second energy beam (24) each have their irradiation timing set so that the discharge current of the discharge generated in the discharge region is at or above a specified threshold value (Ip) when at least part of the gasified raw material (21, 31) having a specified spatial density distribution reaches the discharge region.

31. An extreme ultraviolet radiation generating method as described in claim 30, wherein time data (ti) on the start of discharge and time data (Δti) on when the discharge current reaches the specified threshold value (Ip) is acquired, and the irradiation timing of the first energy beam (23) and of the second energy beam (24) is modified on the basis of both of said time data.

32. An extreme ultraviolet radiation generating method as described in claim 31, wherein the first energy beam (23) irradiates the raw material (21, 31) once prior to irradiation with the first energy beam (23) and the second energy beam (24) on the basis of said time data.

**Patentansprüche**

1. Extrem-Ultraviolett-Lichtquellenvorrichtung, die umfasst:

ein Gefäß mit einem Entladungsbereich,
ein Rohmaterialzuführungsmittel (20, 30, 40, 50) zur Zuführung flüssiger oder fester Rohmaterialien (21, 31), die eine Extrem-Ultraviolettstrahlung abgeben,
ein erstes Energiestrahlbestrahlungsmittel zur Vergasung des Rohmaterials (21, 31) durch Bestrahlen des Rohmaterials mit einem ersten Energiestrahl (23), der gegen das Rohmaterial (21, 31) gerichtet ist,
ein Paar Elektroden (11, 12; 11', 12'), die durch eine bestimmte Lücke getrennt sind, zum Erhitzen und Anregen des vergasten Rohmaterials (21, 31) durch eine Entladung innerhalb des Entladungsbereichs des Gefäßes und zum Generieren eines Hochtemperatur-Plasmas,
ein Impulsstromversorgungsmittel (8, 15) zur Versorgung der Elektroden (11, 12; 11', 12') mit Impulsstrom,
ein optisches Kollektormittel (2) zum Sammeln der vom Hochtemperatur-Plasma, das durch Entladung im Entladungsbereich des Paares der Elektroden (11, 12; 11', 12') generiert wird, abgegebenen Extrem-Ultraviolettstrahlung, und
einen Extrem-Ultraviolettstrahlung-Extraktionsbereich, in dem die gesammelte Extrem-Ultraviolettstrahlung extrahiert wird,
**dadurch gekennzeichnet, dass**
das Rohmaterialzuführungsmittel (20, 30, 40, 50) das flüssige oder feste Rohmaterial (21, 31) in einen anderen Raum als den Entladungsbereich zuführt, von dem das vergaste Rohmaterial (21, 31) den Entladungsbereich erreichen kann,
der erste Energiestrahl (23) auf das Rohmaterial (21, 31) gerichtet ist, das dem Raum zugeführt wird, von dem das vergaste Rohmaterial den Entladungsbereich erreichen kann, und

dass sie ein zweites Energiestrahlbestrahlungsmittel zur Auslösung der Entladung im Entladungsbereich und zur Abgrenzung eines Entladungsweges in einer bestimmten Position des Entladungsbereichs durch Abstrahlen eines zweiten Energiestrahls (24) zwischen den Elektroden (11, 12; 11', ', 12'), an die Energie angelegt wird, umfasst.

2.  Extrem-Ultraviolett-Lichtquellenvorrichtung gemäß Anspruch 1, wobei das erste Energiestrahlbestrahlungsmittel und das zweite Energiestrahlbestrahlungsmittel jeweils ein Mittel für eine operative Zeitgebung besitzen, das so eingestellt ist, dass der Entladungsstrom der im Entladungsbereich generierten Entladung an oder über einem bestimmten Schwellenwert (Ip) liegt, wenn zumindest ein Teil des vergasten Rohmaterials (21, 31) mit einer bestimmten Raumdichteverteilung den Entladungsbereich erreicht.

3.  Extrem-Ultraviolett-Lichtquellenvorrichtung gemäß Anspruch 1 oder 2, wobei das Rohmaterialzuführungsmittel (20) dazu ausgebildet ist, das Rohmaterial (21) zuzuführen, indem es in Tropfenform in Schwerkraftrichtung fallen gelassen wird.

4.  Extrem-Ultraviolett-Lichtquellenvorrichtung gemäß Anspruch 1 oder 2, wobei das Rohmaterialzuführungsmittel (30) dazu ausgebildet ist, das Rohmaterial (31) in Drahtform zu versetzen und den Rohmaterialdraht kontinuierlich zu bewegen.

5.  Extrem-Ultraviolett-Lichtquellenvorrichtung gemäß Anspruch 1 oder 2, wobei das Rohmaterialzuführungsmittel (40) eine Rohmaterialzuführungsscheibe (40b) aufweist und dazu ausgebildet ist, das Rohmaterial zuzuführen, indem das Rohmaterial in flüssige Form versetzt, das flüssige Rohmaterial der Rohmaterialzuführungsscheibe (40b) zugeführt und die Rohmaterialzuführungsscheibe (40b), der das flüssige Rohmaterial zugeführt wurde, gedreht wird, um den zugeführten Teil des flüssigen Rohmaterials auf der Rohmaterialzuführungsscheibe (40b) in eine Bestrahlungsposition des Energiestrahls (23) zu bewegen.

6.  Extrem-Ultraviolett-Lichtquellenvorrichtung gemäß Anspruch 1 oder 2, wobei das Rohmaterialzuführungsmittel (50) eine Kapillare (50b) aufweist und dazu ausgebildet ist, das Rohmaterial zuzuführen, indem das Rohmaterial in flüssige Form versetzt wird und das flüssige Rohmaterial über die Kapillare (50b) der Bestrahlungsposition des Energiestrahls (23) zugeführt wird.

7.  Extrem-Ultraviolett-Lichtquellenvorrichtung gemäß Anspruch 1 oder 2, wobei zwischen dem ersten Strahlabstrahlungsmittel und dem Rohmaterial (21, 31) eine rohrförmige Düse eingebracht ist, so dass der erste Energiestrahl (23) durch die rohrförmige Düse (60a/60b) strömt, um das Rohmaterial (21, 31) zu vergasen, und wobei mindestens ein Teil des vergasten Rohmaterials (21, 31) durch die rohrförmige Düse (60a, 60b) gesprüht wird.

8.  Extrem-Ultraviolett-Lichtquellenvorrichtung gemäß Anspruch 7, wobei eine Verengung (62) in der rohrförmigen Düse (60b) vorgesehen ist.

9.  Extrem-Ultraviolett-Lichtquellenvorrichtung gemäß einem der Ansprüche 1 bis 8, die ferner ein Magnetfeld-Anlegungsmittel umfasst, das an den Entladungsbereich ein Magnetfeld anlegt, das ungefähr parallel zu einer Richtung der Entladung ist, die zwischen dem Paar der Elektroden (11, 12; 11', 12') generiert wird.

10. Extrem-Ultraviolett-Lichtquellenvorrichtung gemäß einem der Ansprüche 1 bis 9, wobei die Elektroden scheibenförmige Elektroden (11, 12) sind und wobei die Elektroden (11, 12) so konfiguriert sind, dass sie rotationsförmig angetrieben werden, so dass sich die Entladungserzeugungsposition auf der Elektrodenoberfläche ändert.

11. Extrem-Ultraviolett-Lichtquellenvorrichtung gemäß Anspruch 10, wobei die scheibenförmigen Elektroden (11, 12) so angeordnet sind, dass die Randabschnitte am Außenumfang der Elektroden (11, 12) durch eine bestimmte Lücke getrennt sind.

12. Extrem-Ultraviolett-Lichtquellenvorrichtung gemäß einem der Ansprüche 1 bis 11, wobei die Energiestrahlbestrahlungsmittel Laser (23a, 24a) sind.

13. Extrem-Ultraviolett-Lichtquellenvorrichtung gemäß Anspruch 1,
    **dadurch gekennzeichnet, dass**
    das Impulsstromversorgungsmittel (8, 15) so konfiguriert ist, dass es den Elektroden (11, 12; 11', ', 12') einen Impulsstrom von 1 $\mu$s oder mehr zuführt, und wobei, nachdem der Entladungsweg zwischen den Elektroden (11,

**EP 1 976 344 B1**

12; 11', 12') durch das zweite Energiestrahlbestrahlungsmittel begrenzt wurde, Rohmaterialgas mit einer Ionendichte im Entladungsweg, die nahezu die gleiche ist wie die Ionendichte unter Bedingungen einer Extrem-Ultraviolettabstrahlungsemission, dem Entladungsweg zugeführt wird.

14. Extrem-Ultraviolett-Lichtquellenvorrichtung gemäß Anspruch 13, wobei das erste Energiestrahlbestrahlungsmittel und das zweite Energiestrahlbestrahlungsmittel jeweils ein Mittel für eine operative Zeitgebung aufweisen, die so eingestellt ist, dass der Entladungsstrom der im Entladungsbereich generierten Entladung bei oder über einem bestimmten Schwellenwert (Ip) liegt, wenn vergastes Rohmaterial mit einer bestimmten Raumdichteverteilung den Entladungsbereich erreicht.

15. Extrem-Ultraviolett-Lichtquellenvorrichtung gemäß Anspruch 13 oder 14, wobei das Rohmaterialzuführungsmittel (20) dazu ausgebildet ist, das Rohmaterial (21) zuzuführen, indem es in Tropfenform in Schwerkraftrichtung fallen gelassen wird.

16. Extrem-Ultraviolett-Lichtquellenvorrichtung gemäß Anspruch 13 oder 14, wobei das Rohmaterialzuführungsmittel (30) dazu ausgebildet ist, das Rohmaterial (31) in Drahtform zu versetzen und den Rohmaterialdraht kontinuierlich zu bewegen.

17. Extrem-Ultraviolett-Lichtquellenvorrichtung gemäß Anspruch 13 oder 14, wobei das Rohmaterialzuführungsmittel eine Rohmaterialzuführungsscheibe (40b) aufweist und dazu ausgebildet ist, das Rohmaterial zuzuführen, indem das Rohmaterial in flüssige Form versetzt, das flüssige Rohmaterial der Rohmaterialzuführungsscheibe (40b) zugeführt und die Rohmaterialzuführungsscheibe (40b), der das flüssige Rohmaterial zugeführt wurde, gedreht wird, um den zugeführten Teil des flüssigen Rohmaterials auf der Rohmaterialzuführungsscheibe (40b) in eine Bestrahlungsposition des Energiestrahls (23) zu bewegen.

18. Extrem-Ultraviolett-Lichtquellenvorrichtung gemäß Anspruch 13 oder 14, wobei das Rohmaterialzuführungsmittel (50) eine Kapillare (50b) aufweist und dazu ausgebildet ist, das Rohmaterial zuzuführen, indem das Rohmaterial (21) in flüssige Form versetzt wird und das flüssige Rohmaterial (21) über die Kapillare (50b) der Bestrahlungsposition des Energiestrahls (23) zugeführt wird.

19. Extrem-Ultraviolett-Lichtquellenvorrichtung gemäß Anspruch 13 oder 14; wobei zwischen dem ersten Energiestrahlbestrahlungsmittel und dem Rohmaterial (21, 31) eine rohrförmige Düse (60a, 60b) angeordnet ist, so dass der erste Energiestrahl (23) durch die rohrförmige Düse (60a, 60b) strömt, und wobei mindestens ein Teil des vergasten Rohmaterials (21) aus der rohrförmigen Düse (60a, 60b) gesprüht wird.

20. Extrem-Ultraviolett-Lichtquellenvorrichtung gemäß Anspruch 19, wobei eine Verengung (62) in der rohrförmigen Düse (60b) vorgesehen ist.

21. Extrem-Ultraviolett-Lichtquellenvorrichtung gemäß einem der Ansprüche 13 bis 20, die ferner ein Magnetfeld-Anlegungsmittel umfasst, das an den Entladungsbereich ein Magnetfeld anlegt, das ungefähr parallel zu einer Richtung der Entladung ist, die zwischen dem Paar der Elektroden (11, 12; 11', 12') generiert wird.

22. Extrem-Ultraviolett-Lichtquellenvorrichtung gemäß einem der Ansprüche 13 bis 21, wobei die Elektroden (11, 12) scheibenförmige Elektroden (11, 12) sind und wobei die Elektroden (11, 12) so konfiguriert sind, dass sie rotationsförmig angetrieben werden, so dass sich die Entladungsgenerierungsposition auf der Elektrodenoberfläche ändert.

23. Extrem-Ultraviolett-Lichtquellenvorrichtung gemäß Anspruch 22, wobei die scheibenförmigen Elektroden (11, 12) so angeordnet sind, dass die Randabschnitte am Außenumfang der Elektroden (11, 12) durch eine bestimmte Lücke getrennt sind.

24. Extrem-Ultraviolett-Lichtquellenvorrichtung gemäß einem der Ansprüche 13 bis 23, wobei die Energiestrahlbestrahlungsmittel Laser (23a, 24a) sind.

25. Verfahren zur Generierung einer Extrem-Ultraviolettstrahlung, das eine Extrem-Ultraviolettstrahlung generiert mittels eines ersten Energiestrahls (23) zum Bestrahlen und Vergasen eines flüssigen oder festen Rohmaterials (21, 31), das einem Entladungsbereich zwischen einem Paar Elektroden (11, 12; 11', 12') in einem Gefäß für die Emission von Extrem-Ultraviolettstrahlung zugeführt wird, und mittels des Erhitzens und Anregens des vergasten Rohmaterials (21, 31) durch Generieren eines Hochtemperatur-Plasmas mit einer Entladung von dem Paar Elektroden (11, 12;

11', 12'), die Schritte umfassend:

Abstrahlen des ersten Energiestrahls auf das Rohmaterial (21, 31), das einem anderen Raum als dem Entladungsbereich zugeführt wird, von dem das vergaste Rohmaterial (21, 31) den Entladungsbereich erreichen kann, Bestrahlen des Entladungsbereichs mit einem zweiten Energiestrahl (24), um mittels der gepaarten Elektroden (11, 12; 11', 12') eine Entladung im Entladungsbereich auszulösen und einen Entladungsweg in einer bestimmten Position im Entladungsbereich zu begrenzen.

26. Verfahren zur Generierung einer Extrem-Ultraviolettstrahlung gemäß Anspruch 25, wobei der erste Energiestrahl (23) und der zweite Energiestrahl (24) ihre jeweilige Bestrahlungs-Zeitgebung so eingestellt haben, dass der Entladungsstrom der im Entladungsbereich generierten Entladung bei oder über einem bestimmten Schwellenwert (Ip) liegt, wenn mindestens ein Teil des vergasten Rohmaterials (21, 31) mit einer bestimmten Raumdichteverteilung den Entladungsbereich erreicht.

27. Verfahren zur Generierung einer Extrem-Ultraviolettstrahlung gemäß Anspruch 26, wobei Zeitdaten (ti) über den Start der Entladung und Zeitdaten ($\Delta$ti) über den Zeitpunkt, zu dem der Entladungsstrom den bestimmten Schwellenwert (Ip) erreicht, gesammelt werden, und die Bestrahlungs-Zeitgebung des ersten Energiestrahls (23) und des zweiten Energiestrahls (24) auf der Grundlage dieser beiden Zeitdaten modifiziert wird.

28. Verfahren zur Generierung einer Extrem-Ultraviolettstrahlung gemäß Anspruch 27, wobei der erste Energiestrahl (23) das Rohmaterial (21, 31) ein Mal vor der Bestrahlung mit dem ersten Energiestrahl (23) und dem zweiten Energiestrahl (24) auf der Grundlage der Zeitdaten bestrahlt.

29. Verfahren zur Generierung einer Extrem-Ultraviolettstrahlung gemäß Anspruch 25,
**dadurch gekennzeichnet, dass**
nach der Begrenzung des Entladungsweges zwischen den Elektroden (11, 12; 11', 12') der Entladungsweg mit Rohmaterialgas versorgt wird, dessen Ionendichte im Entladungsweg nahezu gleich der Ionendichte unter Bedingungen einer Extrem-Ultraviolettstrahlungsemission ist, und
Erhitzen des Rohmaterialgases durch die Entladung auf eine Temperatur, die die Bedingungen für eine Extrem-Ultraviolettstrahlungsemission erfüllt, und kontinuierliche Produktion einer Extrem-Ultraviolettstrahlung für mindestens 200 ns.

30. Verfahren zur Generierung einer Extrem-Ultraviolettstrahlung gemäß Anspruch 29, wobei der erste Energiestrahl (23) und der zweite Energiestrahl (24) ihre jeweiligen Bestrahlungs-Zeitgebungen so eingestellt haben, dass der Entladungsstrom der im Entladungsbereich generierten Entladung bei oder über einem bestimmten Schwellenwert (Ip) liegt, wenn mindestens ein Teil des vergasten Rohmaterials (21, 31) mit einer bestimmten Raumdichteverteilung den Entladungsbereich erreicht.

31. Verfahren zur Generierung einer Extrem-Ultraviolettstrahlung gemäß Anspruch 30, wobei Zeitdaten (ti) über den Start der Entladung und Zeitdaten ($\Delta$ti) über den Zeitpunkt, zu dem der Entladungsstrom den bestimmten Schwellenwert (Ip) erreicht, gesammelt werden, und die Bestrahlungs-Zeitgebung des ersten Energiestrahls (23) und des zweiten Energiestrahls (24) auf der Grundlage dieser beiden Zeitdaten modifiziert wird.

32. Verfahren zur Generierung einer Extrem-Ultraviolettstrahlung gemäß Anspruch 31, wobei der erste Energiestrahl (23) das Rohmaterial (21, 31) einmal vor der Bestrahlung mit dem ersten Energiestrahl (23) und dem zweiten Energiestrahl (24) auf der Grundlage der Zeitdaten bestrahlt.

**Revendications**

1. Source lumineuse à ultraviolets extrêmes comprenant
une enceinte possédant une région de décharge,
un moyen d'alimentation en matières premières (20, 30, 40, 50) destiné à fournir des matières premières liquides ou solides (21, 31) qui émettront un rayonnement ultraviolet extrême,
un premier moyen d'irradiation par faisceau d'énergie destiné à gazéifier la matière première (21, 31) en l'irradiant avec un premier faisceau d'énergie (23) dirigé vers la matière première (21, 31), une paire d'électrodes (11, 12 ; 11', 12') séparées par un intervalle spécifié pour chauffer et exciter la matière première gazéifiée (21, 31) par une décharge dans ladite région de décharge de l'enceinte et pour produire un plasma à haute température,

un moyen d'alimentation en énergie en impulsions (8, 15) destiné à fournir de l'énergie en impulsions aux électrodes (11, 12 ; 11', 12'),

un moyen formant un collecteur optique (2) pour collecter le rayonnement ultraviolet extrême émis par le plasma à haute température produit par la décharge dans la région de décharge de la paire d'électrodes (11, 12 ; 11', 12'), et

une zone d'extraction du rayonnement ultraviolet extrême dans laquelle le rayonnement ultraviolet extrême collecté est extrait,

**caractérisée en ce que**

le moyen d'alimentation en matières premières (20, 30, 40, 50) amène les matières premières solides ou liquides (21, 31) dans un espace autre que la région de décharge à partir duquel la matière première gazéifiée (21, 31) peut parvenir dans la région de décharge,

**en ce que** le premier faisceau d'énergie (23) est dirigé vers la matière première (21, 31) amenée dans ledit espace à partir duquel la matière première gazéifiée peut parvenir dans la région de décharge, et

**en ce qu'**elle comprend un deuxième moyen d'irradiation à faisceau d'énergie pour déclencher la décharge dans la région de décharge et pour délimiter un trajet de décharge dans une position spécifiée de la région de décharge en émettant un deuxième faisceau d'énergie (24) entre les électrodes (11, 12 ; 11', 12') auxquelles l'alimentation est appliquée.

2.  Source lumineuse à ultraviolets extrêmes selon la revendication 1, dans laquelle le premier moyen d'irradiation par faisceau d'énergie et le deuxième moyen d'irradiation à faisceau d'énergie possèdent chacun des moyens pour régler un moment de fonctionnement de telle façon que l'intensité de décharge de la décharge produite dans la région de décharge soit égale ou supérieure à une valeur de seuil spécifiée (Ip) quand au moins une partie de la matière première gazéifiée (21, 31) ayant une répartition de densité spatiale spécifiée arrive dans la région de décharge.

3.  Source lumineuse à ultraviolets extrêmes selon la revendication 1 ou 2, dans laquelle le moyen d'alimentation en matières premières (20) est adapté pour amener la matière première (21) en la laissant tomber sous forme de gouttelettes dans le sens de la gravitation.

4.  Source lumineuse à ultraviolets extrêmes selon la revendication 1 ou 2, dans laquelle le moyen d'alimentation en matières premières (30) est adapté pour mettre la matière première (31) en forme de fil et déplacer le fil de la matière première de façon continue.

5.  Source lumineuse à ultraviolets extrêmes selon la revendication 1 ou 2, dans laquelle le moyen d'alimentation en matières premières (40) possède un disque d'alimentation en matière première (40b) et est adapté pour amener la matière première en mettant la matière première sous forme liquide, en amenant la matière première liquide au disque d'alimentation en matière première (40b), et en faisant tourner le disque d'alimentation en matière première (40b) auquel la matière première liquide a été amenée pour déplacer la portion de matière première liquide amenée sur le disque d'alimentation en matière première (40b) dans une position d'irradiation du faisceau d'énergie (23).

6.  Source lumineuse à ultraviolets extrêmes selon la revendication 1 ou 2, dans laquelle le moyen d'alimentation en matières premières (50) possède un capillaire (50b) et est adapté pour amener la matière première en mettant la matière première sous forme liquide et en amenant la matière première liquide dans la position d'irradiation du faisceau d'énergie (23) à l'aide du capillaire (50b).

7.  Source lumineuse à ultraviolets extrêmes selon la revendication 1 ou 2, dans laquelle une buse tubulaire est placée entre le premier moyen d'irradiation à faisceau d'énergie et la matière première (21, 31), de telle sorte que le premier faisceau d'énergie (23) passe à travers la buse tubulaire (60a/60b) pour gazéifier la matière première (21, 31), et dans laquelle une partie au moins de la matière première gazéifiée (21, 31) est pulvérisée par la buse tubulaire (60a, 60b).

8.  Source lumineuse à ultraviolets extrêmes selon la revendication 7, dans laquelle une constriction (62) est prévue dans la buse tubulaire (60b).

9.  Source lumineuse à ultraviolets extrêmes selon l'une quelconque des revendications 1 à 8, comprenant en outre un moyen d'application de champ magnétique qui applique dans la région de décharge un champ magnétique qui est approximativement parallèle à un sens de la décharge produite entre la paire d'électrodes (11, 12 ; 11', 12').

10. Source lumineuse à ultraviolets extrêmes selon l'une quelconque des revendications 1 à 9, dans laquelle les électrodes sont des électrodes en forme de disque (11, 12) et dans laquelle les électrodes (11, 12) sont configurées pour être entraînées en rotation de telle façon que la position de génération de la décharge à la surface des électrodes change.

11. Source lumineuse à ultraviolets extrêmes selon la revendication 10, dans laquelle les électrodes en forme de disque (11, 12) sont placées de telle façon que des parties de bord sur la périphérie des électrodes (11, 12) soient séparées par un espace spécifié.

12. Source lumineuse à ultraviolets extrêmes selon l'une quelconque des revendications 1 à 11, dans laquelle les moyens d'irradiation à faisceaux d'énergie sont des lasers (23a, 24a).

13. Source lumineuse à ultraviolets extrêmes selon la revendication 1,
**caractérisée en ce que**
le moyen d'alimentation en énergie en impulsions (8, 15) est configuré pour fournir une alimentation en impulsions de 1 μs ou plus aux électrodes (11, 12 ; 11', 12'), et dans laquelle, après la délimitation du trajet de décharge entre les électrodes (11, 12 ; 11', 12') par le deuxième moyen d'irradiation à faisceau d'énergie, de la matière première gazeuse ayant dans le trajet de décharge une densité ionique presque égale à la densité ionique dans les conditions d'émission de rayonnement ultraviolet extrême est amenée dans le trajet de décharge.

14. Source lumineuse à ultraviolets extrêmes selon la revendication 13, dans laquelle le premier moyen d'irradiation par faisceau d'énergie et le deuxième moyen d'irradiation à faisceau d'énergie possèdent chacun des moyens pour régler un moment de fonctionnement de telle façon que l'intensité de décharge de la décharge produite dans la région de décharge soit égale ou supérieure à un seuil spécifié (Ip) quand de la matière première gazéifiée ayant une distribution de densité spatiale spécifiée atteint la région de décharge.

15. Source lumineuse à ultraviolets extrêmes selon la revendication 13 ou 14, dans laquelle le moyen d'alimentation en matières premières (20) est adapté pour amener la matière première (21) en la laissant tomber sous forme de gouttelettes dans le sens de la gravitation.

16. Source lumineuse à ultraviolets extrêmes selon la revendication 13 ou 14, dans laquelle le moyen d'alimentation en matières premières (30) est adapté pour mettre la matière première (31) en forme de fil et déplacer le fil de la matière première de façon continue.

17. Source lumineuse à ultraviolets extrêmes selon la revendication 13 ou 14, dans laquelle le moyen d'alimentation en matières premières possède un disque d'alimentation en matière première (40b) et est adapté pour amener la matière première en mettant la matière première sous forme liquide, en amenant la matière première liquide au disque d'alimentation en matière première (40b), et en faisant tourner le disque d'alimentation en matière première (40b) auquel la matière première liquide a été amenée pour déplacer la portion de matière première liquide amenée sur le disque d'alimentation en matière première (40b) dans une position d'irradiation du faisceau d'énergie (23).

18. Source lumineuse à ultraviolets extrêmes selon la revendication 13 ou 14, dans laquelle le moyen d'alimentation en matières premières (50) possède un capillaire (50b) et est adapté pour amener la matière première en mettant la matière première (21) sous forme liquide et en amenant la matière première liquide dans la position d'irradiation du faisceau d'énergie (23) à l'aide du capillaire (50).

19. Source lumineuse à ultraviolets extrêmes selon la revendication 13 ou 14, dans laquelle une buse tubulaire (60a, 60b) est placée entre le premier moyen d'irradiation à faisceau d'énergie et la matière première (21, 31), de telle sorte que le premier faisceau d'énergie (23) passe à travers la buse tubulaire (60a, 60b) pour gazéifier la matière première (21, 31), et dans laquelle une partie au moins de la matière première gazéifiée (21) est pulvérisée par la buse tubulaire (60a, 60b).

20. Source lumineuse à ultraviolets extrêmes selon la revendication 19, dans laquelle une constriction (62) est prévue dans la buse tubulaire (60b).

21. Source lumineuse à ultraviolets extrêmes selon l'une quelconque des revendications 13 à 20, comprenant en outre un moyen d'application de champ magnétique qui applique dans la région de décharge un champ magnétique qui est approximativement parallèle à un sens de la décharge produite entre la paire d'électrodes (11, 12 ; 11', 12').

**22.** Source lumineuse à ultraviolets extrêmes selon l'une quelconque des revendications 13 à 21, dans laquelle les électrodes (11, 12) sont des électrodes en forme de disque (11, 12) et dans laquelle les électrodes (11, 12) sont configurées pour être entraînées en rotation de telle façon que la position de génération de la décharge à la surface des électrodes change.

**23.** Source lumineuse à ultraviolets extrêmes selon la revendication 22, dans laquelle les électrodes en forme de disque (11, 12) sont placées de telle façon que des parties de bord sur la périphérie des électrodes (11, 12) soient séparées par un espace spécifié.

**24.** Source lumineuse à ultraviolets extrêmes selon l'une quelconque des revendications 13 à 23, dans laquelle les moyens d'irradiation à faisceaux d'énergie sont des lasers (23a, 24a).

**25.** Procédé de génération de rayonnement dans l'ultraviolet extrême produisant un rayonnement ultraviolet extrême en utilisant un premier faisceau d'énergie (23) pour irradier et gazéifier une matière première liquide ou solide (21, 31) amenée dans une région de décharge entre une paire d'électrodes (11, 12 ; 11', 12') à l'intérieur d'une enceinte pour l'émission de rayonnement ultraviolet extrême, et en chauffant et excitant la matière première gazéifiée (21, 31) en produisant un plasma à haute température avec une décharge provenant de la paire d'électrodes (11, 12 ; 11', 12'), **caractérisé en ce qu'**il comprend les étapes d'irradiation du premier faisceau d'énergie vers la matière première (21, 31) amenée dans un espace autre que la région de décharge à partir duquel la matière première gazéifiée (21, 31) peut atteindre région de décharge,
irradiation de la région de décharge avec un deuxième faisceau d'énergie (24) de façon à déclencher une décharge dans la région de décharge grâce aux électrodes en paire (11, 12 ; 11', 12'), et de façon à délimiter un trajet de décharge dans une position spécifiée de la région de décharge.

**26.** Procédé de génération de rayonnement ultraviolet extrême selon la revendication 25,
dans lequel le premier faisceau d'énergie (23) et le deuxième faisceau d'énergie (24) ont chacun un moment d'irradiation réglé de telle façon que l'intensité de décharge de la décharge produite dans la région de décharge soit égale ou supérieure à un seuil spécifié (Ip) quand une partie au moins de la matière première gazéifiée (21, 31) ayant une distribution de densité spatiale spécifiée atteint la région de décharge.

**27.** Procédé de génération de rayonnement ultraviolet extrême selon la revendication 26,
dans lequel les données de temps (ti) du début de la décharge et les données de temps (Δti) du moment où l'intensité de la décharge atteint la valeur de seuil spécifiée (Ip) sont acquises, et le moment de l'irradiation par le premier faisceau d'énergie (23) et par le deuxième faisceau d'énergie (24) est modifié sur la base de ces deux données de temps.

**28.** Procédé de génération de rayonnement ultraviolet extrême selon la revendication 27,
dans lequel le premier faisceau d'énergie (23) irradie la matière première (21, 31) une fois avant l'irradiation avec le premier faisceau d'énergie (23) et le deuxième faisceau d'énergie (24) sur la base desdites données de temps.

**29.** Procédé de génération de rayonnement ultraviolet extrême selon la revendication 25, **caractérisé en ce que**
après que le trajet de décharge est délimité entre les électrodes (11, 12 ; 11', 12'), la matière première gazeuse est amenée dans le trajet de décharge dans lequel la densité ionique est presque la même que la densité ionique dans les conditions d'émission du rayonnement ultraviolet extrême, et
la matière première gazeuse est chauffée par la décharge à une température qui remplir les conditions d'émission de rayonnement ultraviolet extrême et produit un rayonnement ultraviolet extrême de façon continue pendant au moins 200 ns.

**30.** Procédé de génération de rayonnement ultraviolet extrême selon la revendication 29, dans lequel le premier faisceau d'énergie (23) et le deuxième faisceau d'énergie (24) ont chacun un moment d'irradiation réglé de telle façon que l'intensité de décharge de la décharge produite dans la région de décharge soit égale ou supérieure à une valeur de seuil spécifiée (Ip) quand au moins une partie de la matière première gazéifiée (21, 31) ayant une répartition de densité spatiale spécifiée arrive dans la région de décharge.

**31.** Procédé de génération de rayonnement ultraviolet extrême selon la revendication 30, dans lequel les données de temps (ti) du début de la décharge et les données de temps (Δti) du moment où l'intensité de la décharge atteint la valeur de seuil spécifiée (Ip) sont acquises, et le moment de l'irradiation par le premier faisceau d'énergie (23) et par le deuxième faisceau d'énergie (24) est modifié sur la base de ces deux données de temps.

**32.** Procédé de génération de rayonnement ultraviolet extrême selon la revendication 31, dans lequel le premier faisceau d'énergie (23) irradie la matière première (21, 31) une fois avant l'irradiation avec le premier faisceau d'énergie (23) et le deuxième faisceau d'énergie (24) sur la base desdites données de temps.

**Fig. 1 (a)**　Power source trigger
(IGBT on)
Td

**Fig. 1 (b)**　(Inter-electrode)
Voltage
$\Delta$td
Threshold value (Vp)

**Fig. 1 (c)**　2nd laser beam
(laser beam
for initiation)
T2

**Fig. 1 (d)**　(Discharge)
Voltage
Breakdown point
Threshold value (Ip)
$\Delta$ti
$\Delta$tp

**Fig. 1 (e)**　1st laser beam
(laser beam
for raw material)
T1
raw material gas
arrival (standby)
point
$\Delta$tg

**Fig. 1 (f)**　EUV emission

**Fig. 2 (a)**    Power source trigger
(IGBT on)

Td

Δtd

**Fig. 2 (b)**    (Inter-electrode)
Voltage

Threshold value (Vp)

**Fig. 2 (c)**    2nd laser beam
(laser beam
for initiation)

T2

**Fig. 2 (d)**    (Discharge)
Current

Breakdown point

Threshold value (Ip)

Δti    Δtp

**Fig. 2 (e)**    1st laser beam
(laser beam
for raw material)

T1

raw material gas
arrival (standby)
point

Δtg

**Fig. 2 (f)**    EUV emission

# Fig. 3 (a)

# Fig. 3 (b)

## Fig. 4 (a)

Electrode 11
(anode)

High-temperature
plasma

Raw material
21

EUV collector
optics 2

EUV emission

Gasified raw
material 21'

Laser beam 23

Optical axis

Electrode 12
(cathode)

## Fig. 4 (b)

Electrode 11
(anode)

High-temperature
plasma

EUV collector
optics 2

EUV emission

Raw material
21

Optical axis

Gasified raw
material 21'

Laser beam 23

Electrode 12
(cathode)

# Fig. 5 (a)

Raw material
21

EUV collector
optics 2

Electrode 11'
(anode)

EUV emission

High-temperature
plasma

Optical axis

Gasified raw
material 21'

Laser
beam 23

# Fig. 5 (b)

Raw material supply means 20

Electrode 11'
(anode)

Raw material
21

EUV collector
optics 2

High-temperature
plasma

EUV emission

Laser beam

Optical axis

Gasified raw
material 21'

Electrode 12
(cathode)

# Fig. 6

# Fig. 7 (a) Plasma current

Threshold value Ip

# Fig. 7 (b) Low-temperature plasma radius

Gas irradiation

Heating brings electron temperature to specified value

# Fig. 7 (c) EUV emission

EUV emission

# Fig. 8 (a) Plasma current

Threshold value Ip2

# Fig. 8 (b) Low-temperature plasma radius

Gas irradiation

Heating brings electron temperature to specified value

# Fig. 8 (c) EUV emission

EUV emission

# Fig. 9

# Fig. 10

# Fig. 11 (a)

2nd rotary electrode

Discharge path

Point collection

Laser beam for initiation 24

Collection optics 24c

2nd laser source

1st rotary electrode

24d

# Fig. 11 (b)

2nd rotary electrode

Discharge path

Linear collection

Laser beam for initiation 24

Collection optics 24c

2nd laser source

1st rotary electrode

24f

24e

# Fig. 12

P 0 ──────────────

L

20a

Raw material
monitor

P 1 ──── ○ ── T m

L p

P 2 ──── ○ ── T m + △ t m

# Fig. 13

Start

**S101** A standby command from the controller 26 of the EUV light source device is transmitted to the vacuum evacuation devices 5 and 4, the gas evacuation units 13 and 14, the 1st motor 22a and the 2nd motor 22b.

**S102** The vacuum evacuation device 5 and 4, the gas supply units 13 and 14, the 1st motor 22a, and the 2nd motor 22b begin to operate. A vacuum atmosphere forms in the discharge space 1a and a gas curtain 13b is formed in the collection space 1b, to which buffer gas and cleaning gas are supplied. The 1st rotary electrode 11 and the 2nd rotary electrode 12 rotate. (standby state)

**S103** The EUV light source device controller 26 sends an operation start command signal to the raw material gas supply unit 20 and the raw material monitor 20a.

**S104** The raw material supply unit 20 begins to drop droplets of the high-temperature plasma raw material. The raw material monitor 20, when the raw material reaches the position P1, transmits a raw material detection signal to the controller of the EUV light source device.

**S105** The EUV light source device controller 26 transmits a standby completion signal to the lithography tool controller 27.

**S106** The controller 26 of the EUV light source device receives a light emission command from the lithography tool controller 27 that has received the standby completion signal.

**S107** The EUV light source device controller 26 transmits a charge control signal to the charger CH of the pulsed power generator 8.

**S108** The charger CH charges the main capacitor C0.

**S109** First pulse?

Yes — **S110**

No — **S116**

**S110** The EUV light source device controller 26 finds the timings Td', T1' and T2' with time Tm as the reference.

$$Td' = Tm + (\Delta tm - \Delta td - \Delta ti + \Delta tg) - d1 - (\alpha + \beta) \quad (15)$$
$$T1' = Tm + \Delta tm \quad (14)$$
$$T2' = Tm + (\Delta tm + \Delta tg - \Delta ti) - \beta \quad (16)$$

**S111** The EUV light source device controller 26 takes the time of detection of the first raw material detection signal from the raw material monitor 20a, after the charger charge stabilization period tst has elapsed, as the reference time Tm.

**S112** With time Tm as the reference and the timings found in step S110, the EUV light source device controller 26 sends the main trigger signal, the 1st trigger signal, and the 2nd trigger signal to the switching means of the pulsed power generator 8, the 1st laser controller 23b, and the 2nd laser controller 24b respectively.

**S116** The EUV light source device controller 26 calculates corrected values of the timings T1' and T2' based on the counter values (step S114)

$$tvcal = (d1 + \Delta td) - tvc \quad (20)$$
$$tical = \Delta ti - tic \quad (21)$$

**S117** The EUV light source device controller 26 in consideration of the correction values, finds the timings Td', T1' and T2' with time Tm as the reference.

$$Td' = Tm + (\Delta tm - \Delta td - \Delta ti + \Delta tg) - d1 - (\alpha + \beta) - (tvcal + tical) \quad (22)$$
$$T1' = Tm + \Delta tm \quad (14)$$
$$T2' = Tm + (\Delta tm + \Delta tg - \Delta ti) - \beta - tical \quad (23)$$

**S118** The EUV light source device controller 26 takes the time of detection of the first raw material detection signal from the raw material monitor 20a, after the charger charge stabilization period tst has elapsed, as the reference time Tm.

**S119** With time Tm as the reference and the timings found in step S110, the EUV light source device controller 26 sends the main trigger signal, the 1st trigger signal, and the 2nd trigger signal to the switching means of the pulsed power generator 8, the 1st laser controller 23b, and the 2nd laser controller 24b respectively.

Ⓐ      Ⓑ

# Fig. 14

Ⓐ                                                                                        Ⓑ

**S113** | The EUV light source device controller 26 operates a voltage counter at the start of trigger signal output and operates a current counter at the start of the 2nd trigger signal output.

**S114** | The EUV light source device controller 26 detects the timing for reaching the threshold value Vp, and stops the voltage counter, detects the timing for reaching the threshold value Ip, and stops the current counter.

**S115** | As a result of the EUV light source device controller 26 sending various trigger signals, high-temperature plasma is created by the discharge and EUV emissions with a wavelength of 13.5 nm are produced by the high-temperature plasma.

( End )

# Fig. 15

S201 Standby command

S202 Standby state

S203 Operation start command

S204 Raw material detection signal

S205 Standby completion signal

S206 Light emission command

S207 Charge control command

$$Td' = Tm + (\Delta tm - \Delta td - \Delta ti + \Delta tg) - d1 - (\alpha + \beta). \ldots (15)$$
$$T1' = Tm + \Delta tm \qquad \ldots (14)$$
$$T2' = Tm + (\Delta tm + \Delta tg - \Delta ti) - \beta \ldots (16)$$

$$Td' = Tm + (\Delta tm - \Delta td - \Delta ti + \Delta tg) - d1 - (\alpha + \beta) - (tvcal + tical). \ldots (22)$$
$$T1' = Tm + \Delta tm \qquad \ldots (14)$$
$$T2' = Tm + (\Delta tm + \Delta tg - \Delta ti) - \beta - tical \ldots (16)$$

S208 Controller operation

S209 Main trigger signal

S210 IGBT on

S211 (Inter-electrode)voltage

S212 Voltage counter

S213 2nd trigger signal

S214 2nd laser beam (laser beam for initiation)

S215 (Discharge) current

S216 Current counter

S217 1st trigger signal

S218 1st laser beam (laser beam for raw material)

S219 EUV emission

78

# Fig. 16

Discharge space 1a

Raw material supply unit 30

Plasma

1st motor 22a

Rotor shaft 22e

1st rotary electrode 11

Reel 30a

Positioning means A 30b

Laser beam for raw material 23

Aperture

Collecting optical system

Raw material wire 31

1st laser source

23a

Positioning means B 30c

2nd laser source

24a

Drive mechanism 30d

Collecting optical system

Aperture

Reel 30e

Laser beam for initiation 24

# Fig. 17

Discharge space 1a

Mechanical seal 22d

Rotor shaft 22f

2nd rotary electrode 12

2nd motor 22b

Chamber 1

Laser beam for raw material 23

Aperture

Plasma

1st laser source

23a

Raw material 31

Collecting optical system

Optical axis

2nd laser source

24a

Collecting optical system

Aperture

1st motor 22a

Laser beam for initiation 24

1st rotary electrode 11

Rotor shaft 22e

Mechanical seal 22c

# Fig. 18

1st motor 22a

Foil trap 3

Rotor shaft 22e

EUV collector optics 2

1st rotary electrode 11

Plasma

Raw material supply disk 40b

Optical axis

2nd rotary electrode 12

Rotor shaft 22f

2nd motor 22b

Laser beam for initiation 24

Chamber 1

Laser beam for raw material 23

# Fig. 19

Raw material supply disk 40b

EUV collector optics 2    Foil trap 3    Raw material supply unit 40

Liquid material
supply means 40a

Plasma

Optical axis

Wiper 12d

Power introduction part 12c

Laser beam for initiation 24

2nd rotary
electrode 12

Aperture

Chamber 1    Laser beam for
raw material 23    Collecting optical system

Aperture

Collecting optical system    1st laser
source    2nd laser
source

23a    24a

# Fig. 20

Rotor shaft 22e
1st motor 22a
EUV collector optics 2
1st rotary electrode 11
Foil trap 3
Aperture
Raw material supply unit 40
Collecting optical system
Liquid raw material supply means 40a
23a
1st laser source
Raw material supply disk 40b
Rotor shaft 40d
2nd laser source
3rd motor 40c
24a
Chamber 1
2nd rotary electrode 12
Rotor shaft 22f
2nd motor 22b

# Fig. 21

Liquid raw
material bath 50a

EUV collector optics 2

Foil trap 3

Raw material supply unit 50

Capillary 50b

Heater 50c

Plasma

Optical axis

1st electrode 11'
(2nd electrode 12')

Laser beam for initiation 24

Aperture

Laser beam for
raw material 23

Collecting optical system

Aperture

2nd laser source 24a

Chamber 1

Collecting optical system

1st laser source 23a

# Fig. 22

Power introduction part

Laser beam for 1st electrode 11'
raw material 23

EUV collector optics 2

Aperture

Foil trap 3

Collecting optical
system

Liquid raw material bath 50a

Raw material supply unit 50

1st laser
source 23a

2nd laser
source 24a

Capillary 50b

Heater 50c

Collecting
optical system   Aperture

Chamber 1

Power
introduction part

Laser beam for initiation 24

2nd electrode 12'

| Pulsed power generator | Heater power source | Liquid raw material bath controller |
|---|---|---|
| 8 | 50e | 50d |

Fig. 23 (a)

Laser beam for raw material 23

Raw material 21

Tubular nozzle 60a

Fig. 23 (b)

Gasified raw material 21'

Raw material 21

Tubular nozzle 60a

## Fig. 24 (a)

Laser beam for
raw material 23    Constriction 62

Raw material 21

High-speed spray nozzle 60b

## Fig. 24 (b)

Gasified raw material 21'    Constriction 62    Pressure elevation area 63

Raw material 21

High-speed spray nozzle 60b

## Fig. 24 (c)

Gasified raw material 21'    Constriction 62    Pressure elevation area 63

Raw material 21

High-speed spray nozzle 60b    Heater 64

# Fig. 25

Raw material supply unit 60

Pressure elevation area 63

Constriction 62

Gasified raw material 21'

Raw material accommodation area 60c

Raw material 21

High-speed spray nozzle 60b

# Fig. 26 (a)

Laser beam 23

High-temperature plasma raw material 21

Concavity 61a

# Fig. 26 (b)

Laser beam 23

High-temperature plasma raw material 21

Concavity 61a

# Fig. 27

```
                              ( Start )
                                  │
                                  ▼
```

S301 | A standby command from the controller 26 of the EUV light source device is transmitted to the vacuum evacuation devices 5 and 4, the gas evacuation units 13 and 14, the 1st motor 22a and the 2nd motor 22b.

S302 | The vacuum evacuation device 5 and 4, the gas supply units 13 and 14, the 1st motor 22a, and the 2nd motor 22b begin to operate. A vacuum atmosphere forms in the discharge space 1a and a gas curtain 13b is formed in the collection space 1b, to which buffer gas and cleaning gas are supplied. The 1st rotary electrode 11 and the 2nd rotary electrode 12 rotate. (standby state)

S305 | The EUV light source device controller 26 transmits a standby completion signal to the lithography tool controller 27.

S306 | The controller 26 of the EUV light source device receives a light emission command from the lithography tool controller 27 that has received the standby completion signal.

S307 | The EUV light source device controller 26 transmits a charge control signal to the charger CH of the pulsed power generator 8.

S308 | The charger CH charges the main capacitor C0.

S309 | First pulse?

**Yes** — S310

The EUV light source device controller 26 finds the timings T1' and T2' with time Td' as the reference.

$$T1'=Td'+d1+(\Delta td+\Delta ti-\Delta tg) +(\alpha+\beta) \quad (11)$$
$$T2'=Td'+d1+\Delta td+\alpha \quad (5)$$

S311 | The EUV light source device controller 26 transmits the main trigger signal to the switching means of the pulsed power supply means 8, after the charger charge stabilization period tst has elapsed. This time becomes the reference time Td'.

S312 | With time Td' as the reference and the timings found in step S310, the EUV light source device controller 26 sends the 1st trigger signal and the 2nd trigger signal to the 1st laser controller 23b, and the 2nd laser controller 24b respectively.

**No** — S316

The EUV light source device controller 26 calculates corrected values of the timings T1' and T2' based on the counter values (step S314)

$$tvcal = (d1+\Delta td)\text{-}tvc \quad (20)$$
$$tical = \Delta ti\text{-}tic \quad (21)$$

S317 | The EUV light source device controller 26, in consideration of the correction values, finds the timings T1' and T2' with time Td' as the reference.

$$T1'=Td'+d1+(\Delta td+\Delta ti-\Delta tg) +(\alpha+\beta)+(tvcal + tical) \quad (25)$$
$$T2'=Td'+d1+\Delta td+\alpha+tvcal \quad (23)$$

S318 | The EUV light source device controller 26 transmits the main trigger signal to the switching means of the pulsed power supply means 8, after the charger charge stabilization period tst has elapsed. This time becomes the reference time Td'.

S319 | With time Td' as the reference and the timings found in step S310, the EUV light source device controller 26 sends the 1st trigger signal and the 2nd trigger signal to the 1st laser controller 23b, and the 2nd laser controller 24b respectively.

Ⓐ          Ⓑ

# Fig. 28

Ⓐ        Ⓑ

**S313** — The EUV light source device controller 26 operates a voltage counter at the start of trigger signal output and operates a current counter at the start of the 2nd trigger signal output.

**S314** — The EUV light source device controller 26 detects the timing for reaching the threshold value Vp, and stops the voltage counter, detects the timing for reaching the threshold value Ip, and stops the current counter.

**S315** — As a result of the EUV light source device controller 26 sending various trigger signals, high-temperature plasma is created by the discharge and EUV emissions with a wavelength of 13.5 nm are produced by the high-temperature plasma.

End

# Fig. 29

S401 Standby command

S402 Standby state

S405 Standby completion command

S406 Light emission command

S407 Charge control command

tst

$$T1'=Td'+d1+(\Delta td+\Delta ti-\Delta tg) \\ +(\alpha+\beta)...(11)$$
$$T2'=Td'+d1+\Delta td+\alpha \qquad ...(5)$$

$$T1'=Td'+d1+(\Delta td+\Delta ti-\Delta tg) \\ +(\alpha+\beta)+(tvcal+tical)...(25)$$
$$T2'=Td'+d1+\Delta td+\alpha+tvcal \qquad ...(24)$$

S408 Controller calculations

S409 Main trigger signal

tvc   tic

S410 IGBT on

Td'

S411 (Inter-electrode)voltage

d1   Td

Threshold (Vp)

$\Delta td$   $\alpha$

S412 Voltage counter

S413 2nd trigger signal

T2'

S414 2nd laser beam
(laser beam for initiation)

T2   Breakdown

S415 (Discharge) current

Threshold (Ip)

$\Delta ti$   $\Delta tp$   $\beta$

S416 Current counter

S417 1st trigger signal

T1'

S418 1st laser beam
(laser beam for raw material)

Raw material
gas arrival

T1   $\Delta tg$

S419 EUV emission

# Fig. 30

Power source trigger
(IGBT on)
Td

Δtd

(Inter-electrode)
voltage

Threshold
(Vp)

2nd laser beam
(laser beam
for initiation)
T2

Breakdown time

(Discharge)
current

Threshold
(Ip)

Δti

Δtp

Adjustment irradiation
1st laser beam
(laser beam
for raw material)
T1

Raw material gas
arrival (standby)
time

Δtg

EUV emission

# Fig. 31

1st electrode 11
(cathode)

Chamber 1

Low temperature gas 21'
(gasified raw material)

High-temperature plasma

High-temperature plasma
raw material 21

PFN

EUV emission

Pulsed power
supply means 15

EUV light
extraction area 7

Laser source 23a

EUV collector optics 2

Laser beam 23

2nd electrode 12
(anode)

**Fig. 32 (a)** Power source trigger (PFN)

Td

**Fig. 32 (b)** (Inter-electrode) Voltage

Threshold (Vp)

$\Delta$td

Discharge generation time point

**Fig. 32 (c)** (Discharge) Current

T1

Threshold (Ip)

$\Delta$ti

$T > 1\mu s$

**Fig. 32 (d)** Laser beam

T2 $\Delta$tg

**Fig. 32 (e)** EUV emission

Raw material gas arrival time

Arrival at specified plasma electron temperature

$\tau_{heat}$

$T_{EUV} > (200ns)$

# Fig. 33

2nd laser beam 24

1st laser beam 23

1st discharge electrode 11

2nd discharge electrode 12

2nd laser beam focal point

Discharge channel

Low-temperature plasma gas 21'

High-temperature plasma raw material 21

# Fig. 34

# Fig. 35

PFN circuit area

Pulsed power supply means 15

# Fig. 36

```
( Start )
```

**S501** | A standby command from the controller of the EUV light source device is transmitted to the evacuation device, the start-up raw material supply unit and the motor.

**S502** | The evacuation device, the start-up raw material supply unit, and the motor begin to operate. A reduced-pressure atmosphere forms in the chamber, the supply of start-up raw material to the 2nd discharge electrode begins, and the 1st rotary electrode and the 2nd rotary electrode rotate. (standby state)

**S503** | The EUV light source device controller transmits a standby completion signal to the lithography tool controller.

**S504** | The controller of the EUV light source device receives a light emission command from the lithoghaphy tool controller that 27 has received the standby completion signal.

**S505** | The EUV light source device controller transmits a charge control signal to the charger CH1 of the power generation means.

**S506** | The charger CH1 charges the main capacitor C.

**S507** | The EUV light source device controller finds the timings Td' and T2' with time TL1 as the reference

$$Td'=TL1'+\gamma-d1 \qquad (34)$$
$$TL2'=TL1'+\Delta tg+\varepsilon$$
$$(0<\varepsilon<\Delta ts, \ \varepsilon=\gamma+\Delta td-\Delta tg) \qquad (43)$$

**S508** | At time point TL1' at or after ther charger charge stabilization period tst has elapsed, the EUV light source device controller transmits the 1st trigger signal to the 1st laser source.

**S509** | At the timing Td' found in step S507 with the points TL1' as a reference, the EUV light source device controller transmits the main trigger signal to the switch SW1. At the timing TL2' found in step S507, it transmits the 2nd trigger signal to the 2nd laser source.

**S510** | As a result of the EUV light source device controller sending the trigger signals, the 2nd laser beam is focused on the specified position in the discharge region, a gas discharge is generated in the discharge region, and the position of the discharge channel of the gas discharge is demarcated. At or after time point T1-$\tau_{heat}$(>T1-$\Delta t$), a high-temperature plasma is generated and EUV emission from this high-temperature plasma begins.

```
( End )
```

# Fig. 37

S601 Standby command

S602 Standby state

S603 Standby completion command

S604 Light emission command

S605 Charge control command

tst

S606 Controller calculations

S607 1st trigger signal

TL1

S608 1st laser beam

TL1'

S609 Low-temperature plasma gas arrival timing

Arrival point    End of discharge start-up

Δtg    Δts
ε

S610 Main trigger signal

Td'

S611 SW on

γ

d1    Td

S612 (Inter-electrode) Voltage

Threshold (Vp)

Δtd

S613 2nd trigger signal

TL2'

S614 2nd laser beam

TL2

Discharge generation point

S615 (Discharge) Current

T1

Threshold (Ip)

Δti    Arrival point

S616 EUV emission

Arrival at specified plasma electron temperature    $\tau_{heat}$

$\tau_{EUV} > (200ns)$

# Fig. 38 (Prior Art)

# Fig. 39 (a) Plasma current
(Prior Art)

# Fig. 39 (b) Plasma radius
(Prior Art)

Period A

# Fig. 39 (c) EUV emission
(Prior Art)

Plasma pinch

# Fig. 40 (a) Plasma current
(Prior Art)

**I**

Heating current
waveform component (M)

Confinement current
waveform component (N)

**t**

# Fig. 40 (b) Plasma radius
(Prior Art)

**r**

**t**

Period B

# Fig. 40 (c) EUV emission
(Prior Art)

EUV
emission

**t**

Plasma pinch

# Fig. 41
## (Prior Art)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2005004555 A1
- JP 2005522839 A
- US 6972421 B2
- JP 2005 A
- JP 522839 A
- JP 2007515741 A
- JP 2007505460 A
- US 20070090304 A1
- WO 2005101924 A1
- WO 2006120942 A1
- JP 2007123138 A
- JP 2002504746 A
- WO 2006120942 A
- US 6359969 B

**Non-patent literature cited in the description**

- Status and Prospects of Research on EUV (Extreme Ultraviolet) Light Sources for Lithography. *J. Plasma Fusion Res.,* March 2003, vol. 79 (3), 219-260